# EUROPEAN PATENT SPECIFICATION

(11) **EP 4 395 500 B1**
(45) Date of publication and mention of the grant of the patent: **18.11.2026**
(21) Application number: 23218974.6
(22) Date of filing: 21.12.2023
(51) Int. Cl.: H10K 50/12

(54) **LIGHT-EMITTING DEVICE AND ELECTRONIC APPARATUS INCLUDING THE SAME**
LICHTEMITTIERENDE VORRICHTUNG UND ELEKTRONISCHE VORRICHTUNG DAMIT
DISPOSITIF ÉLECTROLUMINESCENT ET APPAREIL ÉLECTRONIQUE LE COMPRENANT

(30) Priority: 30.12.2022 KR 20220191045
(43) Date of publication of application: 03.07.2024
(73) Proprietor: Samsung Display Co., Ltd., Yongin-si, Gyeonggi-do 17113 (KR)
(72) Inventor: LEE, Sunghun, 16678 Suwon-si (KR); KANG, Byungjoon, 16678 Suwon-si (KR); KWAK, Seungyeon, 16678 Suwon-si (KR); KIM, Sungmin, 16678 Suwon-si (KR); KIM, Hyungjun, 16678 Suwon-si (KR); LEE, Minhan, 16678 Suwon-si (KR); LEE, Hongsoo, 16678 Suwon-si (KR); HWANG, Kyuyoung, 16678 Suwon-si (KR)
(74) Representative: Elkington and Fife LLP

(56) References cited:
- US-A1- 2020 006 676
- US-A1- 2020 308 209

## Description

### FIELD OF THE INVENTION

The disclosure relates to a light-emitting device and an electronic apparatus including the light-emitting device.

### BACKGROUND OF THE INVENTION

Organic light-emitting devices are self-emissive devices that may have improved characteristics in terms of viewing angles, response time, luminance, driving voltage, and response speed, and provide full-color images.

An organic light-emitting device includes an anode, a cathode, and an interlayer arranged between the anode and the cathode and including an emission layer. A hole transport region may be arranged between the anode and the emission layer, and an electron transport region may be arranged between the emission layer and the cathode. Holes provided from the anode move toward the emission layer through the hole transport region, and electrons provided from the cathode move toward the emission layer through the electron transport region. The holes and the electrons recombine in the emission layer to produce excitons. The excitons may transition from an excited state to a ground state, resulting in light emission. US 2020/308209 A1 and US 2020/006676 A1 disclose OLEDs using transition metal complexes as sensitizers in the light emitting layer.

### SUMMARY OF THE INVENTION

Provided is a light-emitting device having excellent characteristics in terms of luminescence efficiency, lifespan, and/or roll-off ratio, and an electronic apparatus including the light-emitting device.

Additional aspects will be set forth in part in the description which follows and, in part, will be apparent from the description, or may be learned by practice of the presented embodiments of the disclosure.

According to an aspect of the disclosure, a light-emitting device includes
a first electrode, a second electrode, and an interlayer arranged between the first electrode and the second electrode, wherein the interlayer includes an emission layer, the emission layer includes m1 hosts, a sensitizer, and a fluorescent emitter,
where m1 is an integer of 1 or more, and when m1 is 2 or more, the two or more hosts are each different from the other,
the m1 hosts, the sensitizer, and the fluorescent emitter are each different from the other, and
Expression 1 is satisfied. $0 debye \leq \left|PDM\left(S\right)-PDM\left(H\right)\right| \leq 3 debye$ Expression 1
In Expression 1,
PDM(S) is a permanent dipole moment of the sensitizer and has a unit of debye,
PDM(H) is ${\sum }_{x = 1}^{m 1} PDM \left(Hx\right) ⋅ W \left(Hx\right)$ which is an average value of permanent dipole moments of the m1 hosts present in the emission layer, and has a unit of debye wherein i) x is a variable of 1 to m1, ii) PDM(Hx) is a permanent dipole moment of an x^{th} host in the emission layer and has a unit of debye, and iii) W(Hx) is a weight fraction of the x^{th} host relative to a total weight of the host in the emission layer, and is calculated as (a weight of the x^{th} host in the emission layer / a total weight of the host in the emission layer), and
each of PDM(S) and PDM(H) is calculated based on density functional theory (DFT).

According to another aspect of the disclosure, an electronic apparatus includes the light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic view of a light-emitting device according to an embodiment;
FIG. 2 is a schematic view of a light-emitting device according to another embodiment;
FIG. 3 shows a photoluminescence spectrum of each of Films S-1_FE1, S-2_FE1, S-A_FE1, S-B_FE1, and S-C_FE1; and
FIG. 4 shows an electroluminescence (EL) spectrum of each of OLEDs 2 and 3.

### DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects.

As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ±10% or ±5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

A light-emitting device according to an embodiment of the disclosure is defined in claim 1.

A weight of the m1 hosts in the emission layer is greater than a total weight of the fluorescent emitter and the sensitizer. For example, a total weight of the m1 hosts in the emission layer may be about 60 weight percent (wt%) to about 99 wt%, about 70 wt% to about 97 wt%, or about 80 wt% to about 96 wt%, based on 100 wt% of the emission layer.

In an embodiment, m1 may be 1, 2, 3, or 4.

In an embodiment, m1 may be 1 or 2.

When m1 is 2, a weight ratio of two different hosts included in the emission layer may be 1:9 to 9:1, 2:8 to 8:2, 3:7 to 7:3, or 4:6 to 6:4. When the weight ratio is satisfied, movement of holes and electrons in the emission layer may be efficiently performed.

Among total emission components of emitted light from the emission layer, a proportion of a fluorescent emission component emitted from a fluorescent emitter may be about 70 % or more, for example, about 70 % to 100 %, about 70 % to about 95 %, about 70 % to about 90 %, about 70 % to about 85 %, or about 70 % to about 80 %.

The fluorescent emission component emitted from the fluorescent emitter may be an emission component emitted when an exciton of the fluorescent emitter transitions from a singlet excited state to a ground state. Therefore, the emission layer may be a fluorescent emission layer. The fluorescent emission layer may also include a phosphorescent emitter (for example, an organometallic compound including a transition metal). It is to be understood that a fluorescent emission layer is clearly distinguished from a phosphorescent emission layer in which, among total emission components, a proportion of a phosphorescent emission component of emitted light from the phosphorescent emitter is about 70 % or more.

The light-emitting device satisfies Expression 1: $0 debye \leq \left|PDM\left(S\right)-PDM\left(H\right)\right| \leq 3 debye$ Expression 1 wherein, in Expression 1, PDM(S) is a permanent dipole moment of the sensitizer and has a unit of debye.

In Expression 1, PDM(H) is ${\sum }_{x = 1}^{m 1} PDM \left(Hx\right) ⋅ W \left(Hx\right)$ which is an average value of permanent dipole moments of the m1 hosts present in the emission layer, and has a unit of debye, wherein i) x is a variable of 1 to m1, ii) PDM(Hx) is a permanent dipole moment of an xth host in the emission layer and has a unit of debye, and iii) W(Hx) is a weight fraction of the xth host relative to a total weight of the host in the emission layer, and may be calculated as (a weight of the xth host in the emission layer / a total weight of the host in the emission layer).

For example, in the emission layer, when m1 is 1, the host in the emission layer consists of Host A, and PDM(H) is the same as a value of a permanent dipole moment of Host A.

As another example, in the emission layer, when m1 is 2, the host in the emission layer includes two different hosts (for example, a mixture of two different hosts). For example, in the emission layer, when m1 is 2 and the host in the emission layer includes Host A and Host B, which are different from each other, PDM(H) may be calculated as PDM(Host A)·W(Host A) + PDM(Host B)·W(Host B), that is, "(permanent dipole moment of Host A x weight fraction of Host A) + (permanent dipole moment of Host B x weight fraction of Host B)". In this regard, when the host includes Host A and Host B in a weight ratio of 7:3, PDM(H) may be calculated as "PDM(Host A) x 0.7 + PDM(Host B) x 0.3".

Each of PDM(S) and PDM(H) is calculated based on the density functional theory (DFT). The Gaussian 16 program is used.

|A| indicates an absolute value of "A".

In an embodiment, PDM(S) may be greater than PDM(H).

In an embodiment, PDM(S) may be about 0.1 debye to about 3.0 debye, about 0.1 debye to about 2.5 debye, about 0.1 debye to about 2.0 debye, about 0.5 debye to about 3.0 debye, about 0.5 debye to about 2.5 debye, about 0.5 debye to about 2.0 debye, about 1.0 debye to about 3.0 debye, about 1.0 debye to about 2.5 debye, about 1.0 debye to about 2.0 debye, about 1.2 debye to about 3.0 debye, about 1.2 debye to about 2.5 debye, about 1.2 debye to about 2.0 debye, or about 1.5 debye to about 2.0 debye.

In an embodiment, PDM(H) may be about 0.01 debye to about 4.00 debye, about 0.01 debye to about 3.50 debye, about 0.01 debye to about 3.00 debye, about 0.01 debye to about 2.50 debye, about 0.01 debye to about 2.00 debye, about 0.01 debye to about 1.50 debye, about 0.01 debye to about 1.30 debye, about 0.01 debye to about 1.20 debye, about 0.05 debye to about 4.00 debye, about 0.05 debye to about 3.50 debye, about 0.05 debye to about 3.00 debye, about 0.05 debye to about 2.50 debye, about 0.05 debye to about 2.00 debye, about 0.05 debye to about 1.50 debye, about 0.05 debye to about 1.30 debye, about 0.05 debye to about 1.20 debye, about 0.09 debye to about 4.00 debye, about 0.09 debye to about 3.50 debye, about 0.09 debye to about 3.00 debye, about 0.09 debye to about 2.50 debye, about 0.09 debye to about 2.00 debye, about 0.09 debye to about 1.50 debye, about 0.09 debye to about 1.30 debye, about 0.09 debye to about 1.20 debye, about 0.1 debye to about 4.00 debye, about 0.1 debye to about 3.50 debye, about 0.1 debye to about 3.00 debye, about 0.1 debye to about 2.50 debye, about 0.1 debye to about 2.00 debye, about 0.1 debye to about 1.50 debye, about 0.1 debye to about 1.30 debye, or about 0.1 debye to about 1.20 debye.

In an embodiment, |PDM(S) - PDM(H)| may be about 0.1 debye to about 2.5 debye, about 0.2 debye to about 2.0 debye, about 0.3 debye to about 1.5 debye, about 0.4 debye to about 1.0 debye, about 0.4 debye to about 0.8 debye, or about 0.45 debye to about 0.6 debye.

In an embodiment, the light-emitting device may further satisfy Expression 2: $0 eV \leq \left|{S}_{1}\left(S\right)-{T}_{1}\left(S\right)\right| \leq 0.4 eV$ Expression 2
wherein, in Expression 2,
S₁(S) is singlet energy of the sensitizer and has a unit of eV,
T₁(S) is triplet energy of the sensitizer and has a unit of eV, and each of S₁(S) and T₁(S) is calculated based on the DFT.

For example, |S₁(S) - T₁(S)| may be about 0.01 eV to about 0.4 eV, about 0.01 eV to about 0.3 eV, about 0.01 eV to about 0.2 eV, about 0.05 eV to about 0.4 eV, about 0.05 eV to about 0.3 eV, about 0.05 eV to about 0.2 eV, about 0.1 eV to about 0.4 eV, about 0.1 eV to about 0.3 eV, or about 0.1 eV to about 0.2 eV.

In an embodiment, S₁(S) may be about 2.25 eV to about 2.65 eV, about 2.25 eV to about 2.60 eV, about 2.25 eV to about 2.55 eV, about 2.25 eV to about 2.50 eV, about 2.35 eV to about 2.65 eV, about 2.35 eV to about 2.60 eV, about 2.35 eV to about 2.55 eV, about 2.35 eV to about 2.50 eV, about 2.40 eV to about 2.65 eV, about 2.40 eV to about 2.60 eV, about 2.40 eV to about 2.55 eV, or about 2.40 eV to about 2.50 eV.

In an embodiment, T₁(S) may be about 2.2 eV to about 2.6 eV, about 2.2 eV to about 2.5 eV, about 2.2 eV to about 2.4 eV, about 2.3 eV to about 2.6 eV, about 2.3 eV to about 2.5 eV, or about 2.3 eV to about 2.4 eV.

In an embodiment, the light-emitting device may further satisfy Expression 3: $0 eV \leq \left|{S}_{1}\left(FE\right)-{T}_{1}\left(FE\right)\right| \leq 1.5 eV$ Expression 3
wherein, in Expression 3,
S₁(FE) is singlet energy of the fluorescent emitter and has a unit of eV,
T₁(FE) is triplet energy of the fluorescent emitter and has a unit of eV, and each of S₁(FE) and T₁(FE) is calculated based on the DFT.

For example, |S₁(FE) - T₁(FE)| may be about 0.1 eV to about 1.5 eV, about 0.1 eV to about 1.0 eV, about 0.1 eV to about 0.5 eV, about 0.3 eV to about 1.5 eV, about 0.3 eV to about 1.0 eV, or about 0.3 eV to about 0.5 eV.

In an embodiment, S₁(FE) may be about 1.5 eV to about 3.0 eV, about 2.0 eV to about 3.0 eV, or about 2.5 eV to about 3.0 eV.

In an embodiment, T₁(FE) may be about 1.0 eV to about 2.5 eV, about 1.5 eV to about 2.5 eV, or about 2.0 eV to about 2.5 eV.

In an embodiment, FWHM(FE) may be about 5 nanometers (nm) to about 50 nm, about 10 nm to about 45 nm, about 15 nm to about 45 nm, about 20 nm to about 45 nm, about 25 nm to about 45 nm, about 30 nm to about 45 nm, about 10 nm to about 40 nm, about 15 nm to about 40 nm, about 20 nm to about 40 nm, about 25 nm to about 40 nm, about 30 nm to about 40 nm, about 10 nm to about 35 nm, about 15 nm to about 35 nm, about 20 nm to about 35 nm, about 25 nm to about 35 nm, or about 30 nm to about 35 nm. FWHM(FE) is a full width at half maximum of a photoluminescence spectrum of the fluorescent emitter and has a unit of nm, and the photoluminescence spectrum is evaluated relative to a film including the fluorescent emitter.

In an embodiment, λmax(FE) may be about 500 nm to about 550 nm, about 510 nm to about 540 nm, about 515 nm to about 540 nm, about 520 nm to about 540 nm, about 525 nm to about 540 nm, about 510 nm to about 535 nm, about 515 nm to about 535 nm, about 520 nm to about 535 nm, or about 525 nm to about 535 nm. λmax(FE) is a maximum emission peak wavelength of a photoluminescence spectrum of the fluorescent emitter and has a unit of nm, and the photoluminescence spectrum is evaluated relative to a film including the fluorescent emitter.

The "film including the fluorescent emitter" may be prepared by using various methods, such as a vacuum deposition method, a coating method, and a heating method. The "film including the fluorescent emitter" may further include other compounds, for example, a host described in the present specification, in addition to the fluorescent emitter. For example, a method of evaluating FWHM(FE) is the same as described with reference to the following Evaluation Example.

In an embodiment, each of the sensitizer and the fluorescent emitter may emit yellow-green light, green light, or blue-green light.

In an embodiment, each of the sensitizer and the fluorescent emitter may emit green light.

In an embodiment, the emission layer may emit yellow-green light, green light, or blue-green light.

In an embodiment, the emission layer may emit green light.

In an embodiment, the light-emitting device may not emit white light.

The emission layer of the light-emitting device includes m1 hosts, a sensitizer, and a fluorescent emitter. Up to approximately 25% of singlet excitons formed in the host in the emission layer may be transferred to the sensitizer through Förster energy transfer, and energy of 75 % of triplet excitons formed in the host may be transferred to a singlet excited state and triplet excited state of the sensitizer. Among them, the triplet excitons transferred to the triplet excited state and the singlet excitons of the sensitizer may be transferred to a singlet excited state of the fluorescent emitter through Förster energy transfer. Therefore, both the singlet excitons and the triplet excitons generated in the emission layer are transferred to the singlet excited state of the fluorescent emitter. Upon radiative transition to a ground state, the layer emitting fluorescence with high luminescence efficiency, and is referred to as hyper-fluorescence.

As the emission layer satisfies Expression 1 as described above, a difference between an average value of permanent dipole moments of the m1 hosts and a value of a permanent dipole moment of the sensitizer is relatively small. In other words, an average value of permanent dipole moments of the m1 hosts in the emission layer and a value of a permanent dipole moment of the sensitizer are near similar to each other, and thus, even in a case where a relatively large amount of sensitizers are used, when the emission layer is formed, sensitizer aggregation caused by intermolecular interaction of the sensitizers is minimized, and the sensitizers may be uniformly dispersed in the host. Accordingly, " Förster energy transfer from the host to the sensitizer" that induces the hyper-fluorescence is maximized, and "Dexter energy transfer from the host to the fluorescent emitter" that inhibits the hyper- fluorescence is relatively minimized. Thus, the light-emitting device as described above may have excellent characteristics in terms of luminescence efficiency, lifespan, and/or a roll-off ratio.

Furthermore, since at least one of Expression 2 and Expression 3 is further satisfied, the light-emitting device may have better luminescence efficiency, and thus, a high-quality electronic apparatus may be implemented by using the light-emitting device.

The above may be described in more detail in Evaluation Examples provided below.

The m1 hosts in the emission layer may include a hole-transporting compound, an electron-transporting compound, a bipolar compound, or a combination thereof. Each of the m1 hosts may not include a transition metal.

For example, if in the emission layer, m1 is 2, each of two hosts in the emission layer may include a hole-transporting compound and/or an electron-transporting compound, and the hole-transporting compound and the electron-transporting compound may be each be different from the other.

In an embodiment, the hole-transporting compound may include at least one π-electron rich C₃-C₆₀ cyclic group and may not include an electron-transporting group. Examples of the electron-transporting group may include a cyano group, a fluoro group, a π-electron deficient nitrogen-containing cyclic group, a phosphine oxide group, and a sulfoxide group.

The "π-electron deficient nitrogen-containing cyclic group" as used herein may be a C₁-C₆₀ heterocyclic group which has at least one *-N=*' moiety as a ring-forming moiety. Examples of the π-electron deficient nitrogen-containing cyclic group may include a triazine group, an imidazole group, and the like.

"π-electron rich C₃-C₆₀ cyclic group" may be a C₃-C₆₀ cyclic group that does not include a *-N=*' moiety as a ring-forming moiety. Examples of the π-electron rich C₃-C₆₀ cyclic group may include a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, and a dibenzocarbazole group.

For example, the hole-transporting compound may include two or more carbazole groups.

In an embodiment, the electron-transporting compound may be a compound including at least one electron-transporting group. The electron-transporting group may be a cyano group, a fluoro group, a π-electron deficient nitrogen-containing C₁-C₆₀ cyclic group, a phosphine oxide group, a sulfoxide group, a combination thereof. In an embodiment, the electron-transporting compound may include a triazine group.

For example, the electron-transporting compound may include at least one electron-transporting group (for example, a triazine group) and at least one π-electron rich C₃-C₆₀ cyclic group(for example, a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphtho carbazole group, a dinaphthofuran group, a dinaphthothiophene group, a dibenzocarbazole group, or any combination thereof.

In an embodiment, the hole-transporting compound may be a compound represented by Formula 6: 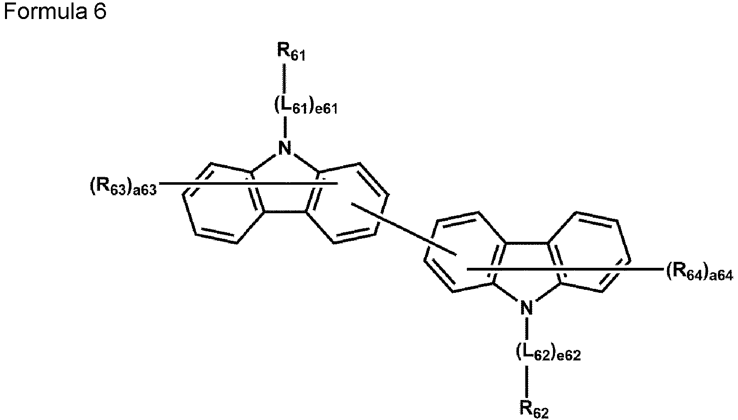
wherein, in Formula 6,
L₆₁ and L₆₂ may each independently be a π-electron rich C₃-C₆₀ cyclic group that is unsubstituted or substituted with deuterium, a C₁-C₂₀ alkyl group, a deuterated C₁-C₂₀ alkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, -Si(Q₃₃)(Q₃₄)(Q₃₅), or any combination thereof,
e61 and e62 may each independently be an integer from 1 to 6,
R₆₁ to R₆₄ may each independently be:
   hydrogen, deuterium, a C₁-C₂₀ alkyl group, or a deuterated C₁-C₂₀ alkyl group;
   a π-electron rich C₃-C₆₀ cyclic group that is unsubstituted or substituted with deuterium, a C₁-C₂₀ alkyl group, a deuterated C₁-C₂₀ alkyl group, a phenyl group, a deuterated a phenyl group, a (C₁-C₂₀ alkyl)phenyl group, a biphenyl group, a deuterated biphenyl group, a (C₁-C₂₀ alkyl)biphenyl group, -Si(Q₃₃)(Q₃₄)(Q₃₅), or any combination thereof; or

      -Si(Q₃)(Q₄)(Q₅),

      and
   a63 and a64 may each independently be an integer from 0 to 7, where
   Q₃ to Q₅ and Q₃₃ to Q₃₅ are each the same as described in the present specification.

In an embodiment, the hole-transporting compound may be a compound represented by Formula 6-1, 6-2, or 6-3: 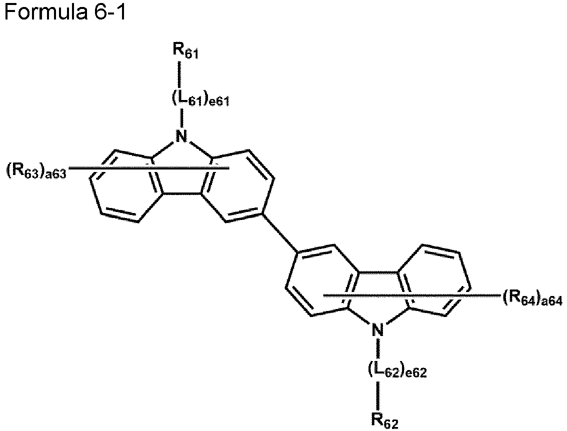 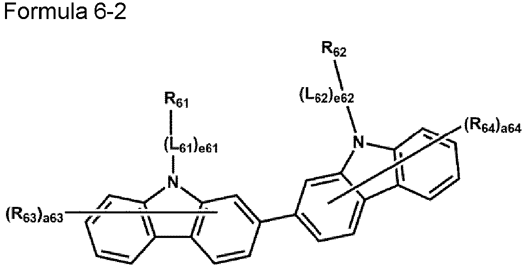 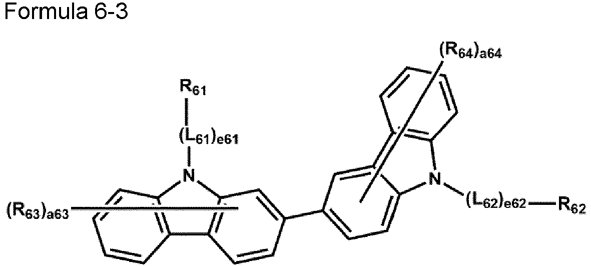 wherein, in Formulae 6-1 to 6-3, L₆₁, L₆₂, R₆₁ to R₆₄, e61, e62, a63, and a64 are respectively the same as those described in the present specification.

In an embodiment, the hole-transporting compound may be one of Compounds HTH1 to HTH6:

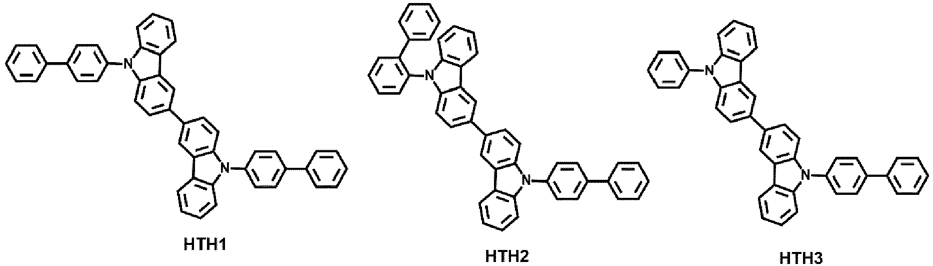

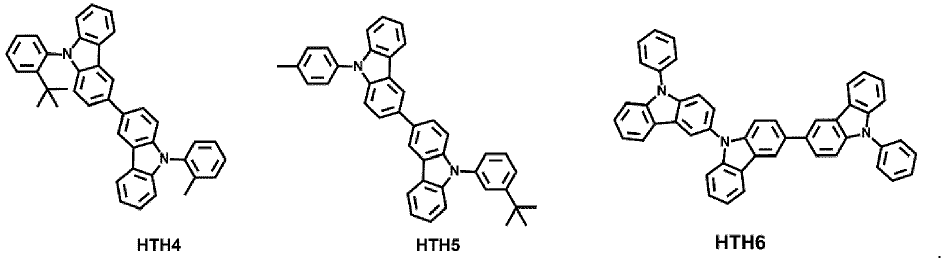

In an embodiment, the electron-transporting compound may be a compound represented by Formula 7: 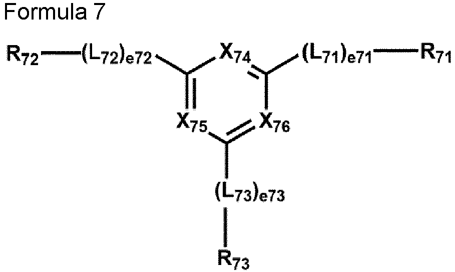
wherein, in Formula 7,
X₇₄ may be C(R₇₄) or N, X₇₅ may be C(R₇₅) or N, X₇₆ may be C(R₇₆) or N, and at least one of X₇₄ to X₇₆ may be N,
L₇₁ to L₇₃ may each independently be a C₅-C₃₀ carbocyclic group or a C₁-C₃₀ heterocyclic group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof,
e71 to e73 may each independently be an integer from 1 to 10, and
R₇₁ to R₇₆ may each independently be:
   hydrogen, deuterium, -F, or a cyano group;
   a C₁-C₂₀ alkyl group that is unsubstituted or substituted with deuterium, -F, a cyano group, or any combination thereof;
   a C₅-C₃₀ carbocyclic group or a C₁-C₃₀ heterocyclic group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof; or
   -Si(Q₃)(Q₄)(Q₅), where Q₃ to Q₅ and Q₃₃ to Q₃₅ are each the same as described in the present specification.

In an embodiment, X₇₄ to X₇₆ in Formula 7 may each be N.

In an embodiment, L₇₁ to L₇₃ in Formula 7 may each independently be a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphtho carbazole group, a dinaphthofuran group, a dinaphthothiophene group, or dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof.

In an embodiment, in Formula 7, at least one of e71 L₇₁, at least one of e72 L₇₂, at least one of e73 L₇₃, or any combination thereof may each independently be a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphtho carbazole group, a dinaphthofuran group, a dinaphthothiophene group, or dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof, where Q₃ to Q₅ and Q₃₃ to Q₃₅ are each the same as described in the present specification.

In an embodiment, in Formula 7, at least one of e71 L₇₁, at least one of e72 L₇₂, at least one of e73 L₇₃, or any combination thereof may include a carbazole group, an indolocarbazole group, a benzocarbazole group, a naphtho carbazole group, or a dibenzocarbazole group, and a nitrogen atom of a pyrrole group in the carbazole group, the indolocarbazole group, the benzocarbazole group, the naphtho carbazole group, or the dibenzocarbazole group may be connected to a carbon atom of a 6-membered ring including X₇₄ to X₇₆ in Formula 7 with a single bond or neighboring L₇₁, L₇₂, and/or L₇₃ therebetween.

In an embodiment, e71 to e73 in Formula 7 indicate numbers of L₇₁ to L₇₃, respectively, and may each independently be, for example, 1, 2, 3, 4, or 5.

In an embodiment, R₇₁ to R₇₆ in Formula 7 may each independently be:
hydrogen, deuterium, -F, or a cyano group;
a C₁-C₂₀ alkyl group that is unsubstituted or substituted with deuterium, -F, a cyano group, or any combination thereof;
a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphtho carbazole group, a dinaphthofuran group, a dinaphthothiophene group, or a dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof; or
-Si(Q₃)(Q₄)(Q₅), where Q₃ to Q₅ and Q₃₃ to Q₃₅ are each the same as described in the present specification.

In an embodiment, the electron-transporting compound may be one of Compounds ETH1 to ETH7:

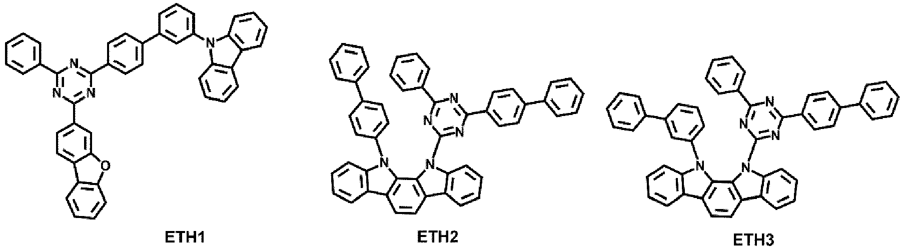

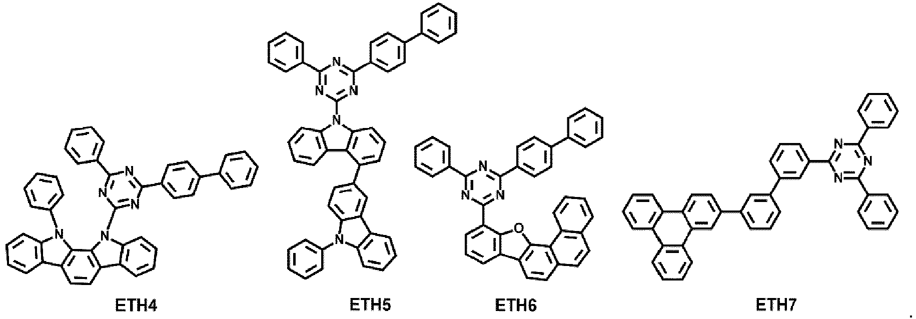

### Description of sensitizer

The sensitizer may include a transition metal.

In an embodiment, the sensitizer may include platinum. The sensitizer may be electrically neutral.

In an embodiment, the sensitizer may include a platinum-containing organometallic compound, and the platinum-containing organometallic compound may include platinum and a tetradentate ligand bonded to the platinum. In this regard, at least one of chemical bonds between the platinum and the tetradentate ligand may be a platinum-carbon chemical bond. In an embodiment, one of chemical bonds between the platinum and the tetradentate ligand may be a platinum-oxygen chemical bond.

In an embodiment, the platinum-containing organometallic compound may be an organometallic compound including a) a chemical bond (for example, a covalent bond) between carbon of the tetradentate ligand and the platinum and b) a chemical bond (for example, a covalent bond) between oxygen (O) of the tetradentate ligand and the platinum. The platinum-containing organometallic compound may include a chemical bond (for example, a coordinate bond) between nitrogen of the tetradentate ligand and the platinum.

In an embodiment, the platinum-containing organometallic compound may be an organometallic compound including a) a chemical bond (for example, a covalent bond) between carbon of the tetradentate ligand and the platinum and b) a chemical bond (for example, a covalent bond) between sulfur (S) of the tetradentate ligand and the platinum. The platinum-containing organometallic compound may include a chemical bond (for example, a coordinate bond) between nitrogen of the tetradentate ligand and the platinum.

In an embodiment, the tetradentate ligand may include a benzimidazole group. For example, the number of the benzimidazole group in the tetradentate ligand is 1.

In an embodiment, at least one of chemical bonds between the platinum and the tetradentate ligand of the platinum-containing organometallic compound may be a platinum-carbon chemical bond, and at least one of the platinum-carbon chemical bond may be a coordinate bond. In other words, the platinum-containing organometallic compound may be a carbene-containing organometallic compound.

In an embodiment, the platinum-containing organometallic compound may be an organometallic compound represented by Formula 1: 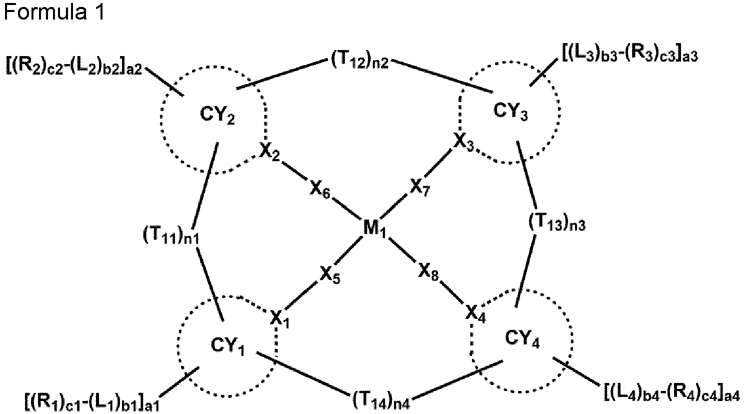 wherein, M₁ in Formula 1 is platinum (Pt).

In Formula 1, X₁ to X₄ may each independently be C or N.

In an embodiment, at least one of X₁ to X₄ in Formula 1 may be C.

In an embodiment, X₁ in Formula 1 may be C.

In an embodiment, in Formula 1, i) X₁ and X₃ may each be C, and X₂ and X₄ may each be N, or ii) X₁ and X₄ may each be C, and X₂ and X₃ may each be N.

In Formula 1, X₅ to X₈ may each independently be a chemical bond, O, S, N(R'), C(R')(R"), or C(=O), wherein at least one of X₅ to X₈ may not be a chemical bond. R' and R" may each be the same as described in the present specification.

In an embodiment, X₅ in Formula 1 may not be a chemical bond.

In an embodiment, X₅ in Formula 1 may be O or S.

In an embodiment, in Formula 1, X₅ may be O or S, and X₆ to X₈ may each be a chemical bond.

In an embodiment, each of X₅ to X₈ in Formula 1 may be a chemical bond (for example, a covalent bond or a coordinate bond).

In Formula 1, two of a bond between X₅ or X₁ and M₁, a bond between X₆ or X₂ and M₁, a bond between X₇ or X₃ and M₁, and a bond between X₈ or X₄ and M₁ may each be a coordinate bond, and the other two bonds may each be a covalent bond.

For example, a bond between X₂ and M₁ in Formula 1 may be a coordinate bond.

In an embodiment, in Formula 1, a bond between X₅ or X₁ and M₁ and a bond between X₃ and M₁ may each be a coordinate bond, and a bond between X₂ and M₁ and a bond between X₄ and M₁ may each be a covalent bond.

In an embodiment, in Formula 1, a bond between X₅ or X₁ and M₁ and a bond between X₃ and M₁ may each be a covalent bond, and a bond between X₂ and M₁ and a bond between X₄ and M₁ may each be a coordinate bond.

In an embodiment, in Formula 1, X₆ may be a chemical bond, X₂ may be carbon, and a bond between X₂ and M₁ may be a coordinate bond.

In an embodiment, in Formula 1, X₂, X₁, and X₄ may each be C, X₃ may be N, X₅ to X₈ may each be a chemical bond, n2 may be 0, n1, n4, and n3 may each be 1, a bond between X₂ and M₁ and a bond between X₃ and M₁ may each be a coordinate bond, and a bond between X₁ and M₁ and a bond between X₄ and M₁ may each be a covalent bond.

Ring CY₁ to ring CY₄ in Formula 1 may each independently be a C₅-C₃₀ carbocyclic group or a C₁-C₃₀ heterocyclic group.

For example, each of ring CY₁, ring CY₃, and ring CY₄ in Formula 1 may not be a benzimidazole group.

For example, ring CY₁ to ring CY₄ in Formula 1 may each independently be i) a first ring, ii) a second ring, iii) a condensed cyclic ring in which two or more first rings are condensed with each other, iv) a condensed cyclic ring in which two or more second rings are condensed with each other, or v) a condensed cyclic ring in which one or more first rings and one or more second rings are condensed with each other,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In an embodiment, ring CY₁ to ring CY₄ in Formula 1 may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluoren-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, pyridinoimidazole group, a pyridinoxazole group, a pyridinoisoxazole group, a pyridinothiazole group, a pyridinoisothiazole group, a pyridinoxadiazole group, a pyridinothiadiazole group, a pyrimidinopyrrole group, a pyrimidinopyrazole group, a pyrimidinoimidazole group, a pyrimidinoxazole group, a pyrimidinoisoxazole group, a pyrimidinothiazole group, a pyrimidinoisothiazole group, a pyrimidinoxadiazole group, a pyrimidinothiadiazole group, a naphthopyrrole group, a naphthopyrazole group, a naphthoimidazol group, a naphthoxazole group, a naphthoisoxazole group, a naphthothiazole group, a naphthoisothiazole group, a naphthoxadiazole group, a naphthothiadiazole group, a phenanthrenopyrrole group, a phenanthrenopyrazole group, a phenanthrenoimidazole group, a phenanthrenoxazole group, a phenanthrenoisoxazole group, a phenanthrenothiazole group, a phenanthrenoisothiazole group, a phenanthrenoxadiazole group, a phenanthrenothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In an embodiment, ring CY₁ and ring CY₃ in Formula 1 may each independently be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with a cyclohexane group, a cyclohexene group, a norbornane group, a piperidine group, or any combination thereof.

In an embodiment, ring CY₂ in Formula 1 may be: an imidazole group, a benzimidazole group, a pyridine group, a pyrimidine group, a pyridazine group, a pyrazine group, a triazine group, a quinoline group, an isoquinoline group, a quinoxaline group, or a quinazoline group; or

an imidazole group, a benzimidazole group, a pyridine group, a pyrimidine group, a pyridazine group, a pyrazine group, a triazine group, a quinoline group, an isoquinoline group, a quinoxaline group, or a quinazoline group, each condensed with a cyclohexane group, a cyclohexene group, a norbornane group, a benzene group, a pyridine group, a pyrimidine group, or any combination thereof. In an embodiment, ring CY₂ in Formula 1 may be an imidazole group, or a benzimidazole group, with X₂ being one of the two imidazole nitrogen's coordinated to the platinum. Moreover, the other (opposite) imidazole nitrogen may be substituted with a C₆-C₁₄ aromatic group, e.g., a phenyl group, that is optionally substituted at one or more ring carbons. Examples of such substitution is indicated in the Group 1-2 structures described herein. In some instances, there may be an advantage to have the opposite imidazole nitrogen be substituted with a C₆-C₁₄ aromatic group with one or more ring carbons substituted with deuterium or a substituent with one or more deuterium atoms, e.g., - CD₃, -CD₂CD₃, -CD(CD₃)₂, or C₆D₅.

In an embodiment, ring CY₄ in Formula 1 may be:
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group; or
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group, each condensed with a cyclohexane group, a cyclohexene group, a norbornane group, a benzene group, a pyridine group, a pyrimidine group, or any combination thereof.

In Formula 1, T₁₁ to T₁₄ may each independently be a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)₂-*', *-C(R₅ₐ)=*', *=C(R₅ₐ)-*', *-C(R₅ₐ)=C(R_{5b})-*', *-C(=S)-*', *-C≡C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

In an embodiment, T₁₁ and T₁₂ in Formula 1 may be a single bond, and T₁₃ may be a single bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', or *-O-*'.

In Formula 1, n1 to n4 indicate numbers of T₁₁ to T₁₄, respectively, and may each independently be 0 or 1, wherein three or more of n1 to n4 may each be 1. In other words, an organometallic compound represented by Formula 1 may have a tetradentate ligand.

In Formula 1, when n1 is 0, T₁₁ does not exist (that is, ring CY₁ and ring CY₂ are not linked to each other), when n2 is 0, T₁₂ does not exist (that is, ring CY₂ and ring CY₃ are not linked to each other), when n3 is 0, T₁₃ does not exist (that is, ring CY₃ and ring CY₄ are not linked to each other), and when n4 is 0, T₁₄ does not exist (that is, ring CY₄ and ring CY₁ are not linked to each other).

In an embodiment, in Formula 1, n1 to n3 may each be 1, and n4 may be 0.

L₁ to L₄ in Formula 1 may each independently be a single bond, a C₁-C₆₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

For example, L₁ to L₄ in Formula 1 may each independently be:
a single bond; or
a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one R₁₀ₐ.

In an embodiment, L₁ to L₄ in Formula 1 may each independently be:
a single bond; or
a benzene group, a naphthalene group, a pyridine group, a fluorene group, a carbazole group, a dibenzofuran group, or a dibenzothiophene group, each unsubstituted or substituted with at least one R₁₀ₐ.

In an embodiment, L₁ to L₄ in Formula 1 may each independently be:
a single bond; or
a C₁-C₂₀ alkylene group, a benzene group, a naphthalene group, a dibenzofuran group, or a dibenzothiophene group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

In Formula 1, b1 to b4 indicate numbers of L₁ to L₄, respectively, and may each independently be an integer from 1 to 10. When b1 is 2 or more, two or more L₁ may be identical to or different from each other, when b2 is 2 or more, two or more L₂ may be identical to or different from each other, when b3 is 2 or more, two or more L₃ may be identical to or different from each other, and when b4 is 2 or more, two or more L₄ may be identical to or different from each other. For example, b1 to b4 may each independently be 1, 2, or 3.

In Formula 1, R₁ to R₄, R₅ₐ, R_{5b}, R', and R" may each independently be hydrogen, deuterium, -F, -Cl, -Br, -I, -SF₅, a hydroxyl group, a cyano group, a nitro group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkylaryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkylheteroaryl group, a substituted or unsubstituted monovalent non-aromatic condensed polycyclic group, a substituted or unsubstituted monovalent non-aromatic condensed heteropolycyclic group, -N(Q₁)(Q₂), - Si(Q₃)(Q₄)(Q₅), -Ge(Q₃)(Q₄)(Q₅), -B(Q₆)(Q₇), -P(=O)(Q₈)(Q₉), or -P(Q₈)(Q₉), where Q₁ to Q₉ may each be the same as described in the present specification.

For example, R₁ to R₄, R₅ₐ, R_{5b}, R', and R" in Formula 1 may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₁-C₂₀ alkenyl group, a C₁-C₂₀ alkoxy group, or a C₁-C₂₀ alkylthio group;
a C₁-C₂₀ alkyl group, a C₁-C₂₀ alkenyl group, a C₁-C₂₀ alkoxy group, or a C₁-C₂₀ alkylthio group, each substituted with deuterium, -F, -Cl, -Br, -I, -CD₃, -CD₂H, - CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cycloctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, - Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a fluorinated alkyl group, a C₁-C₂₀ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cycloctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a phenyl group, a (C₁-C₂₀ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
wherein Q₁ to Q₉ may each independently be:
   deuterium, -F, -CH₃, -CD₃, -CD₂H, -CDH₂, -CH₂CH₃, -CH₂CD₃, -CH₂CD₂H, - CH₂CDH₂, -CHDCH₃, -CHDCD₂H, -CHDCDH₂, -CHDCD₃, -CD₂CD₃, -CD₂CD₂H, - CD₂CDH₂, -CF₃, -CF₂H, -CFH₂, -CH₂CF₃, -CH₂CF₂H, -CH₂CFH₂, -CHFCH₃, - CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a C₁-C₁₀ alkyl group, a phenyl group, or any combination thereof.

In an embodiment, R₁ to R₄, R₅ₐ, R_{5b}, R', and R" in Formula 1 may each independently be:
hydrogen, deuterium, -F, or a cyano group;
a C₁-C₂₀ alkyl group that is unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or
-Si(Q₃)(Q₄)(Q₅) or -Ge(Q₃)(Q₄)(Q₅),
where Q₃ to Q₅ may each independently be:
   a C₁-C₆₀ alkyl group that is unsubstituted or substituted with deuterium, a C₁-C₆₀ alkyl group, a C₆-C₆₀ aryl group, or any combination thereof; or
   a C₆-C₆₀ aryl group that is unsubstituted or substituted with deuterium, a C₁-C₆₀ alkyl group, a C₆-C₆₀ aryl group, or any combination thereof.

In an embodiment, Q₃ to Q₅ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

In an embodiment, Q₃ to Q₅ may be identical to each other.

In an embodiment, two or more of Q₃ to Q₅ may be different from each other.

In an embodiment, R₁ to R₄, R₅ₐ, R_{5b}, R', and R" in Formula 1 may each independently be hydrogen, deuterium, -F, -CH₃, -CD₃, -CD₂H, -CDH₂, -CF₃, -CF₂H, -CFH₂, a C₁-C₁₀ alkyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, - Si(Q₃)(Q₄)(Q₅), or -Ge(Q₃)(Q₄)(Q₅) (wherein Q₃ to Q₅ are respectively the same as those described in the present specification):

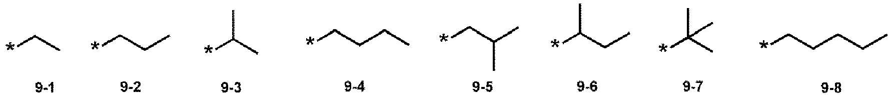

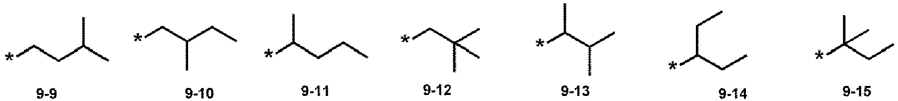

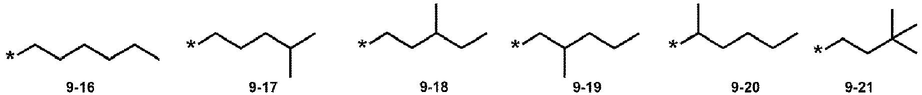

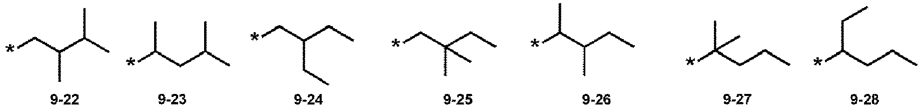

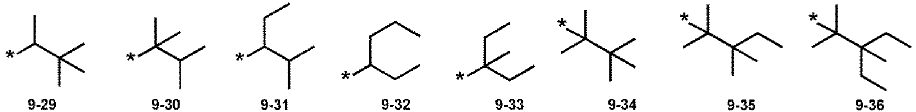

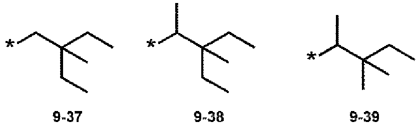

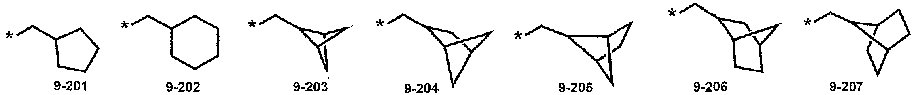

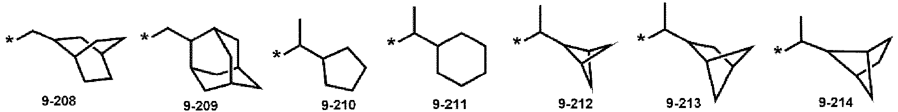

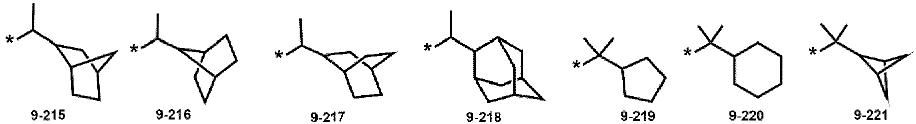

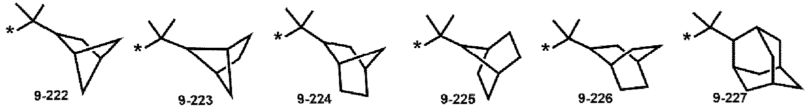

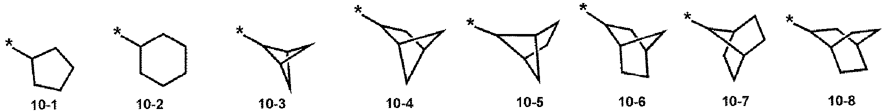

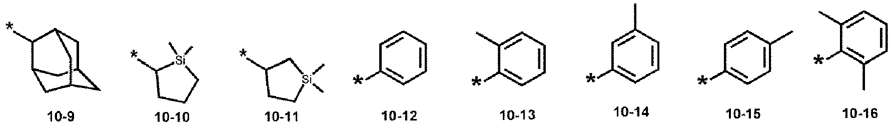

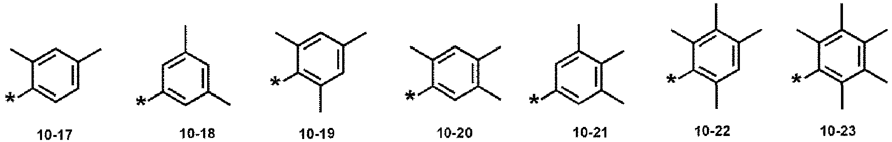

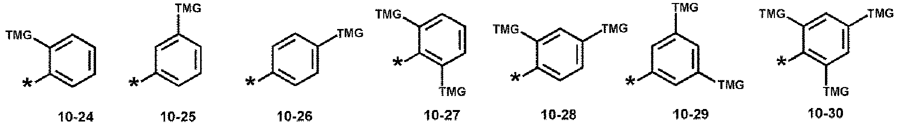

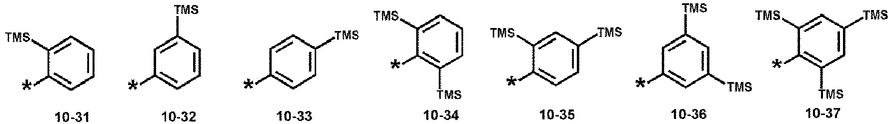

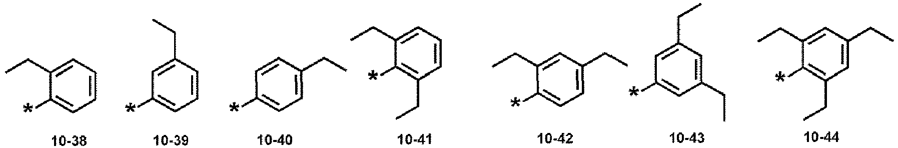

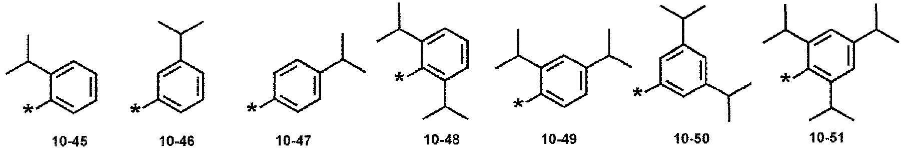

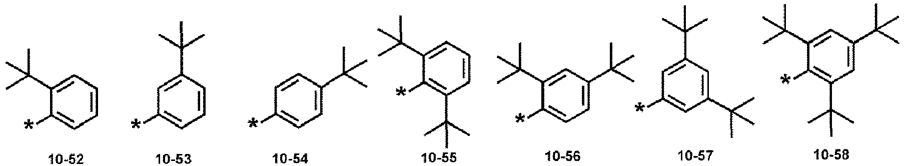

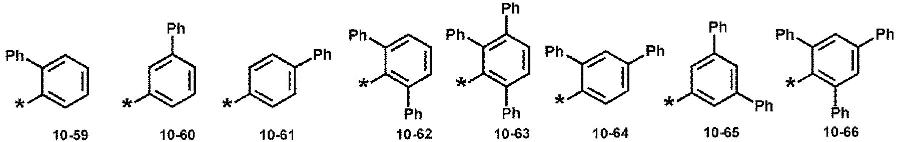

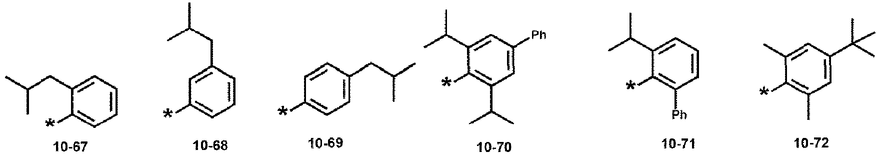

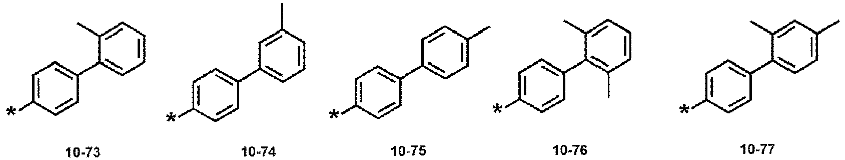

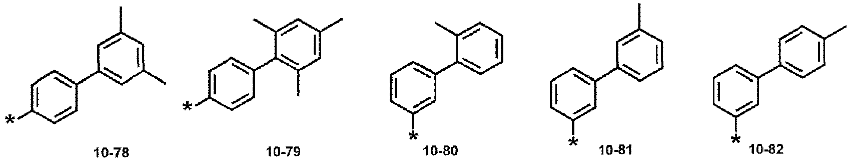

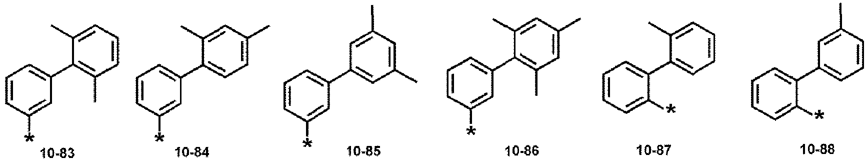

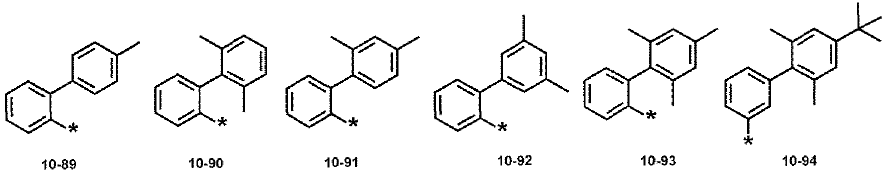

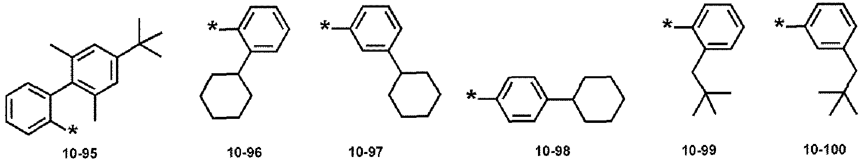

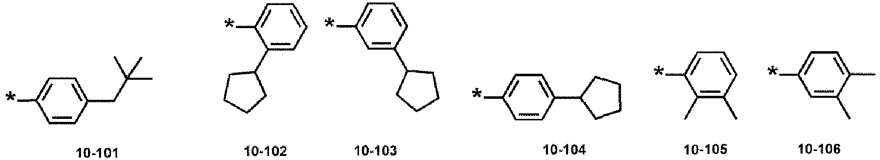

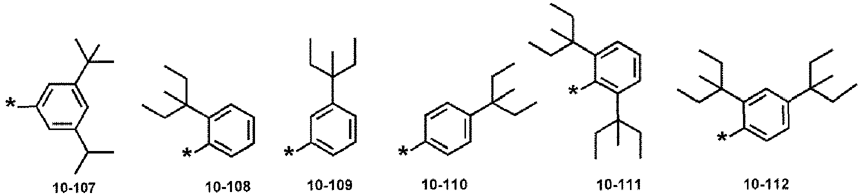

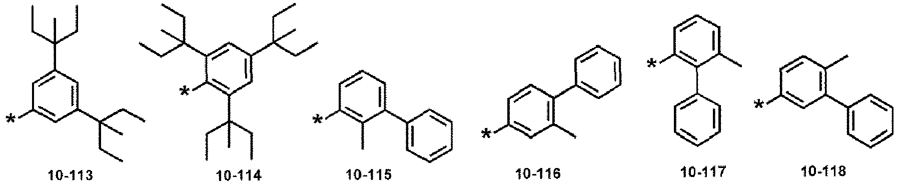

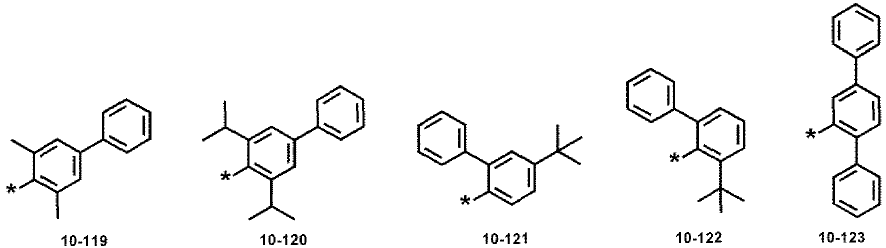

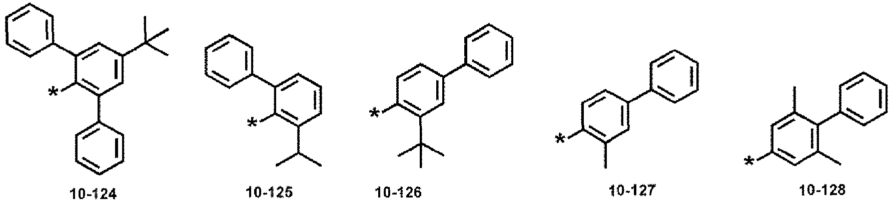

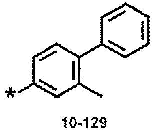

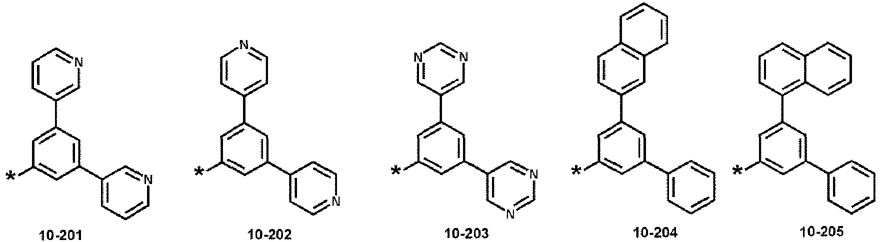

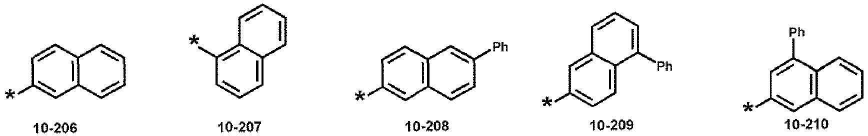

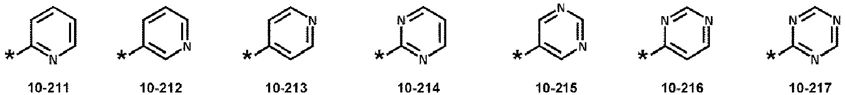

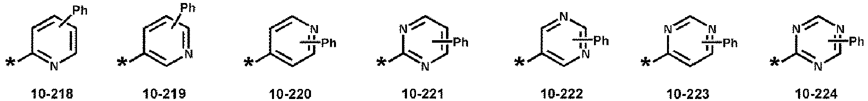

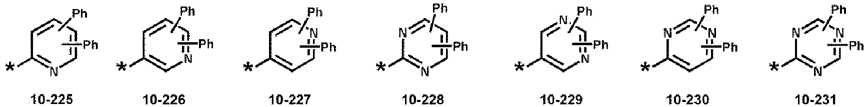

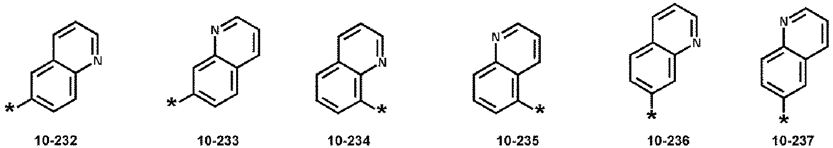

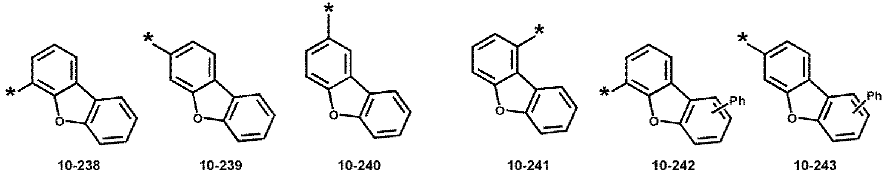

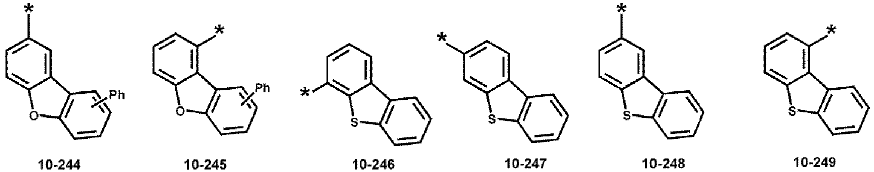

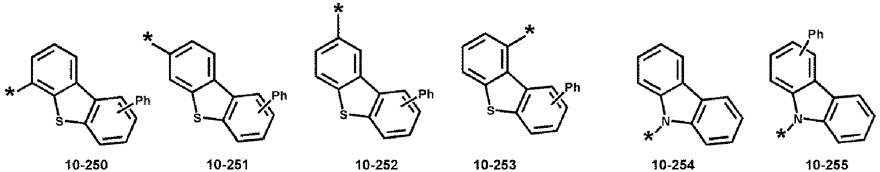

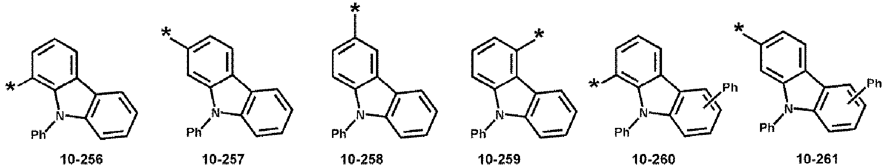

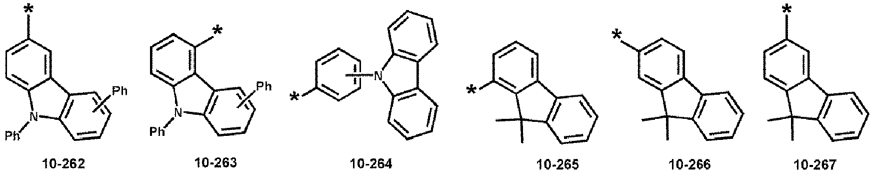

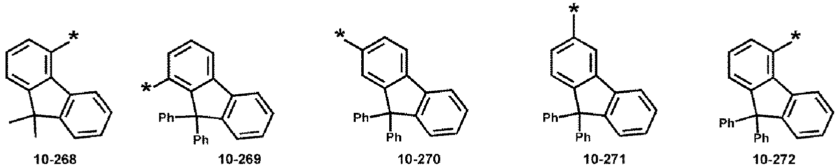

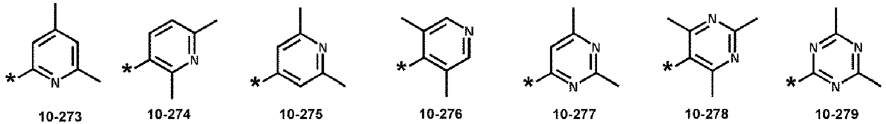

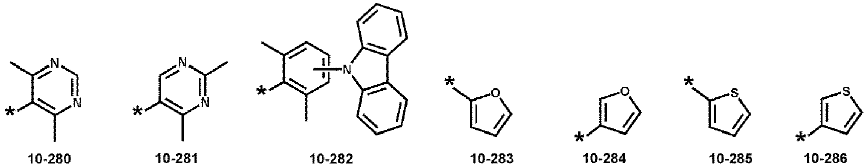

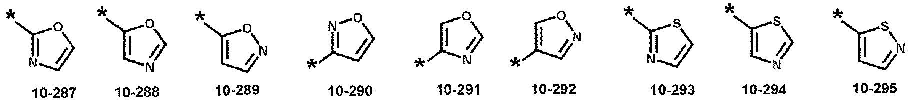

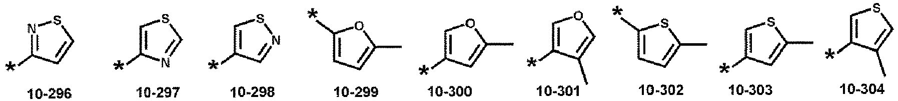

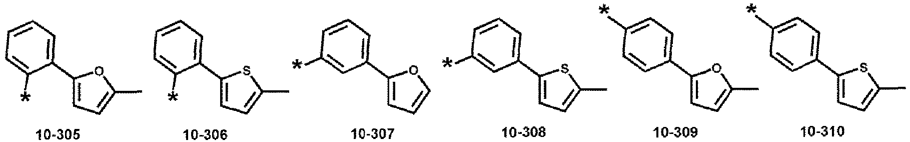

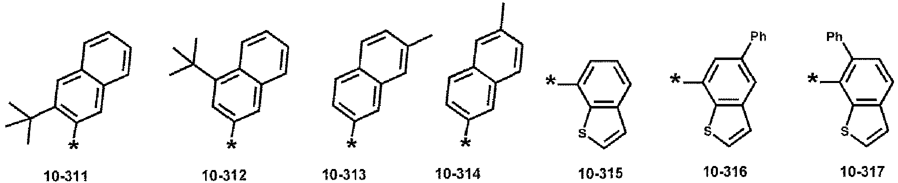

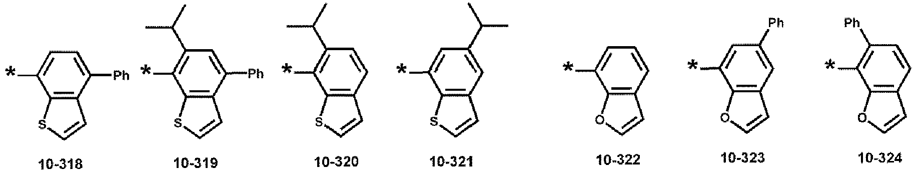

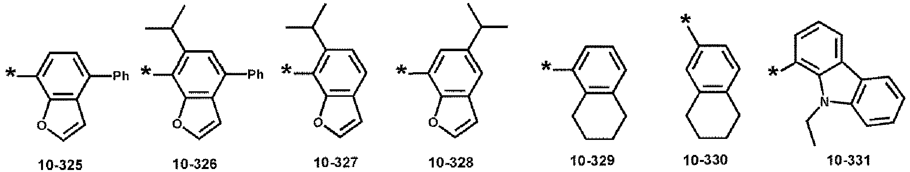

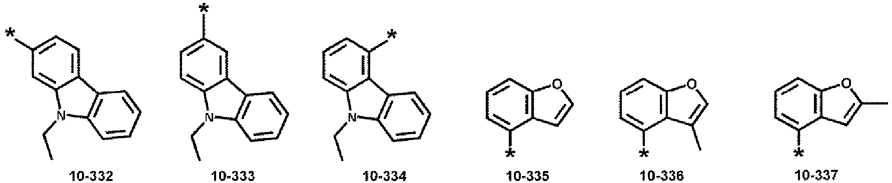

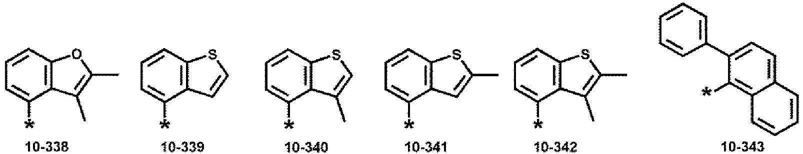

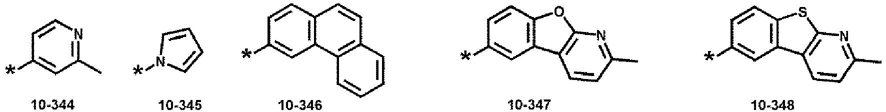

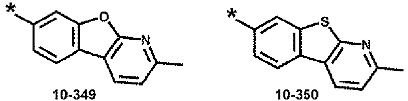

In Formulae 9-1 to 9-39, 9-201 to 9-227, 10-1 to 10-129, and 10-201 to 10-350, * indicates a binding site to a neighboring atom, Ph is a phenyl group, TMS is a trimethylsilyl group, and TMG is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may each be, for example, a group represented by one of Formulae 9-501 to 9-514 and 9-601 to 9-636:

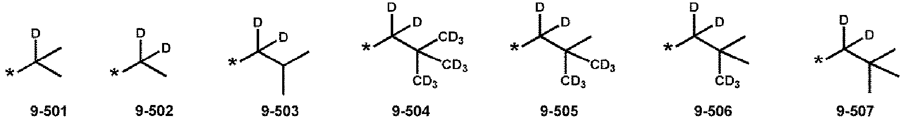

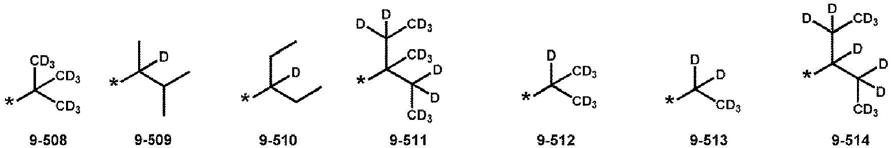

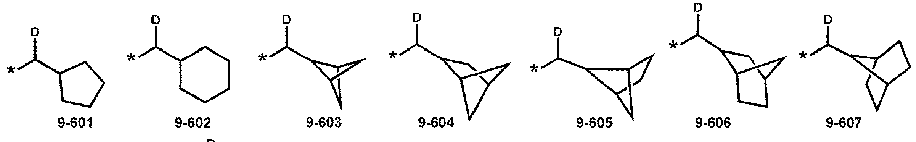

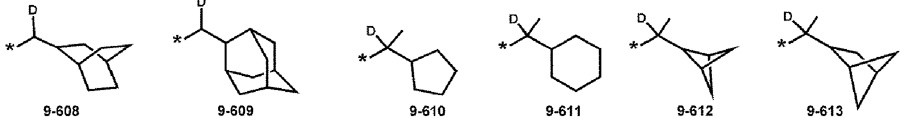

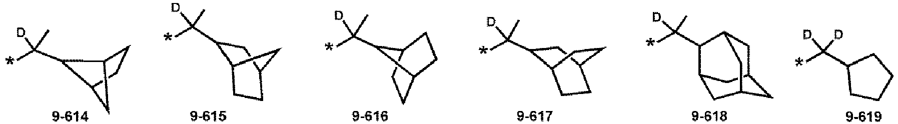

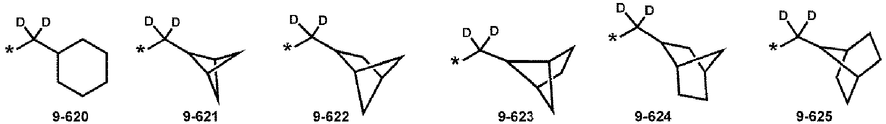

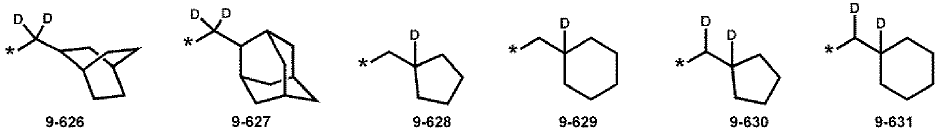

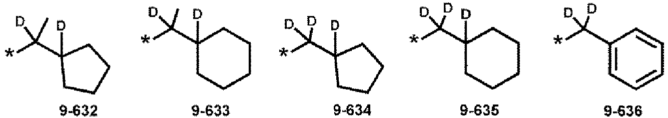

The "group represented by one of Formulae 9-1 to 9-39 in which at least one hydrogen is substituted with -F" and the "group represented by one of Formulae 9-201 to 9-227 in which at least one hydrogen is substituted with -F" may each be, for example, a group represented by one of Formulae 9-701 to 9-710:

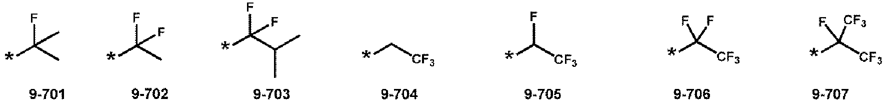

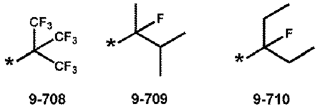

The "group represented by one of Formulae 10-1 to 10-129 in which at least one hydrogen is substituted with deuterium" and the "group represented by one of Formulae 10-201 to 10-350 in which at least one hydrogen is substituted with deuterium" may be, for example, a group represented by one of Formulae 10-501 to 10-553:

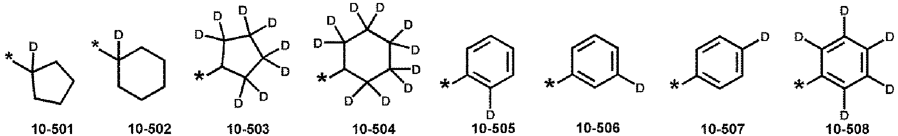

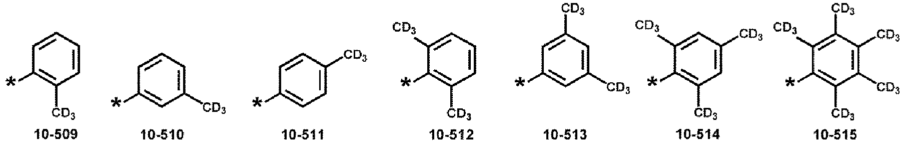

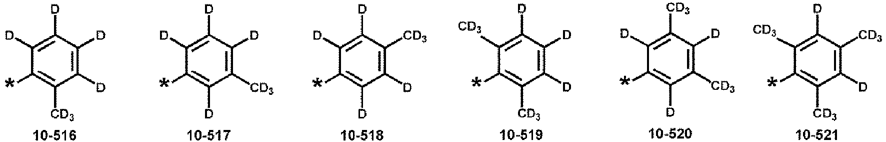

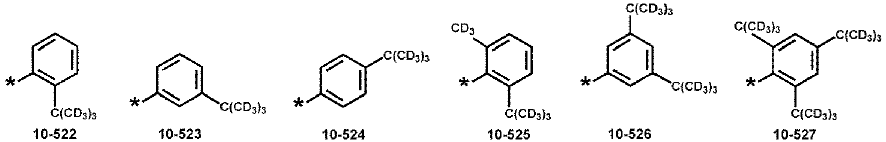

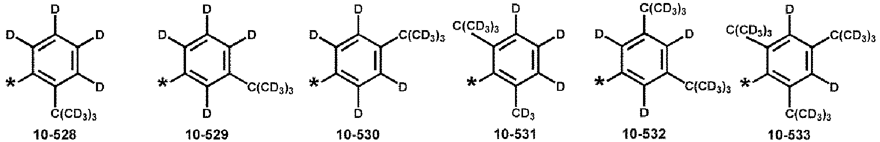

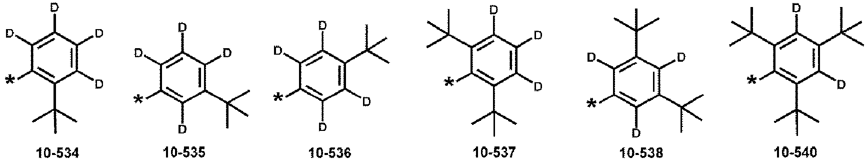

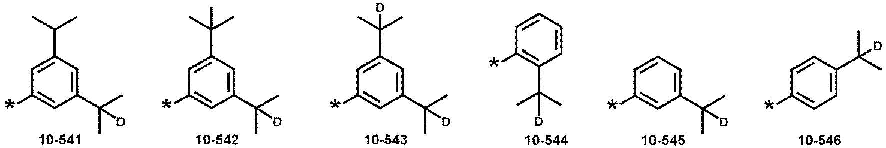

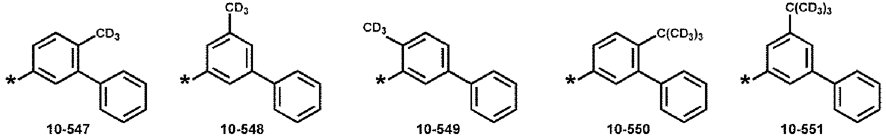

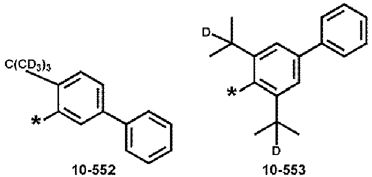

The "group represented by one of Formulae 10-1 to 10-129 in which at least one hydrogen is substituted with -F" and the "group represented by one of Formulae 10-201 to 10-350 in which at least one hydrogen is substituted with -F" may be, for example, a group represented by one of Formulae 10-601 to 10-617:

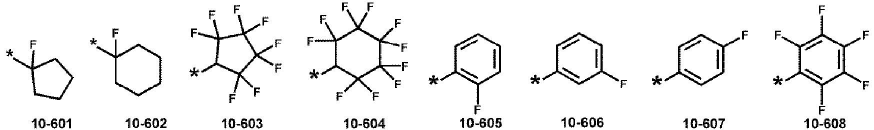

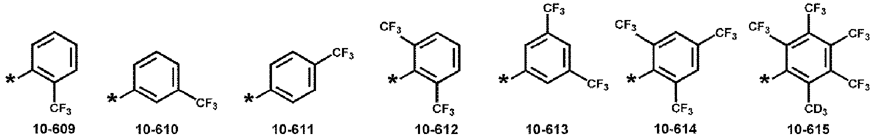

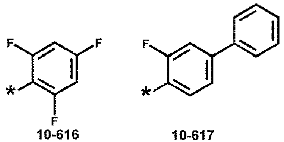

In Formula 1, c1 to c4 and a1 to a4 may be numbers of R₁ to R₄, a group represented by *-[(L₁)_{b1}-(R₁)_{c1}], a group represented by *-[(L₂)_{b2}-(R₂)_{c2}], a group represented by *-[(L₃)_{b3}-(R₃)_{c3}], a group represented by *-[(L₄)_{b4}-(R₄)_{c4}], respectively, and may each independently be an integer from 0 to 20. When c1 is 2 or more, two or more R₁ may be identical to or different from each other, when c2 is 2 or more, two or more R₂ may be identical to or different from each other, when c3 is 2 or more, two or more R₃ may be identical to or different from each other, when c4 is 2 or more, two or more R₄ may be identical to or different from each other, when a1 is 2 or more, two or more groups represented by *-[(L₁)_{b1}-(R₁)_{c1}] may be identical to or different from each other, when a2 is 2 or more, two or more groups represented by *-[(L₂)_{b2}-(R₂)_{c2}] may be identical to or different from each other, when a3 is 2 or more, two or more groups represented by *-[(L₃)_{b3}-(R₃)_{c3}] may be identical to or different from each other, and when a4 is 2 or more, two or more groups represented by *-[(L₄)_{b4}-(R₁)_{c4}] may be identical to or different from each other. For example, c1 to c4 and a1 to a4 in Formula 1 may each independently be 0, 1, 2, or 3.

In Formula 1, at least one of i) two or more of a plurality of R₁, ii) two or more of a plurality of R₂, iii) two or more of a plurality of R₃, iv) two or more of a plurality of R₄, v) R₅ₐ and R_{5b}, and vi) two or more of R₁ to R₄, R₅ₐ, and R_{5b} may each optionally bonded together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ. In other words, in Formula 1, i) two or more of a plurality of R₁ may optionally be bonded together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, ii) two or more of a plurality of R₂ may optionally be bonded together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, iii) two or more of a plurality of R₃ may optionally be bonded together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, iv) two or more of a plurality of R₄ may optionally be bonded together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, v) R₅ₐ and R_{5b} may optionally be bonded together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, and/or vi) two or more of R₁ to R₄, R₅ₐ, and R_{5b} may optionally be bonded together to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

R₁₀ₐ may be the same as described in connection with R₁.

The symbols * and *' as used herein each indicate a binding site to a neighboring atom, unless otherwise stated.

In an embodiment, in Formula 1, n1 may not be 0, n4 may be 0, and a group represented by 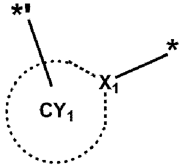 may be a group represented by one of Formulae CY1(1) to CY1(23): 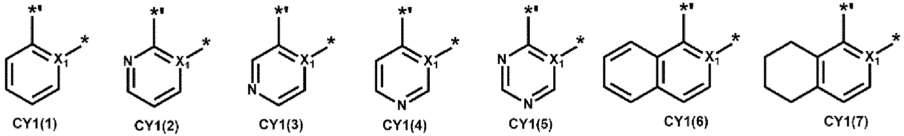 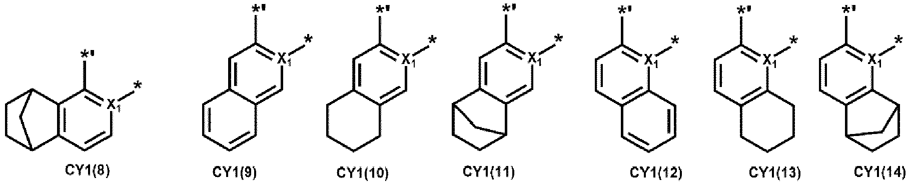 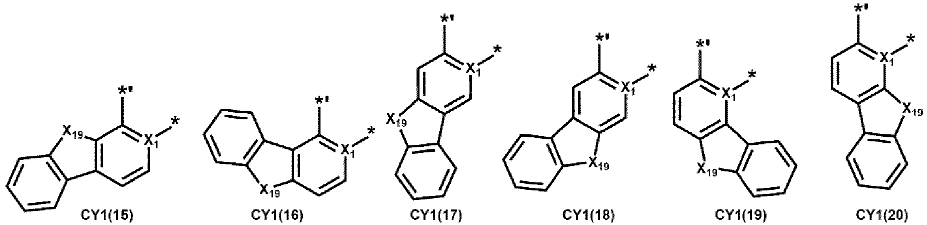 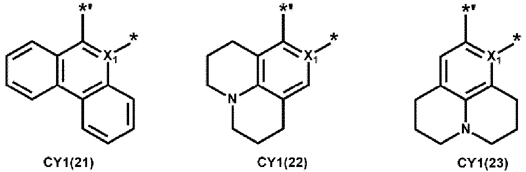 wherein, in Formulae CY1(1) to CY1(23),
X₁ may be the same as described in the present specification,
X₁₉ may be O, S, Se, N(R₁₉ₐ), C(R₁₉ₐ)(R_{19b}), or Si(R₁₉ₐ)(R_{19b}),
R₁₉ₐ and R_{19b} may each be the same as described in connection with R₁,
* may indicate a binding site to M₁ or X₅ in Formula 1, and
*' may indicate a binding site to T₁₁ in Formula 1.

In an embodiment, in Formula 1, n1 may be 1, n4 may be 0, and a group represented by 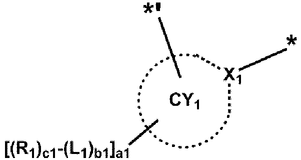 may be a group represented by one of Formulae CY1-1 to CY1-18: 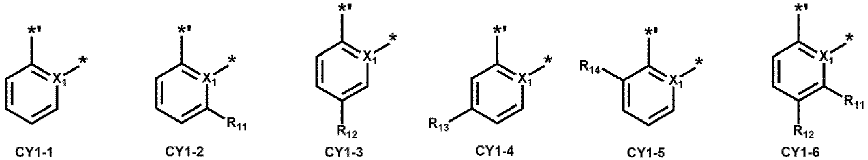 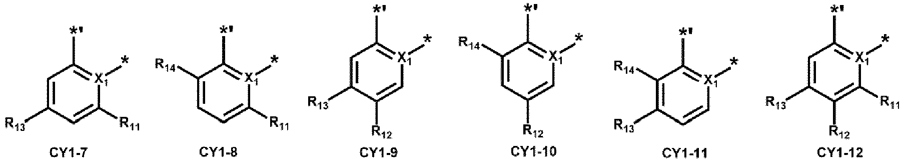 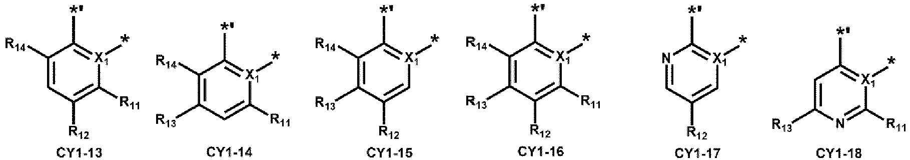 wherein, in Formulae CY1-1 to CY1-18,
X₁ is the same as described in the present specification,
R₁₁ to R₁₄ may each be the same as described in connection with R₁, and each of R₁₁ to R₁₄ may not be hydrogen,
* may indicate a binding site to M₁ or X₅ in Formula 1, and
*' may indicate a binding site to T₁₁ in Formula 1.

In an embodiment, in Formula 1, n1 and n2 may each be 1, and ring CY₂ may be a group represented by Formula CY2A or CY2B: 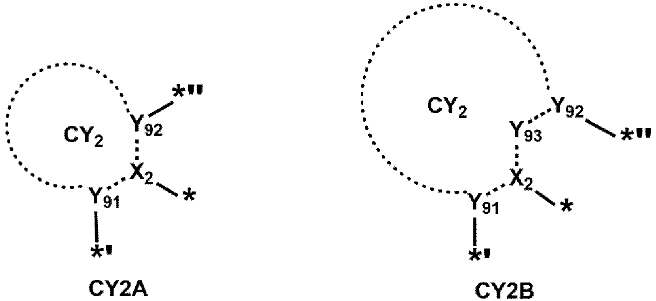 wherein, in Formulae CY2A and CY2B,
X₂ and ring CY₂ may respectively be the same as those described in the present specification,
Y₉₁ and Y₉₂ may each independently be N, C, or Si, and Y₉₃ may be O, S, N, C, or Si,
a bond between X₂ and Y₉₁, a bond between X₂ and Y₉₂, a bond between X₂ and Y₉₃, and a bond between Y₉₂ and Y₉₃ in Formulae CY2A and CY2B may each be a chemical bond,
*' may indicate a binding site to T₁₁ in Formula 1,

* may indicate a binding site to X₆ or M₁ in Formula 1, and
*" may indicate a binding site to T₁₂ in Formula 1.

In an embodiment, in Formula 1, each of n1 and n2 may not be 0, and a group represented by 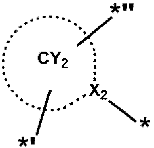 may be a group represented by one of Formulae CY2(1) to CY2(21): 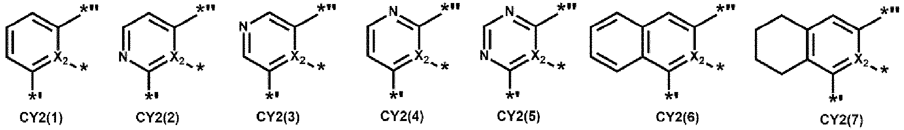 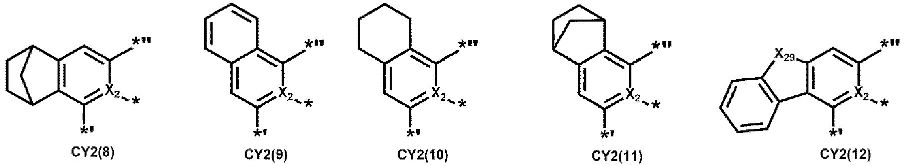 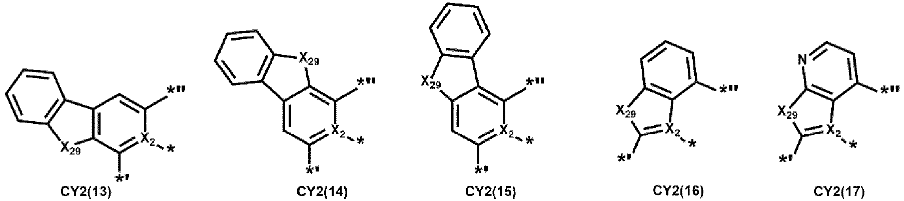 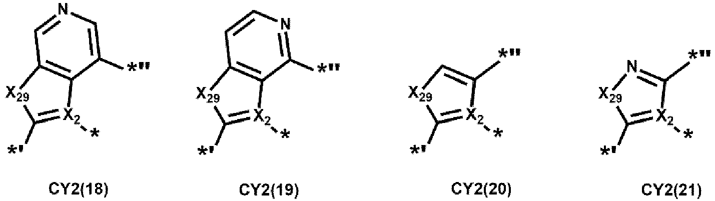 wherein, in Formulae CY2(1) to CY2(21),
X₂ may be the same as described in the present specification,
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may respectively be the same as those described in the present specification,
R₂₉ₐ and R_{29b} may each be the same as described in connection with R₂,
*' may indicate a binding site to T₁₁ in Formula 1,
* may indicate a binding site to X₆ or M₁ in Formula 1, and
*" may indicate a binding site to T₁₂ in Formula 1.

In an embodiment, in Formula 1, each of n1 and n2 may be 1, and a group represented by 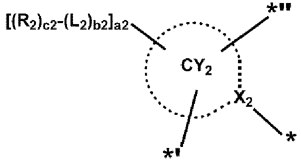 may be a group represented by one of Formulae CY2-1 to CY2-16: 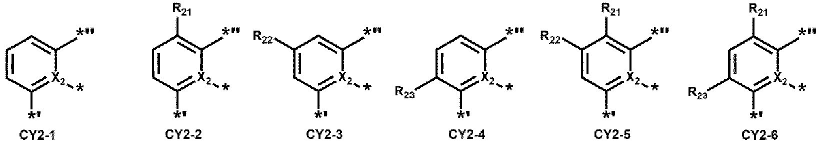 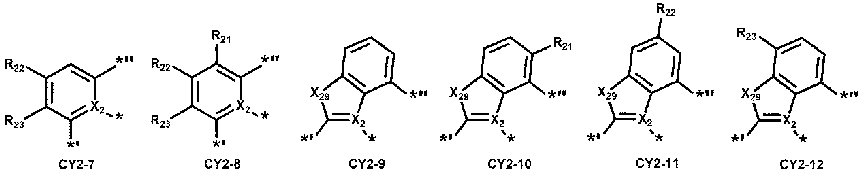 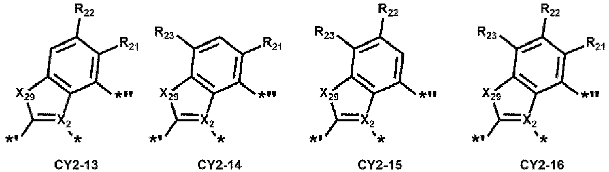 wherein, in Formulae CY2-1 to CY2-16,
X₂ may be the same as described in the present specification,
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may respectively be the same as those described in the present specification,
R₂₁ to R₂₃, R₂₉ₐ, and R_{29b} may each be the same as described in connection with R₂, wherein each of R₂₁ to R₂₃ may not be hydrogen,
*' may indicate a binding site to T₁₁ in Formula 1,
* may indicate a binding site to X₆ or M₁ in Formula 1, and
*" may indicate a binding site to T₁₂ in Formula 1.

In an embodiment, in Formula 1,
each of n1 and n2 may be 1,
a group represented by 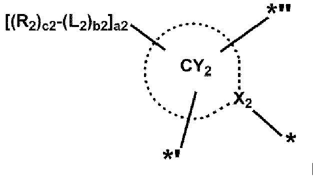 may be represented by one of Formulae CY2-9 to CY2-16,
X₂₉ in Formulae CY2-9 to CY2-16 may be N-[(L₂)_{b2}-(R₂)_{c2}],
L₂ may be a benzene group that is unsubstituted or substituted with at least one R₁₀ₐ,
b2 may be 1 or 2,
c2 may be 1 or 2, and
when c2 is 1, R₂ may be a phenyl group that is unsubstituted or substituted with deuterium, a C₁-C₂₀ alkyl group, a phenyl group, a deuterated phenyl group, a (C₁-C₂₀ alkyl)phenyl group, or any combination thereof, and when c2 is 2, a) one of two R₂ may be a phenyl group that is unsubstituted or substituted with deuterium, a C₁-C₂₀ alkyl group, a phenyl group, a deuterated phenyl group, a (C₁-C₂₀ alkyl)phenyl group, or any combination thereof, and b) the other R₂ may be a C₄-C₂₀ alkyl group or a deuterated C₁-C₂₀ alkyl group, each unsubstituted or substituted with a C₃-C₁₀ cycloalkyl group.

In an embodiment, in Formula 1, each of n2 and n3 may not be 0, and a group represented by 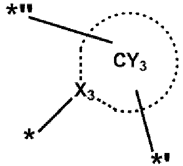 may be a group represented by one of Formulae CY3(1) to CY3(15): 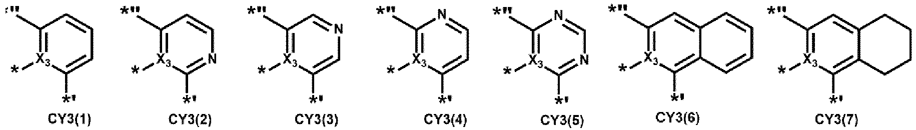 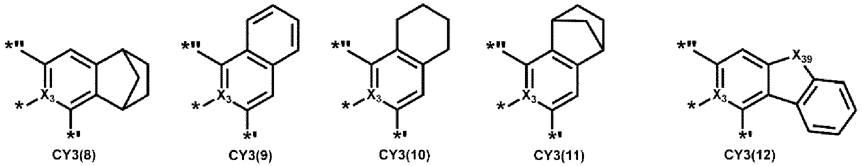 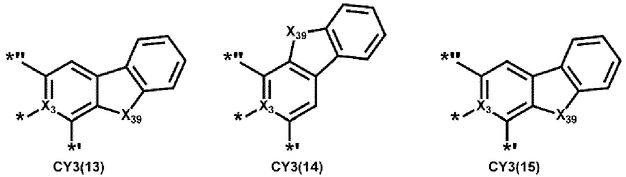 wherein, in Formulae CY3(1) to CY3(15),
X₃ may be the same as described in the present specification,
X₃₉ may be O, S, N(Z₃₉ₐ), C(R₃₉ₐ)(R_{39b}), or Si(R₃₉ₐ)(R_{39b}),
R₃₉ₐ and R_{39b} may each be the same as described in connection with R₃,
*" may indicate a binding site to T₁₂ in Formula 1,
* may indicate a binding site to X₇ or M₁ in Formula 1, and
*' may indicate a binding site to T₁₃ in Formula 1.

In an embodiment, in Formula 1, each of n2 and n3 may be 1, and a group represented by 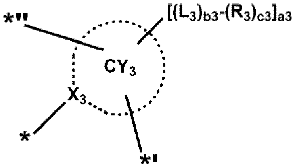 may be represented by one of Formulae CY3-1 to CY3-13: 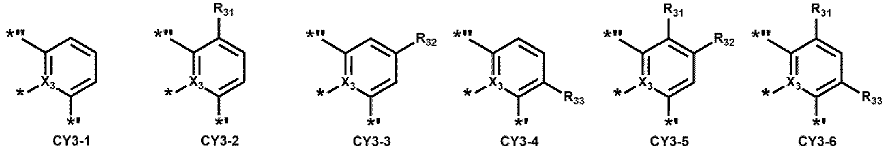 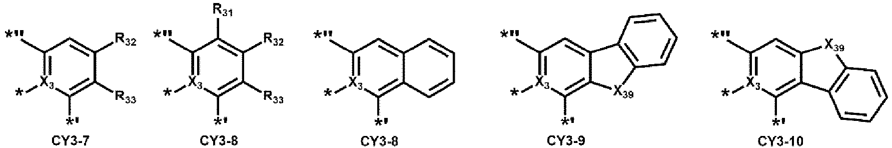 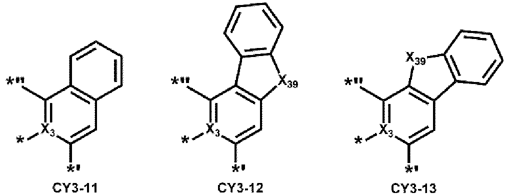 wherein, in Formulae CY3-1 to CY3-13,
X₃ may be the same as described in the present specification,
X₃₉ may be O, S, N-[(L₃)_{b3}-(R₃)_{c3}], C(R₃₉ₐ)(R_{39b}), or Si(R₃₉ₐ)(R_{39b}),
L₃, b3, R₃, and c3 may respectively be the same as those described in the present specification,
R₃₁ to R₃₃, R₃₉ₐ, and R_{39b} may each be the same as described in connection with R₃, wherein each of R₃₁ to R₃₃ may not be hydrogen,
*" may indicate a binding site to T₁₂ in Formula 1,
* may indicate a binding site to X₇ or M₁ in Formula 1, and
*' may indicate a binding site to T₁₃ in Formula 1.

In an embodiment, in Formula 1, n3 may not be 0, n4 may be 0, and a group represented by 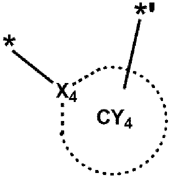 may be represented by one of Formulae CY4(1) to CY4(20): 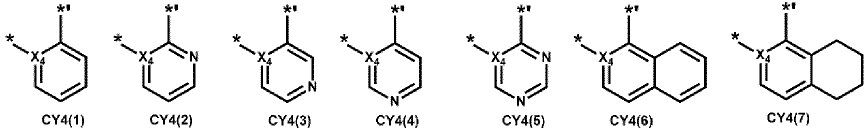 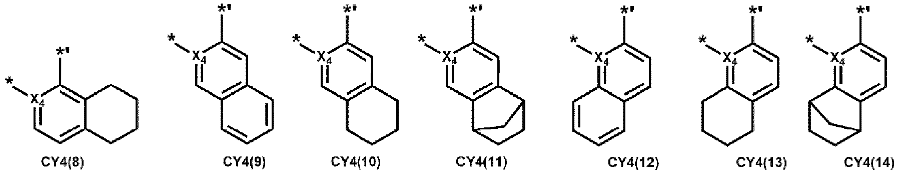 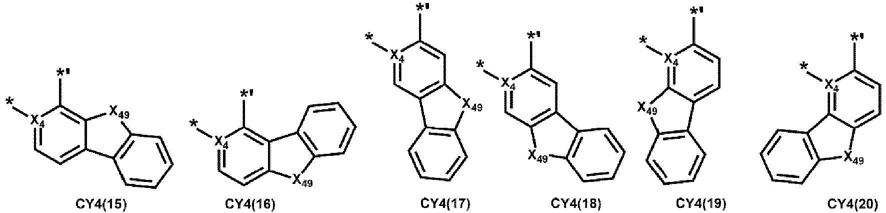 wherein, in Formulae CY4(1) to CY4(20),
X₄ may be the same as described in the present specification,
X₄₉ may be O, S, N(R₄₉ₐ), C(R₄₉ₐ)(R_{49b}), or Si(R₄₉ₐ)(R_{49b}),
R₄₉ₐ and R_{49b} may each be the same as described in connection with R₄,
*' may indicate a binding site to T₁₃ in Formula 1, and
* may indicate a binding site to X₈ or M₁ in Formula 1.

In an embodiment, in Formula 1, n3 may be 1, n4 may be 0, and a group represented by 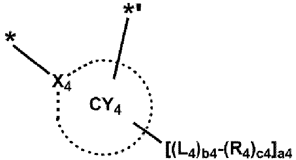 may be a group represented by one of Formulae CY4-1 to CY4-16: 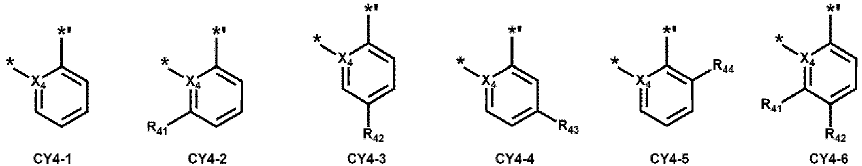 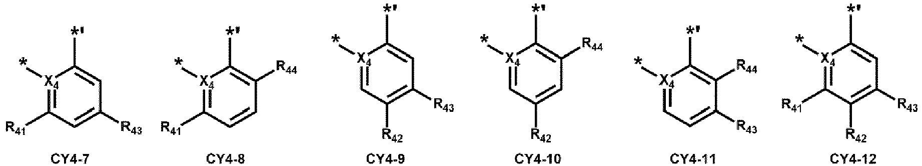 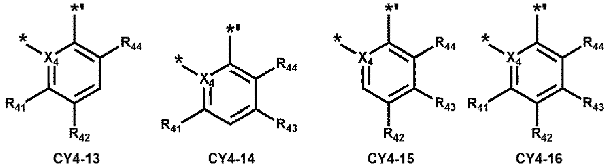 wherein, in Formulae CY4-1 to CY4-16,
X₄ may be the same as described in the present specification,
R₄₁ to R₄₄ may each be the same as described in connection with R₄, wherein each of R₄₁ to R₄₄ is not hydrogen,
*' may indicate a binding site to T₁₃ in Formula 1, and
* may indicate a binding site to X₈ or M₁ in Formula 1.

In an embodiment, the organometallic compound represented by Formula 1 may be a compound represented by one of Formulae 1-1 to 1-3: 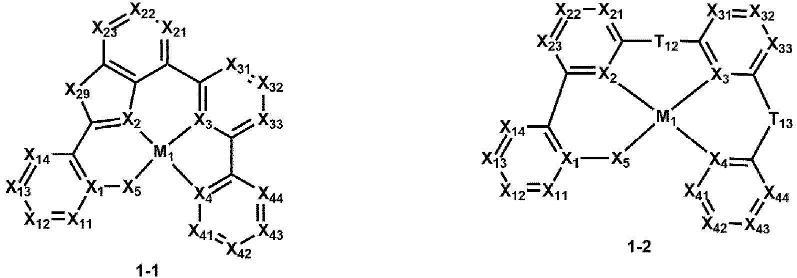 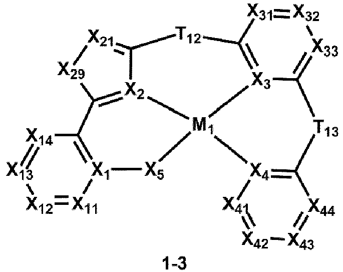 wherein, in Formulae 1-1 to 1-3,
M₁, X₁ to X₅, T₁₂, and T₁₃ may each be the same as described in the present specification,
X₁₁ may be N or C(R₁₁), X₁₂ may be N or C(R₁₂), X₁₃ may be N or C(R₁₃), and X₁₄ may be N or C(R₁₄),
R₁₁ to R₁₄ may each be the same as described in connection with R₁, or
two or more of R₁₁ to R₁₄ may optionally be linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
X₂₁ may be N or C(R₂₁), X₂₂ may be N or C(R₂₂), and X₂₃ may be N or C(R₂₃),
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may each be the same as described in the present specification,
R₂₁ to R₂₃, R₂₉ₐ, and R_{29b} may each be the same as described in connection with R₂, or
two or more of R₂₁ to R₂₃ may optionally be linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
X₃₁ may be N or C(R₃₁), X₃₂ may be N or C(R₃₂), and X₃₃ may be N or C(R₃₃),
R₃₁ to R₃₃ may each be the same as described in connection with R₃, or
two or more of R₃₁ to R₃₃ may optionally be linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
X₄₁ may be N or C(R₄₁), X₄₂ may be N or C(R₄₂), X₄₃ may be N or C(R₄₃), and X₄₄ may be N or C(R₄₄),
R₄₁ to R₄₄ may each be the same as described in connection with R₄, or
two or more of R₄₁ to R₄₄ may optionally be linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

In an embodiment, the sensitizer may include at least one deuterium.

For example, the organometallic compound represented by Formula 1 may be a compound represented by Formula 1-1(1) or a compound represented by First dopant 1-2(1): 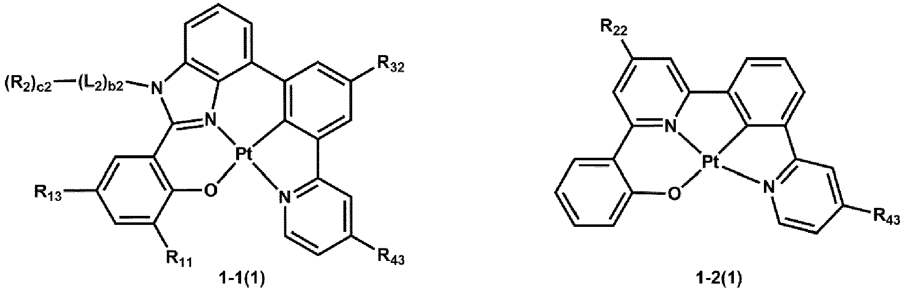 wherein, in Formulae 1-1(1) and 1-2(1),
R₁₁ and R₁₃ may each independently be a C₁-C₁₀ alkyl group that is unsubstituted or substituted with deuterium,
L₂ may be a benzene group that is unsubstituted or substituted with deuterium, a C₁-C₁₀ alkyl group, a C₃-C₁₀ cycloalkyl group, a phenyl group, a biphenyl group, or any combination thereof,
b2 may be 1 or 2,
c2 may be 0, 1, or 2,
R₂ and R₃₂ may each independently be:
   a C₁-C₁₀ alkyl group that is unsubstituted or substituted with deuterium, a C₃-C₁₀ cycloalkyl group, or any combination thereof; or
   a phenyl group that is unsubstituted or substituted with deuterium, a C₁-C₁₀ alkyl group, a C₃-C₁₀ cycloalkyl group, a phenyl group, a biphenyl group, or any combination thereof, and
   R₂₂ and R₄₃ may each independently be a phenyl group that is unsubstituted or substituted with deuterium, a C₁-C₁₀ alkyl group, a C₃-C₁₀ cycloalkyl group, a phenyl group, a biphenyl group, or any combination thereof.

The C₁-C₁₀ alkyl group may include, for example, a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group.

The C₃-C₁₀ cycloalkyl group may include a cyclopentyl group, a cyclohexyl group, a cycloheptyl group, a cyclooctyl group, an adamantanyl group, a norbornanyl group (or, a bicyclo[2.2.1]heptyl group), a bicyclo[1.1.1]pentyl group, a bicyclo[2.1.1]hexyl group, and a bicyclo[2.2.2]octyl group.

In an embodiment, the sensitizer may be selected from compounds of Group 1-1 to Group 1-4:

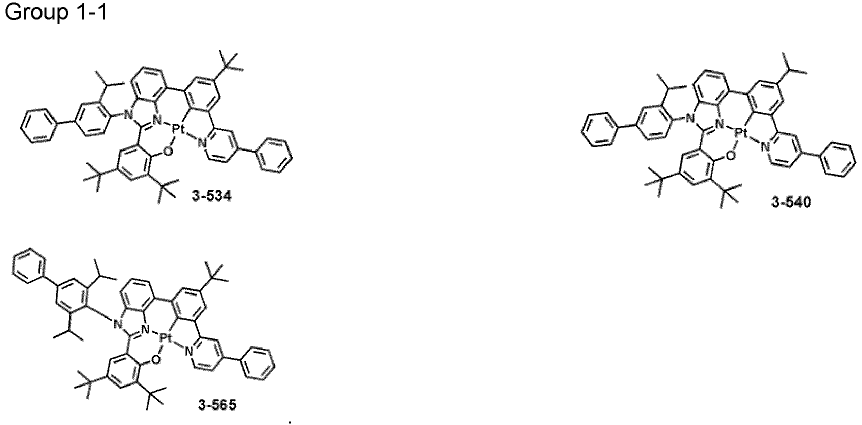

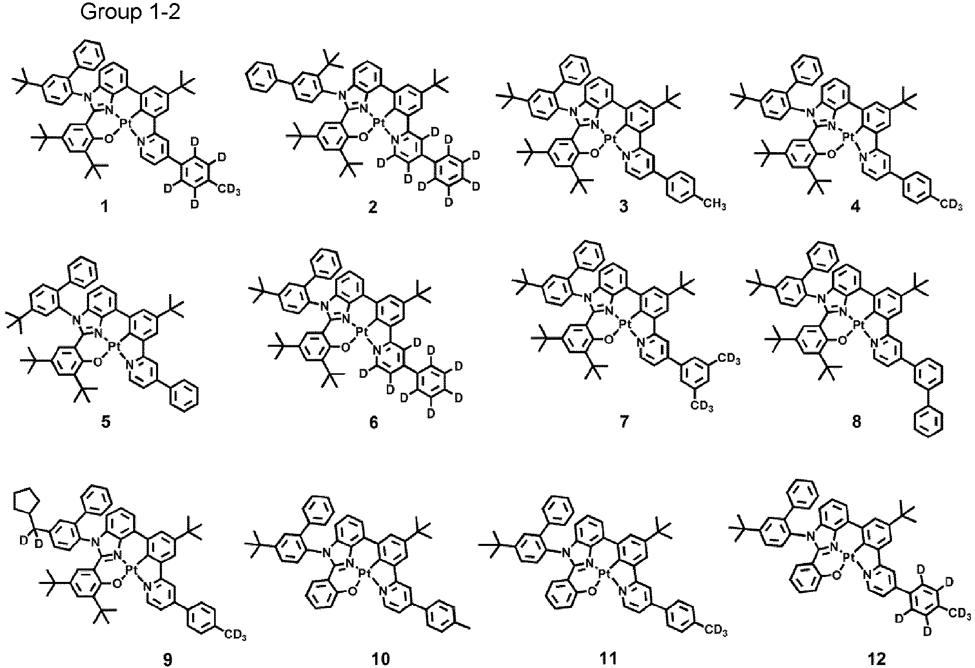

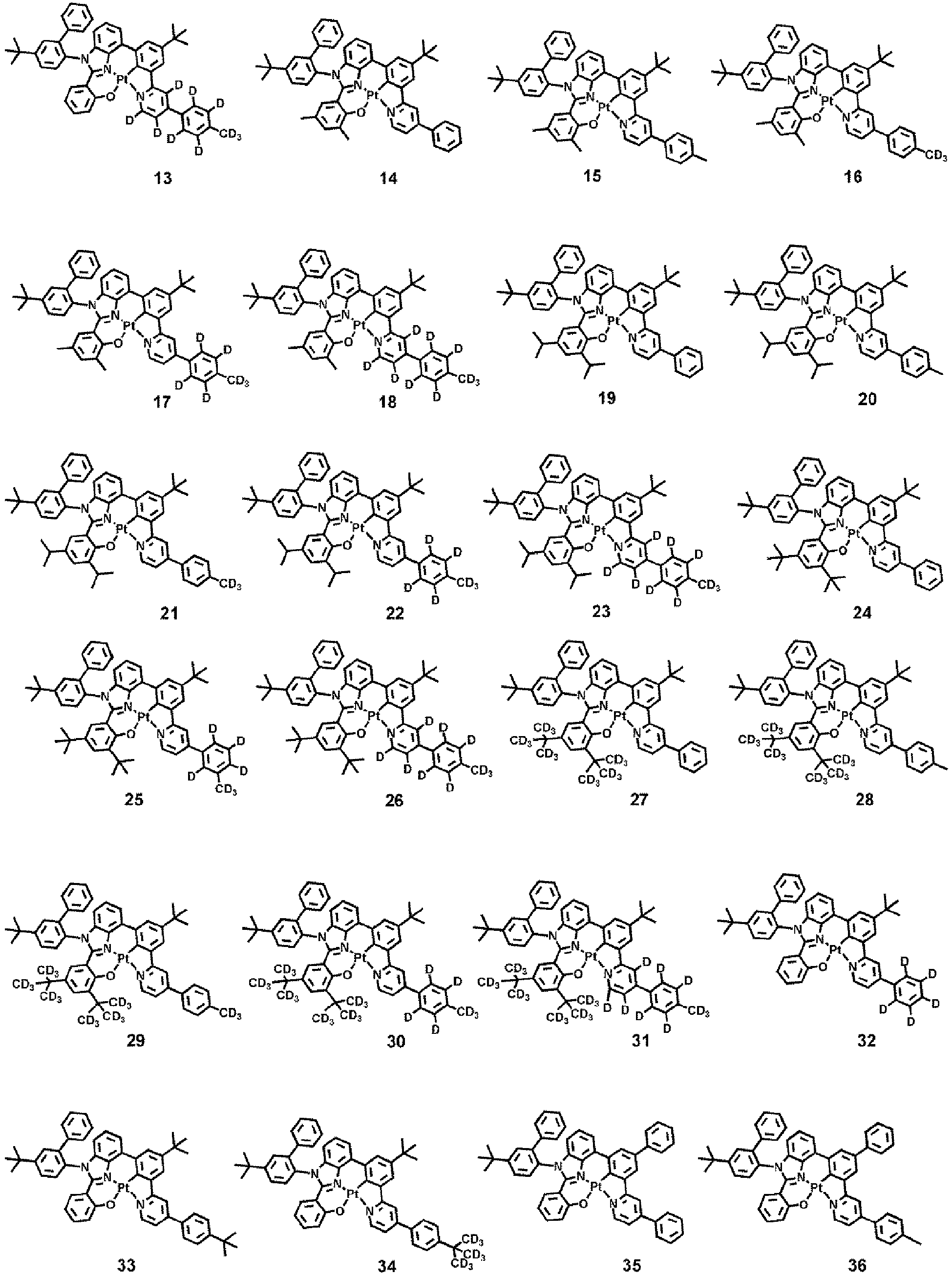

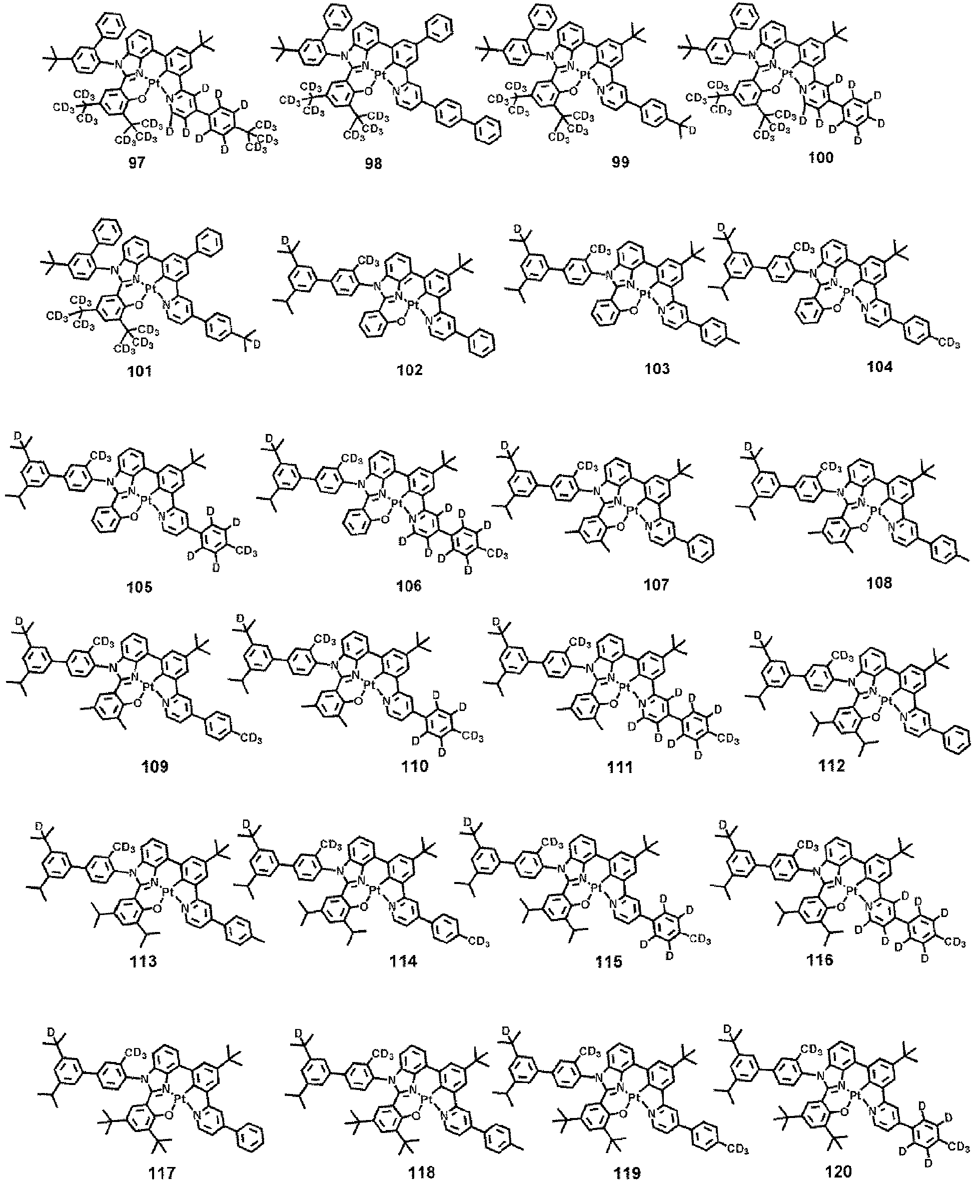

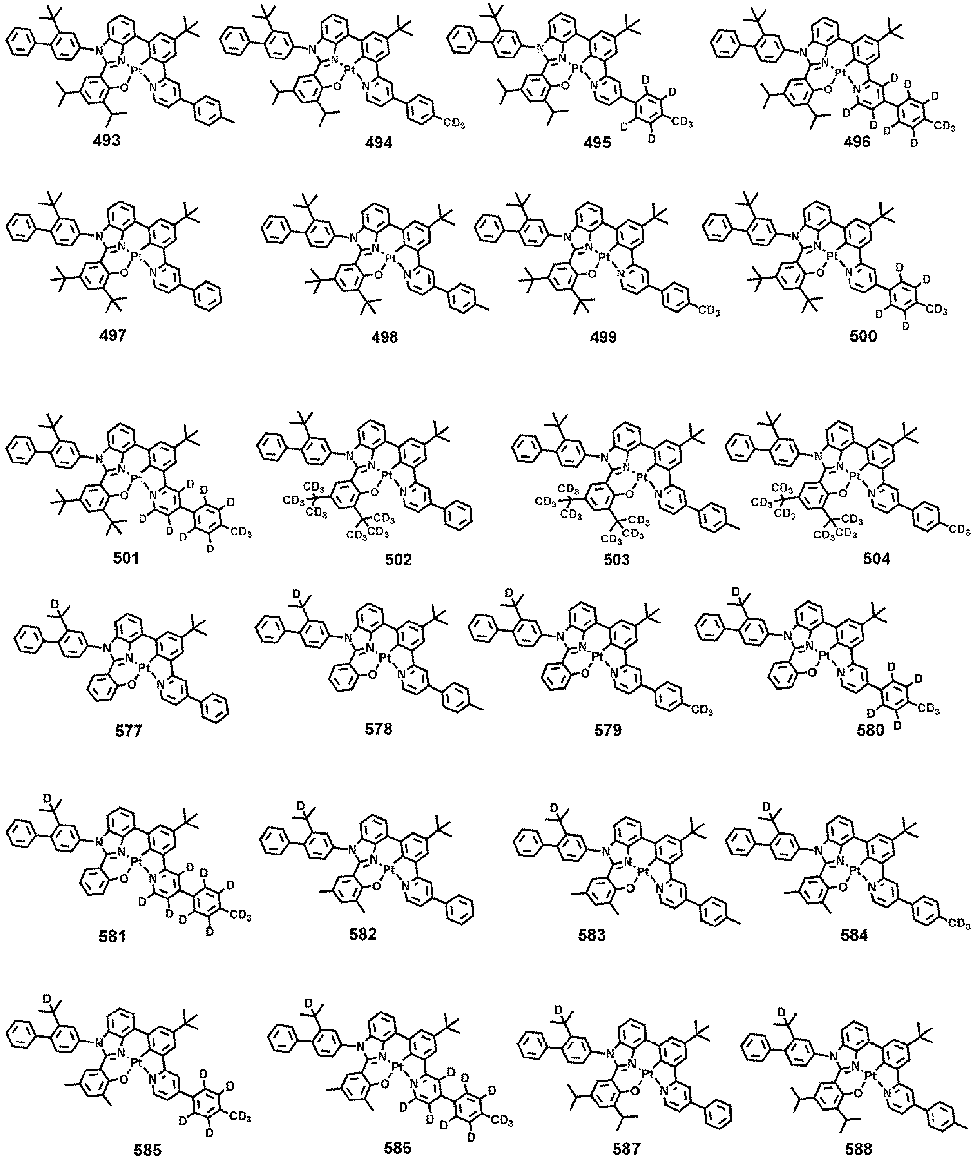

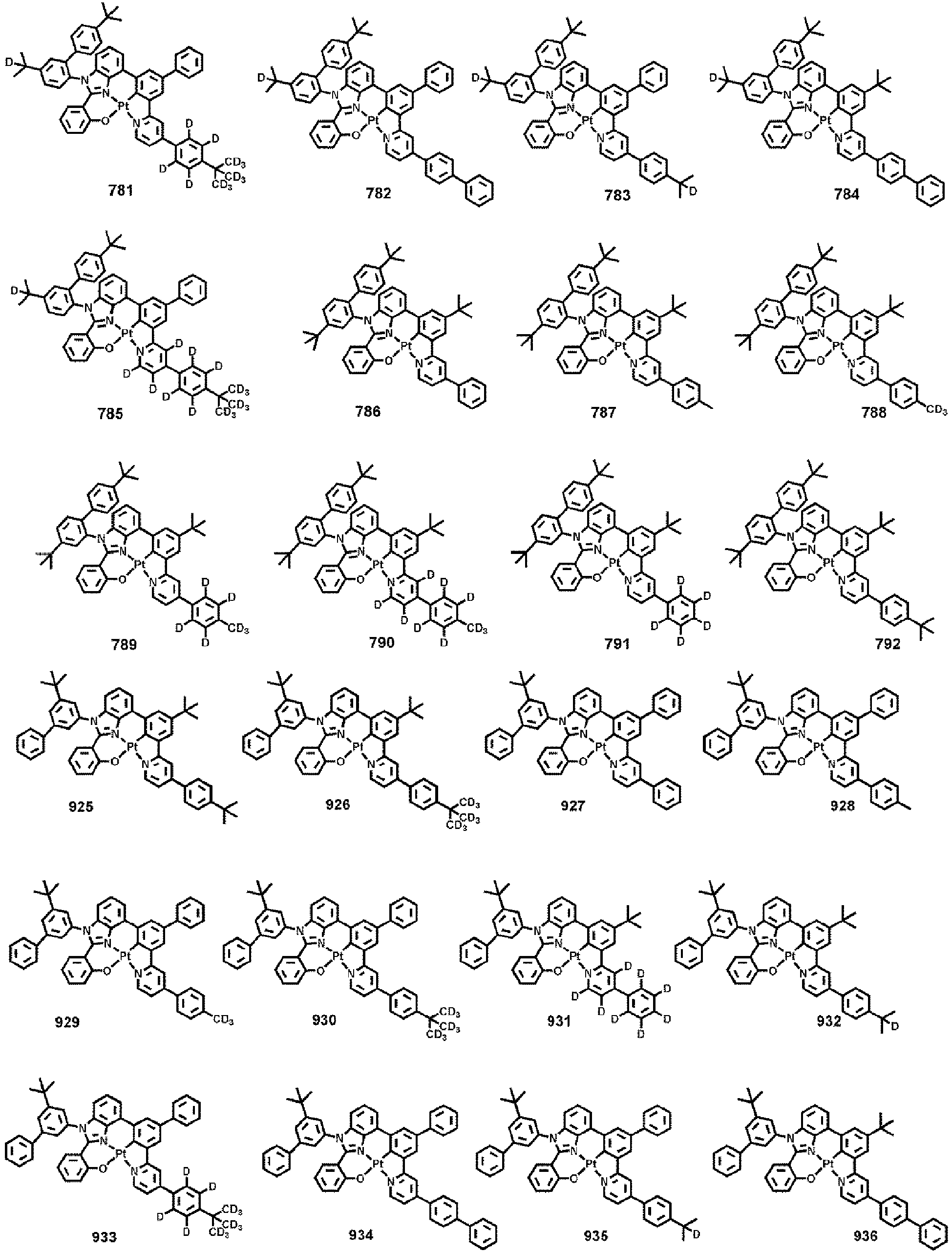

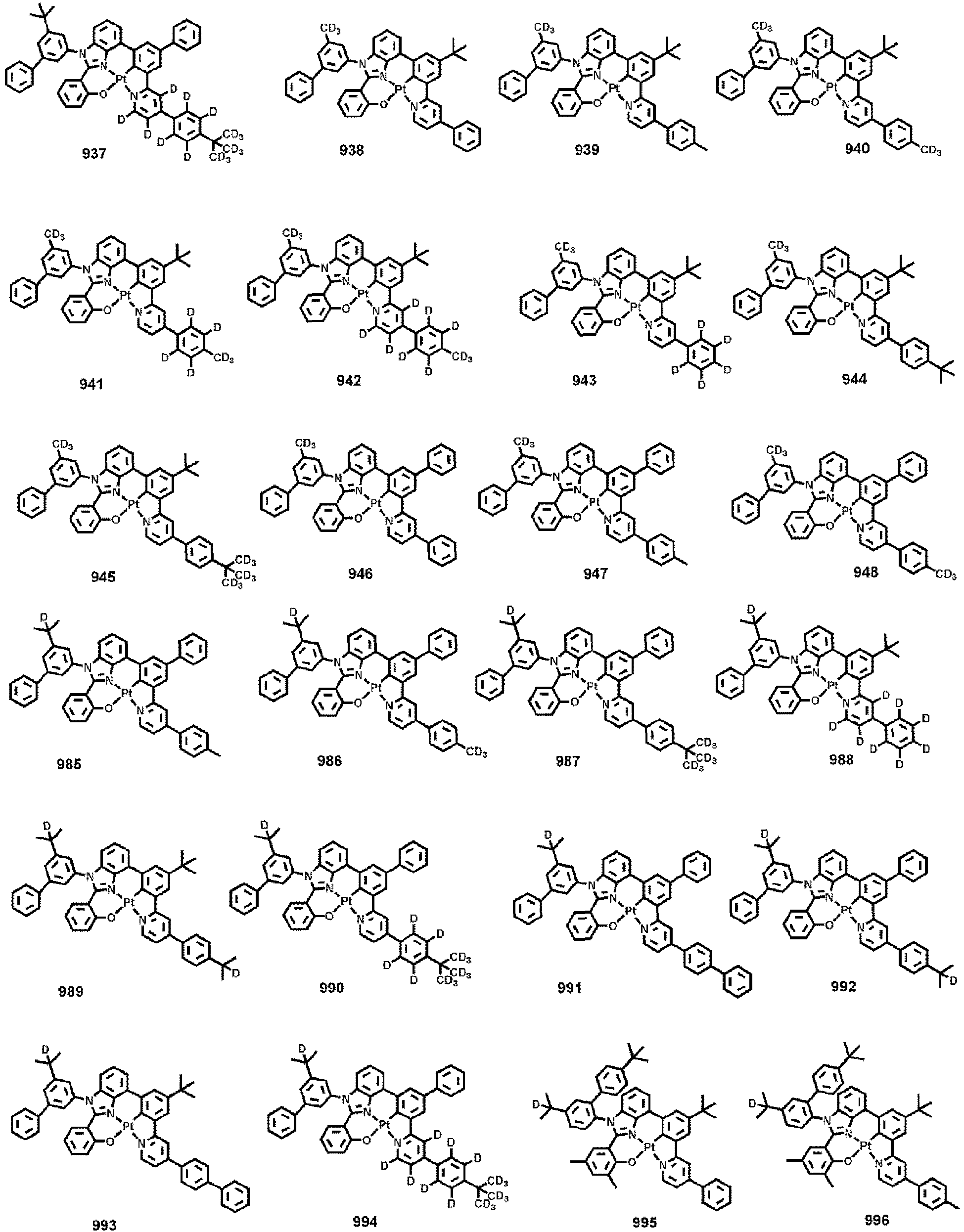

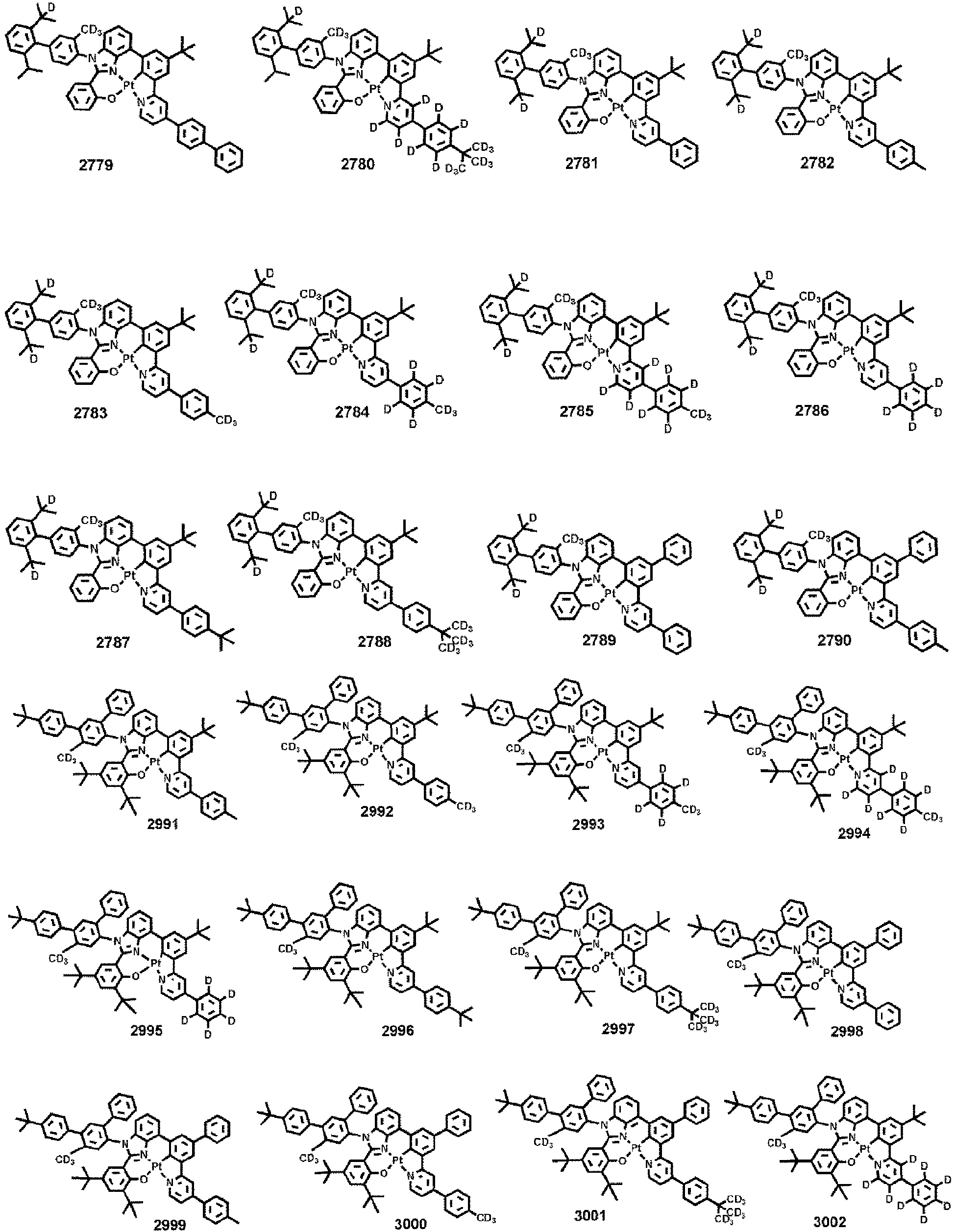

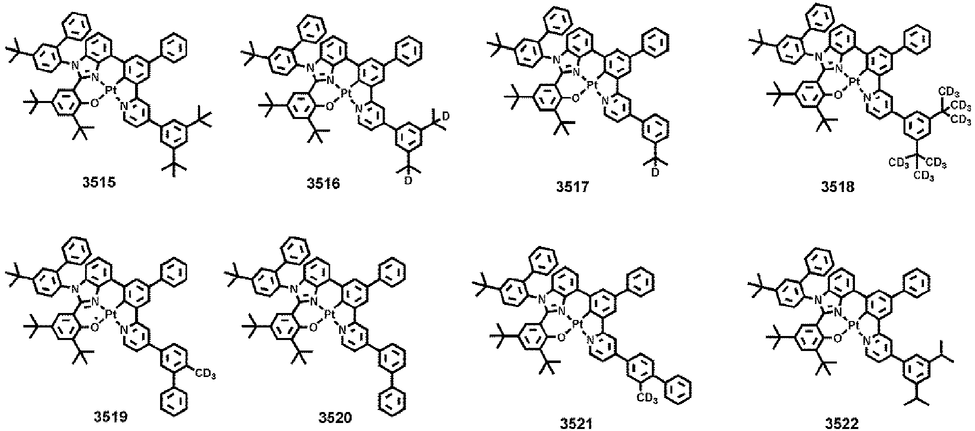

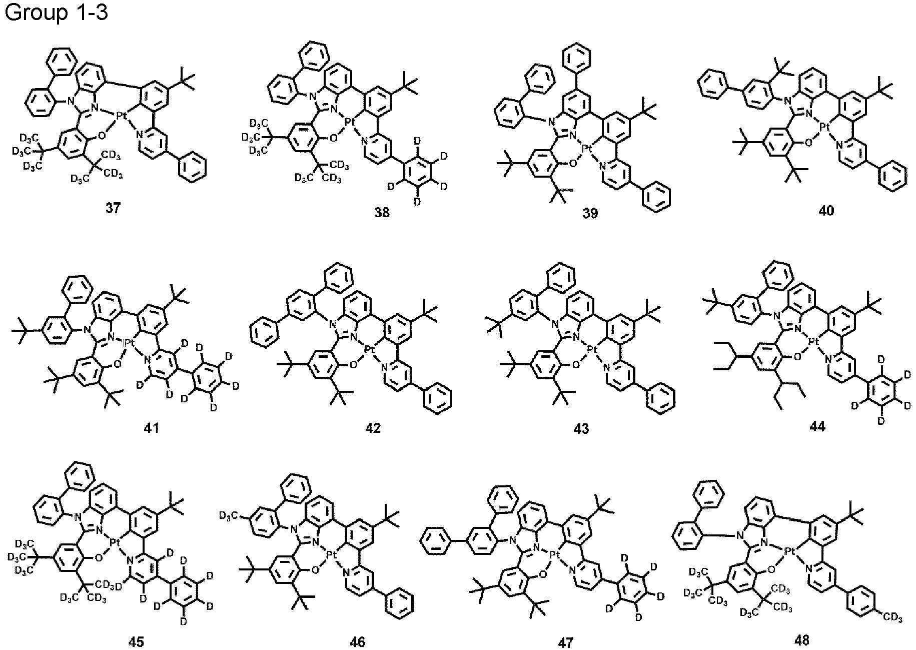

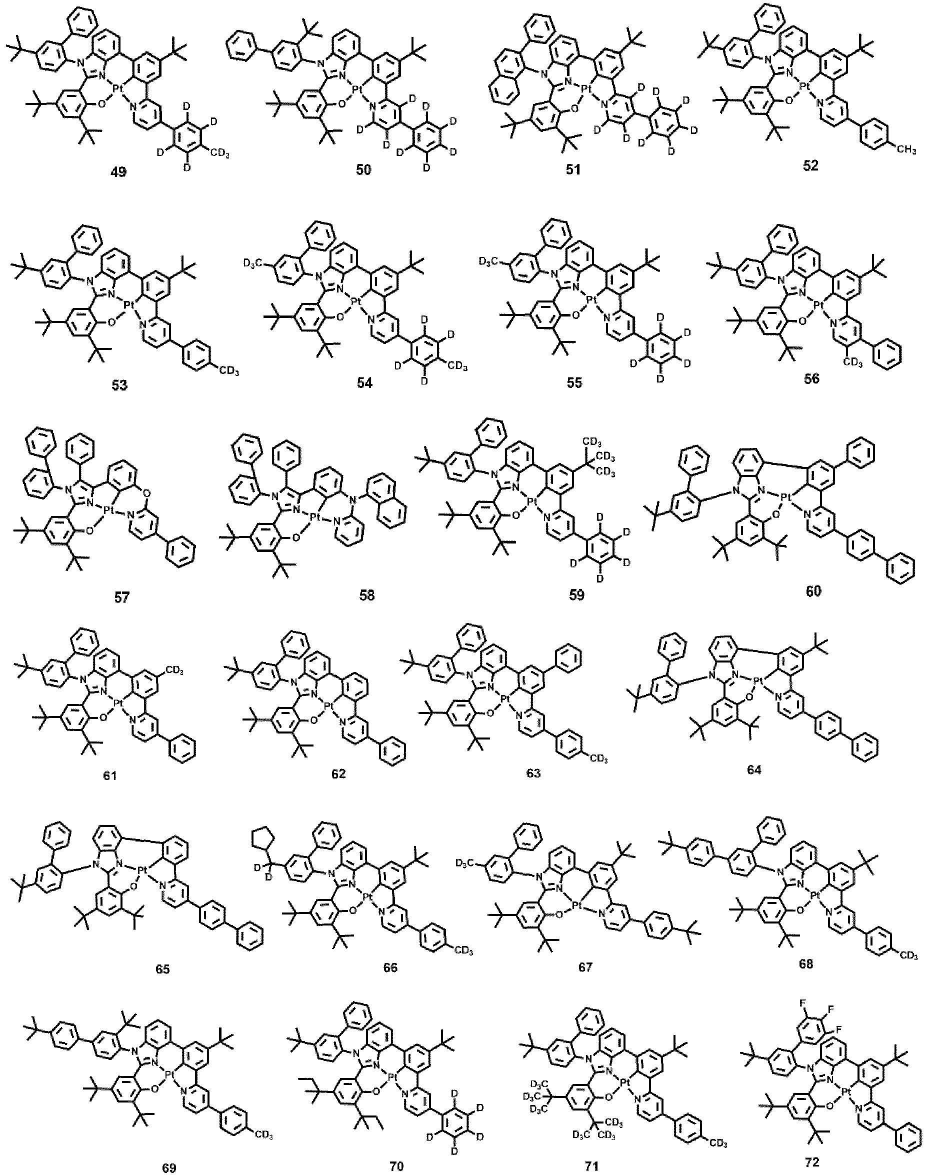

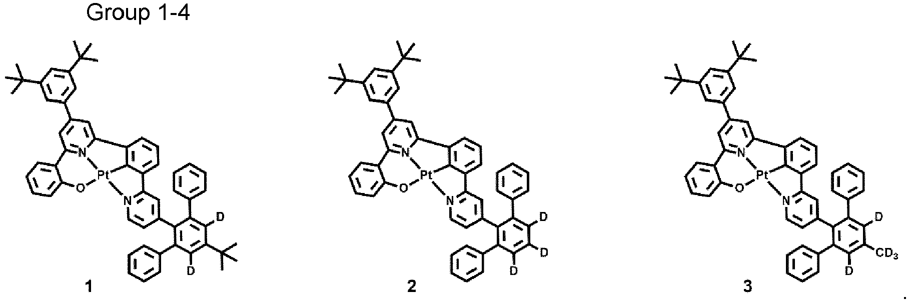

In the present specification, OMe is a methoxy group, TMS is a trimethylsilyl group, and TMG is a trimethylgermyl group.

### Description of fluorescent emitter

The fluorescent emitter may not include a transition metal.

In an embodiment, the fluorescent emitter may include at least one of a thermally activated delayed fluorescence emitter and a prompt fluorescence emitter.

In an embodiment, the fluorescent emitter may be a thermally activated delayed fluorescence emitter including at least one 6-membered ring including at least one nitrogen (N) and at least one boron (B), e.g., as a ring atom..

In an embodiment, the fluorescent emitter may be a prompt fluorescence emitter including at least one 5-membered ring or 6-membered ring including at least one boron (B), e.g., as a ring atom.

In an embodiment, the fluorescent emitter may be a compound represented by Formula 3-1, a compound represented by Formula 3-2, a compound represented by Formula 3-3, or a compound represented by Formula 4: 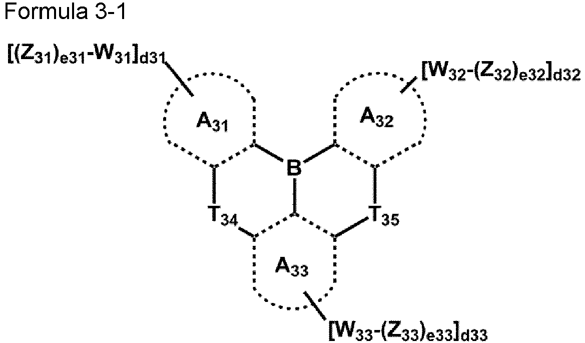 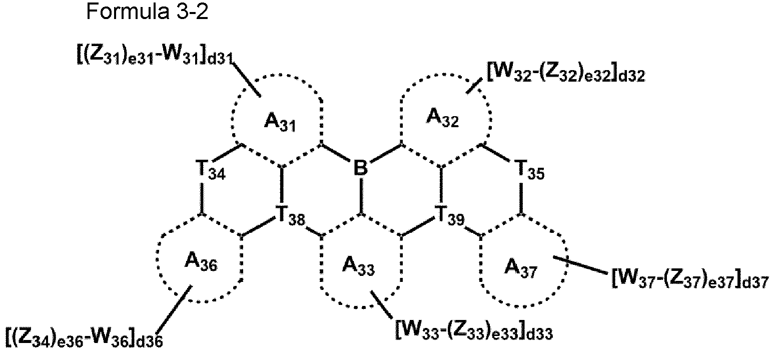 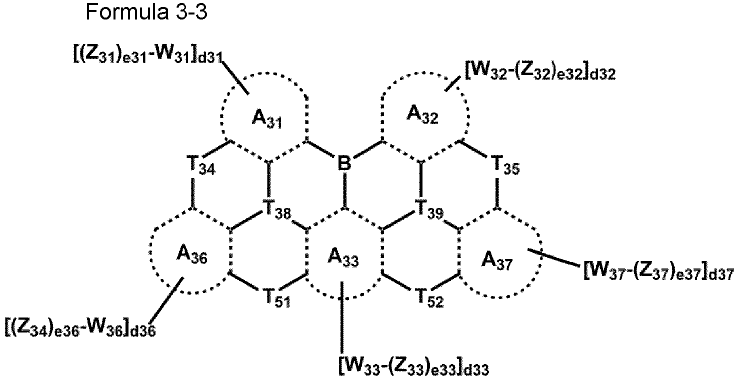 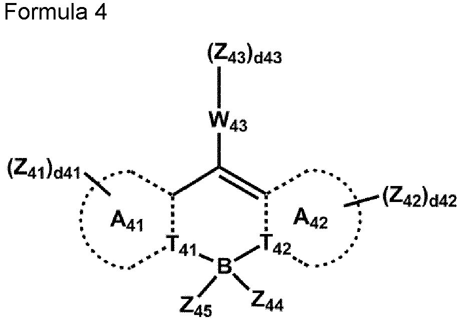 wherein, in Formulae 3-1, 3-2, 3-3, and 4,
ring A₃₁, ring A₃₂, ring A₃₃, ring A₃₆, ring A₃₇, ring A₄₁, and ring A₄₂ may each independently be a C₅-C₃₀ carbocyclicgroup or a C₁-C₃₀ heterocyclic group,
T₃₄ may be a single bond, O, S, N-[W₃₄-(Z₃₄)ₑ₃₄], or C(Z₃₄ₐ)(Z_{34b}),
T₃₅ may be a single bond, O, S, N-[W₃₅-(Z₃₅)ₑ₃₅], or C(Z₃₅ₐ)(Z_{35b}),
T₅₁ may be a single bond, O, S, N-[W₅₁-(Z₅₁)ₑ₅₁], or C(Z₅₁ₐ)(Z_{51b}),
T₅₂ may be a single bond, O, S, N-[W₅₂-(Z₅₂)ₑ₅₂], or C(Z₅₂ₐ)(Z_{52b}),
T₃₈ and T₃₉ may each independently be N or B,
T₄₁ and T₄₂ may each independently be N or C,
W₃₁ to W₃₇, W₄₃, W₅₁, and W₅₂ may each be the same as described in connection with L₁,
Z₃₁ to Z₃₇, Z₅₁, Z₅₂, Z₃₄ₐ, Z_{34b}, Z₃₅ₐ, Z_{35b}, Z₅₁ₐ, Z_{51b}, Z₅₂ₐ, Z_{52b}, and Z₄₁ to Z₄₅ may each be the same as described in connection with R₁,
e31 to e37, e51, and e52 may each be the same as described in connection with c1, and
d31 to d33, d36, d37, and d41 to d43 may each be the same as described in connection with a1.

For example, ring A₃₁, ring A₃₂, ring A₃₃, ring A₃₆, ring A₃₇, ring A₄₁, and ring A₄₂ may each be the same as described in connection with ring CY₁.

In an embodiment, each of rings A₃₁, A₃₂, A₃₆ and A₃₇ in Formulae 3-1, 3-2, and 3-3 may be a benzene group, a carbazole group, a dibenzofuran group, a dibenzothiophene group, or an indolocarbazole group, and ring A₃₃ may be a benzene group, a carbazole group, a dibenzofuran group, a dibenzothiophene group, an indolocarbazole group, a quinoline group, an isoquinoline group, a benzoquinoline group, or a benzoisoquinoline group.

In an embodiment, T₃₄ in Formulae 3-1 to 3-3 may be N-[W₃₄-(Z₃₄)ₑ₃₄].

In an embodiment, T₃₄ in Formulae 3-1 to 3-3 may be N-[W₃₄-(Z₃₄)ₑ₃₄], and Z₃₄ and ring A₃₁ and/or Z₃₄ and Z₃₁ may be bonded together via a single bond or a linking group including O, S, N, B, C, or any combination thereof.

In an embodiment, T₃₅ in Formulae 3-1 to 3-3 may be N-[W₃₅-(Z₃₅)ₑ₃₅].

In an embodiment, T₃₅ in Formulae 3-1 to 3-3 may be N-[W₃₅-(Z₃₅)ₑ₃₅], and Z₃₅ and ring A₃₂ and/or Z₃₅ and Z₃₂ may be bonded together via a single bond or a linking group including O, S, N, B, C, or any combination thereof.

In an embodiment, T₃₄ may be C(Z₃₄ₐ)(Z_{34b}), and Z₃₄ₐ and Z_{34b} may optionally be bonded together to form a C₅-C₃₀ carbocyclicgroup or a C₁-C₃₀ heterocyclic group.

In an embodiment, T₃₅ may be C(Z₃₅ₐ)(Z_{35b}), and Z₃₅ₐ and Z_{35b} may optionally be bonded together to form a C₅-C₃₀ carbocyclicgroup or a C₁-C₃₀ heterocyclic group.

In an embodiment, T₅₁ may be C(Z₅₁ₐ)(Z_{51b}), and Z₅₁ₐ and Z_{51b} may optionally be bonded together to form a C₅-C₃₀ carbocyclicgroup or a C₁-C₃₀ heterocyclic group.

In an embodiment, T₅₂ may be C(Z₅₂ₐ)(Z_{52b}), and Z₅₂ₐ and Z_{52b} may optionally be bonded together to form a C₅-C₃₀ carbocyclic group or a C₁-C₃₀ heterocyclic group.

In an embodiment, ring A₄₁ and ring A₄₂ in Formula 4 may each be:
a pyrrole group; or
a pyrrole group condensed with a cyclopentane group, a cyclopentene group, a cyclopentadiene group, a cyclohexane group, a cyclohexene group, a cyclohexadiene group, a cycloheptane group, a cycloheptene group, a cycloheptadiene group, a cyclooctane group, a cyclooctene group, a cyclooctadiene group, a benzene group, a naphthalene group, a phenanthrene group, an anthracene group, a 2,7-dihydrooxepine group, a 2,7-dihydrothiepine group, a 2,3-dihydrooxepine group, a 2,3-dihydrothiepine group, a furan group, a thiophene group, a benzofuran group, a benzothiophene group, an indene group, a dihydrofuran group, a dihydrothiophene group, or any combination thereof.

For example, T₄₁ and T₄₂ may each be N.

For example, the fluorescent emitter may be selected from compounds of Groups 3 and 4:

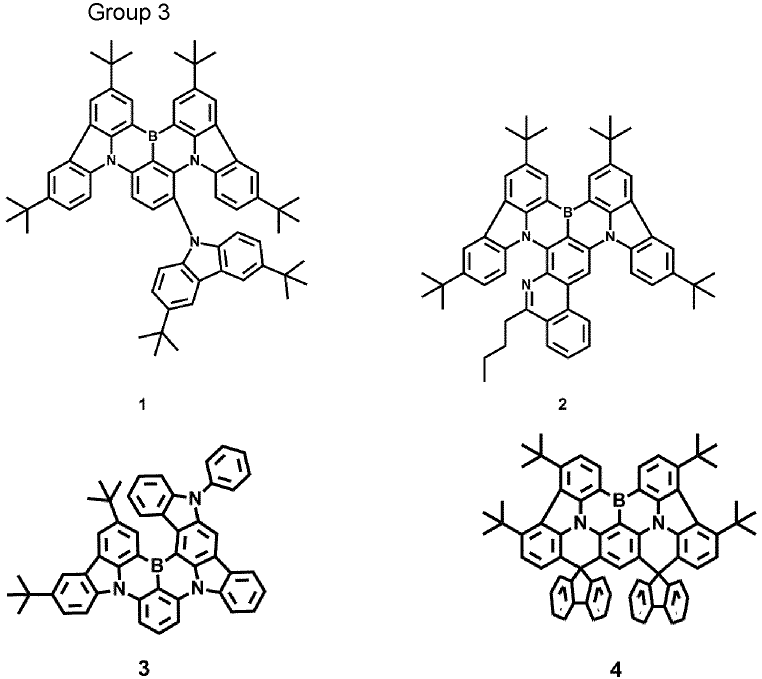

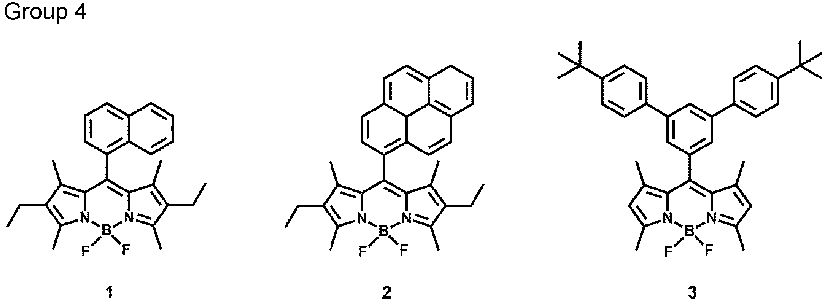

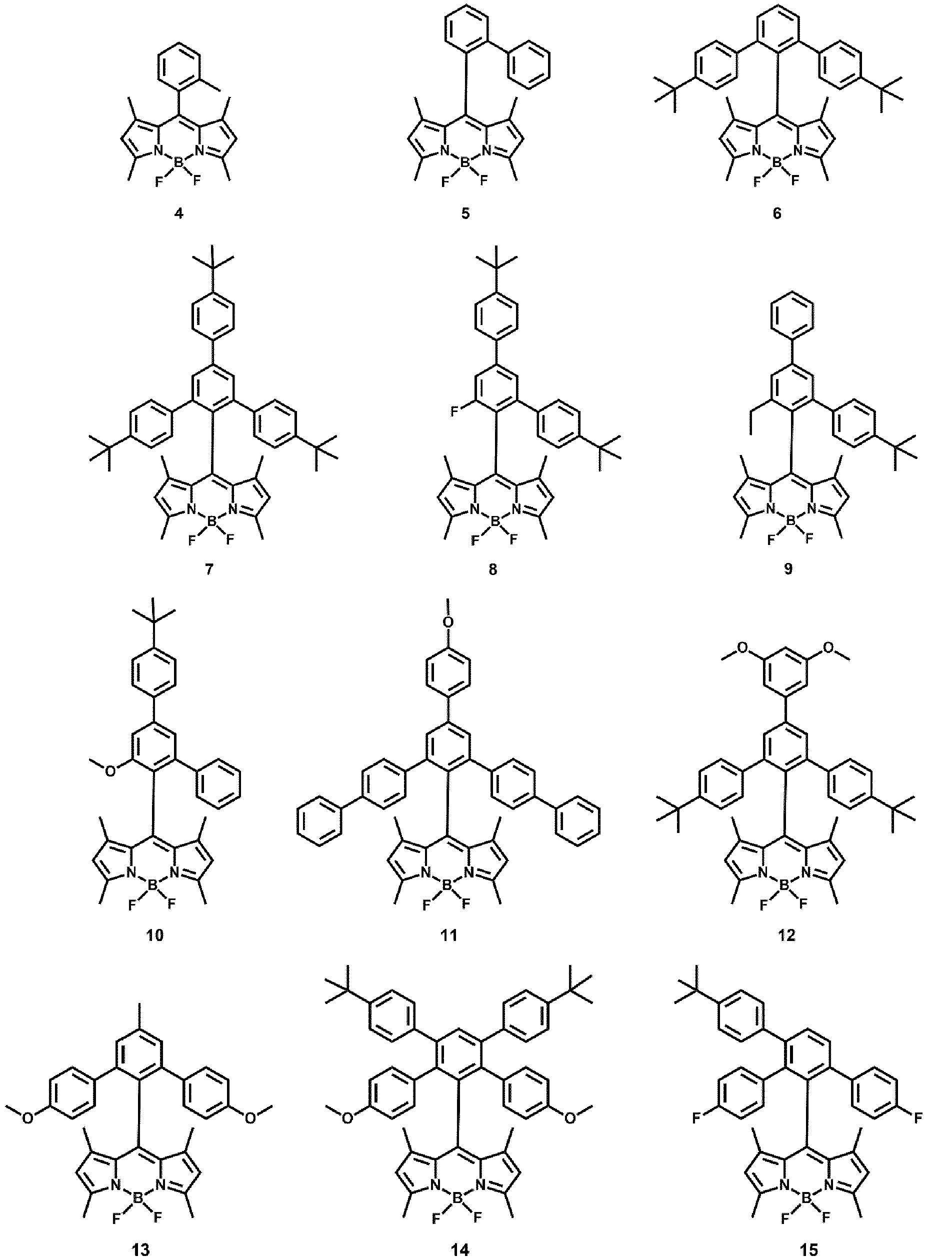

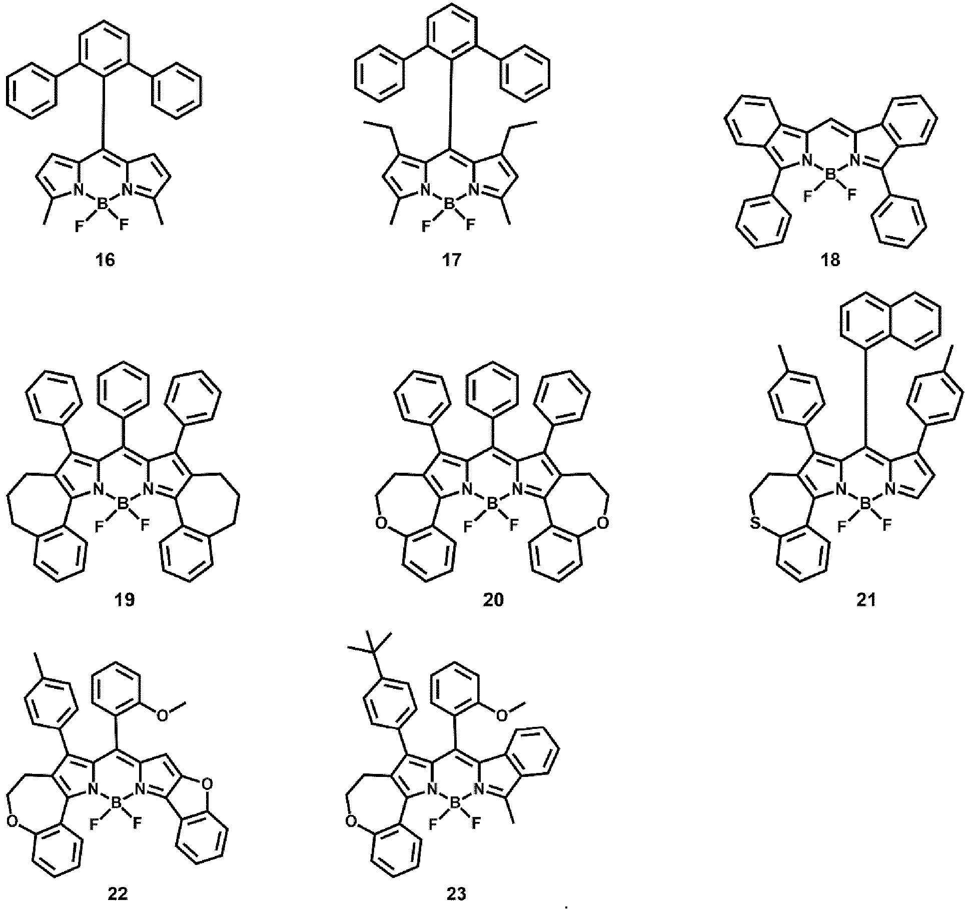

An amount of the sensitizer in the emission layer may be 1 wt% to 30 wt% based on 100 wt% of a host in the emission layer. Alternatively, an amount of the sensitizer in the emission layer may be 0.5 wt% to 30 wt% based on 100 wt% of the emission layer. Meanwhile, an amount of the fluorescent emitter in the emission layer may be 0.01 wt% to 15 wt% based on 100 wt% of the emission layer. When the amounts of the sensitizer and the fluorescent emitter satisfy the ranges as described above, an emission layer having excellent characteristics may be implemented without concentration quenching.

In an embodiment, the emission layer may not include compounds of Group A:

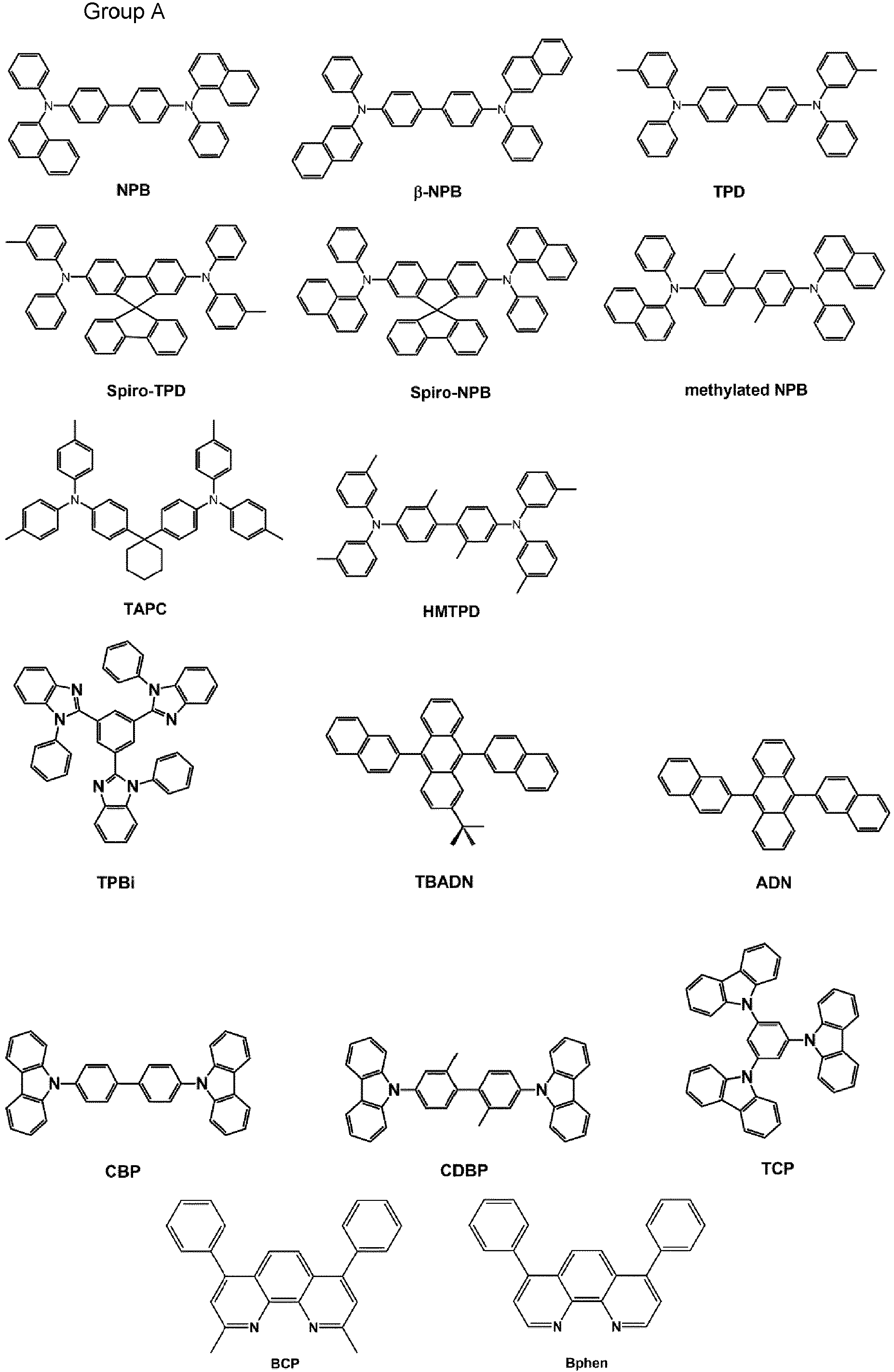

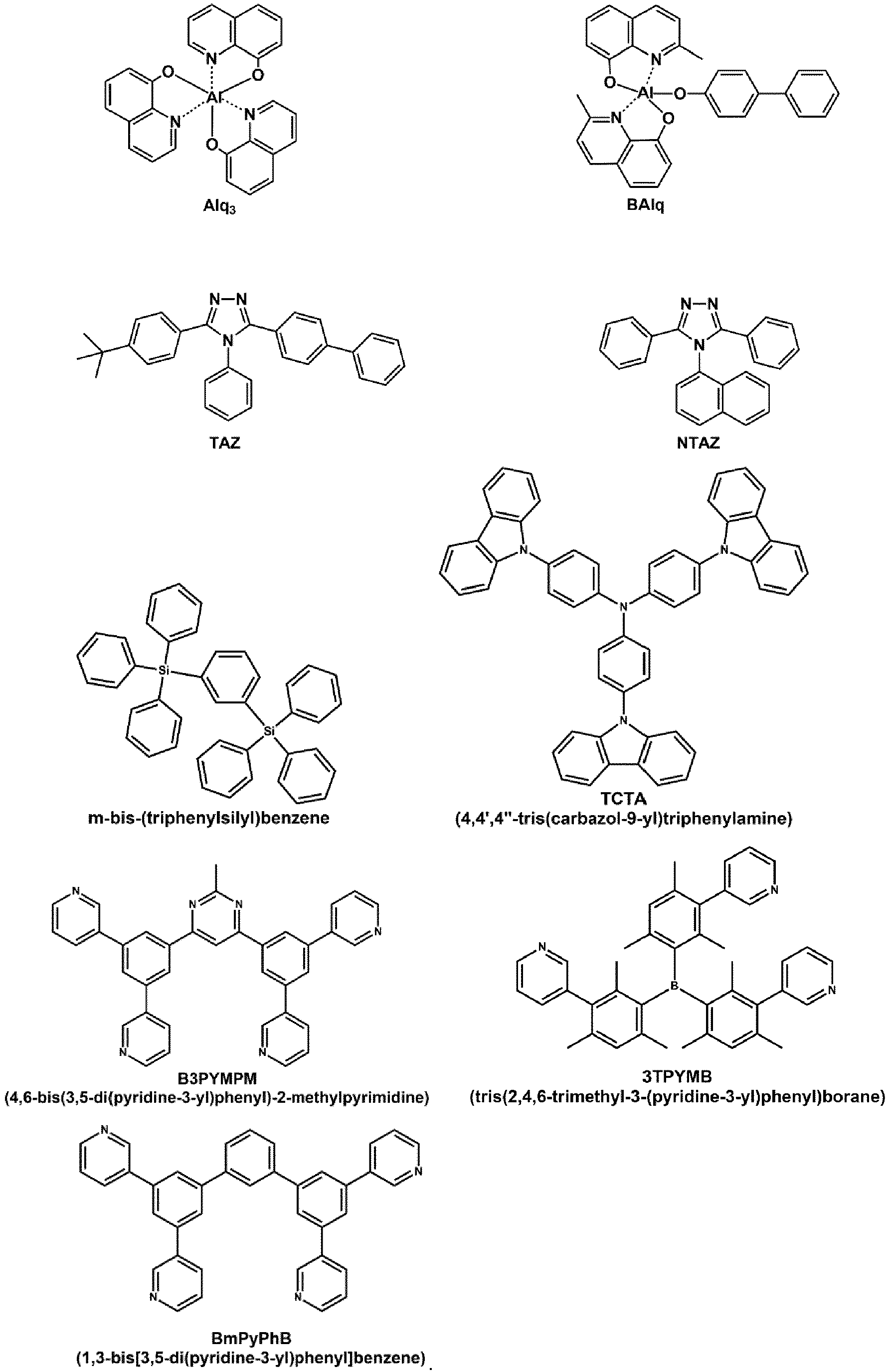

In an embodiment, the interlayer of the light-emitting device may further include a hole transport region arranged between the first electrode and the emission layer and an electron transport region arranged between the emission layer and the second electrode.

The hole transport region may include a hole injection layer, a hole transport layer, an electron blocking layer, a buffer layer, or any combination thereof, and the electron transport region may include a hole blocking layer, an electron transport layer, an electron injection layer, or any combination thereof.

The term "interlayer" as used herein refers to a single layer and/or a plurality of layers arranged between the first electrode and the second electrode of the light-emitting device. The term "interlayer" may include an organometallic compound and an organometallic complex including a metal.

In an embodiment, the interlayer of the light-emitting device may include:
m light-emitting units including at least one emission layer; and
m-1 charge generation layers arranged between two adjacent light-emitting units among the m light-emitting units, when m is an integer of 2 or more.

In other words, the light-emitting device may be a tandem light-emitting device.

For example, m may be 2, 3, 4, 5, 6, 7, 8, 9, or 10. In an embodiment, m may be 2, 3, 4, 5, or 6.

In an embodiment, at least one light-emitting unit among the m light-emitting units may include the emission layer as described in the present specification.

In an embodiment, at least one light-emitting unit among the m light-emitting units may emit blue light.

According to another aspect of the disclosure, the light-emitting device may be included in an electronic apparatus. Thus, an electronic apparatus including the light-emitting device is provided. The electronic apparatus may include, for example, a display, an illumination, a sensor, and the like.

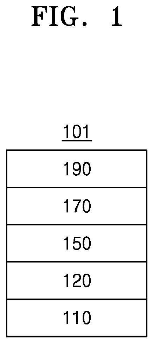

FIG. 1 schematically illustrates a cross-sectional view of an organic light-emitting device 101, which is a light-emitting device according to an embodiment. Hereinafter, the structure of an organic light-emitting device according to an embodiment and a method of manufacturing an organic light-emitting device according to an embodiment will be described in connection with FIG. 1.

The organic light-emitting device 101 of FIG. 1 includes a first electrode 110, a second electrode 190, and an interlayer (not shown) arranged between the first electrode 110 and the second electrode 190, wherein the interlayer includes a hole transport region 120, an emission layer 150, and an electron transport region 170.

A substrate may be additionally arranged under the first electrode 110 or above the second electrode 190. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

The first electrode 110 may be formed by providing, on the substrate, a material for forming the first electrode 110, by using a deposition or sputtering method. The first electrode 110 may be an anode. The material for forming the first electrode 110 may include materials with a high work function to facilitate hole injection. The first electrode 110 may be a reflective electrode. The material for forming the first electrode 110 may be indium tin oxide (ITO), indium zinc oxide (IZO), tin oxide (SnO₂), or zinc oxide (ZnO). In an embodiment, the material for forming the first electrode 110 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 110 may have a single-layered structure or a multilayer structure including two or more layers. For example, the first electrode 110 may have a three-layered structure of ITO/Ag/ITO.

The hole transport region 120 may be arranged between the first electrode 110 and the emission layer 150.

The hole transport region 120 may include a hole injection layer, a hole transport layer, an electron blocking layer, a buffer layer, or any combination thereof.

The hole transport region 120 may include only a hole injection layer or only a hole transport layer. In an embodiment, the hole transport region 120 may have a hole injection layer/hole transport layer structure or a hole injection layer/hole transport layer/electron blocking layer structure, which are sequentially stacked in this stated order from the first electrode 110.

When the hole transport region 120 includes a hole injection layer, the hole injection layer may be formed on the first electrode 110 by using one or more suitable methods, for example, a vacuum deposition method, a spin coating method, a casting method, a Langmuir-Blodgett (LB) method, and/or an ink-jet printing method.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100 °C to about 500 °C, a vacuum pressure of about 10⁻⁸ torr to about 10⁻³ torr, and a deposition rate of about 0.01 Å/sec to about 100 Å/sec.

When the hole injection layer is formed by spin coating, the coating conditions may vary depending on a material for forming the hole injection layer, and the structure and thermal characteristics of the hole injection layer. For example, the coating conditions may include a coating speed of about 2,000 rpm to about 5,000 rpm and a heat treatment temperature of about 80 °C to about 200 °C for removing a solvent after coating.

Conditions for forming a hole transport layer and an electron blocking layer may be understood by referring to conditions for forming the hole injection layer.

The hole transport region 120 may include, for example, m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or any combination thereof:

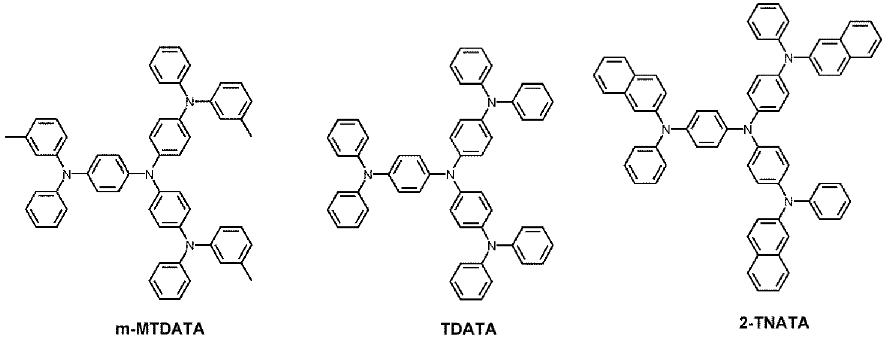

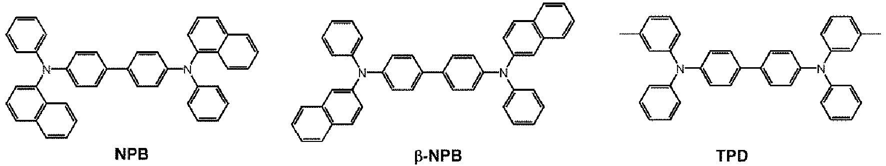

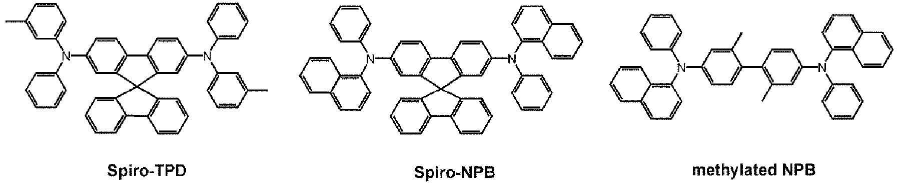

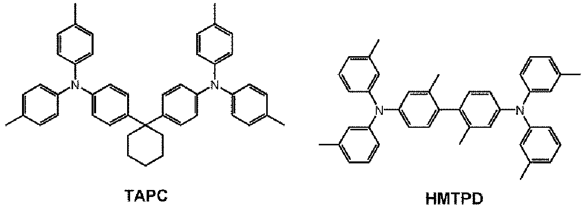

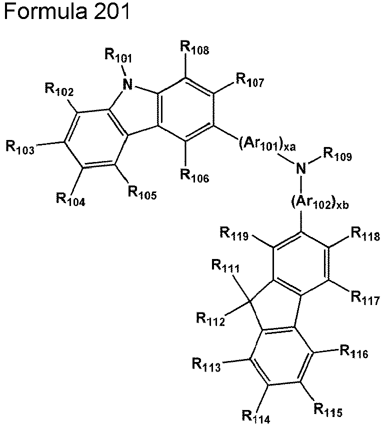

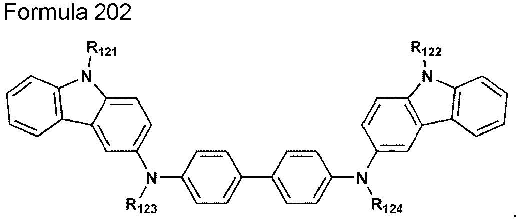

In Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arythio group, a C₁-C₆₀ heteroaryl group, a monovalent non-aromatic condensed polycyclic group, a monovalent non-aromatic condensed heteropolycyclic group, or any combination thereof.

In Formula 201, xa and xb may each independently be an integer from 0 to 5, or 0, 1, or 2. For example, xa may be 1 and xb may be 0.

R₁₀₁ to R₁₀₈, R₁₁₁ to R₁₁₉, and R₁₂₁ to R₁₂₄ in Formulae 201 and 202 may each independently be:
hydrogen, deuterium, -F, -Cl, -Br, -I, a hydroxyl group, a cyano group, a nitro group, an amino group, a C₁-C₁₀ alkyl group (for example, a methyl group, an ethyl group, a propyl group, a butyl group, a pentyl group, a hexyl group, or the like), or a C₁-C₁₀ alkoxy group (for example, a methoxy group, an ethoxy group, a propoxy group, a butoxy group, a pentoxy group, or the like);
a C₁-C₁₀ alkyl group or a C₁-C₁₀ alkoxy group, each unsubstituted or substituted with deuterium, -F, -Cl, -Br, -I, a hydroxyl group, a cyano group, a nitro group, an amino group, or any combination thereof; or
a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, a C₁-C₁₀ alkyl group, a C₁-C₁₀ alkoxy group, or any combination thereof.

In Formula 201, R₁₀₉ may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, a C₁-C₂₀ alkyl group, a C₁-C₂₀ alkoxy group, a phenyl group, a naphthyl group, an anthracenyl group, a pyridinyl group, or any combination thereof.

In an embodiment, the compound represented by Formula 201 may be represented by Formula 201A: 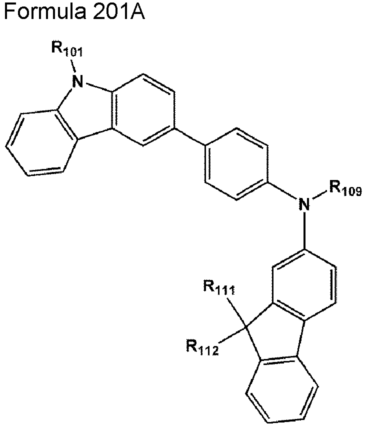 wherein, in Formula 201A, R₁₀₁, R₁₁₁, R₁₁₂, and R₁₀₉ may be understood by referring to the description provided herein.

For example, the hole transport region 120 may include one of Compounds HT1 to HT20 or any combination thereof:

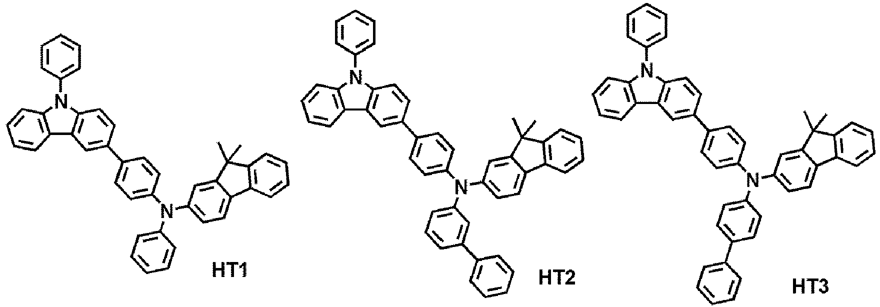

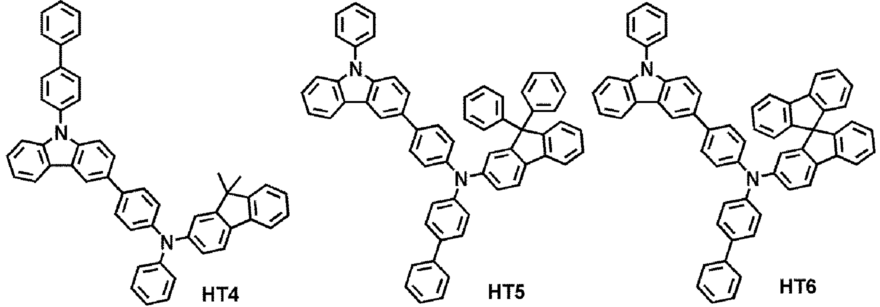

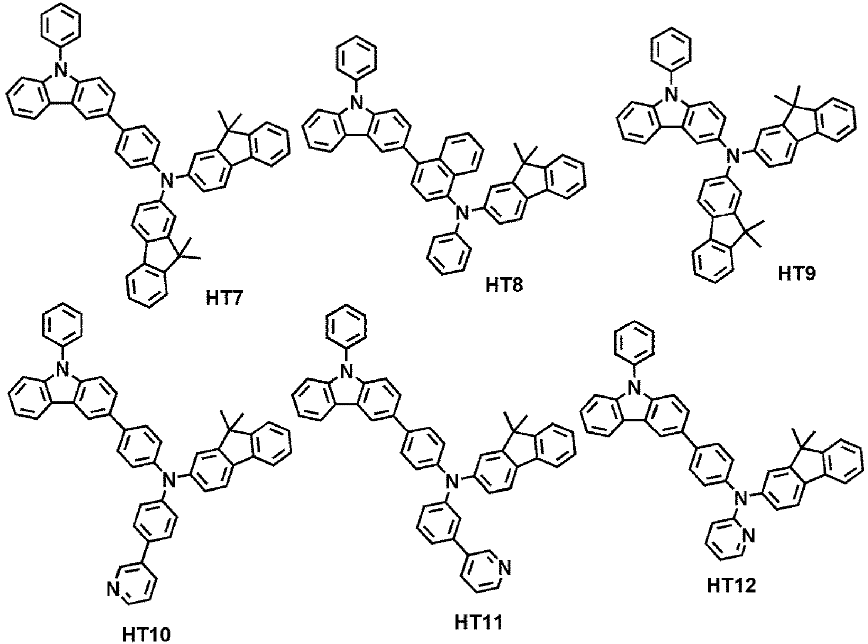

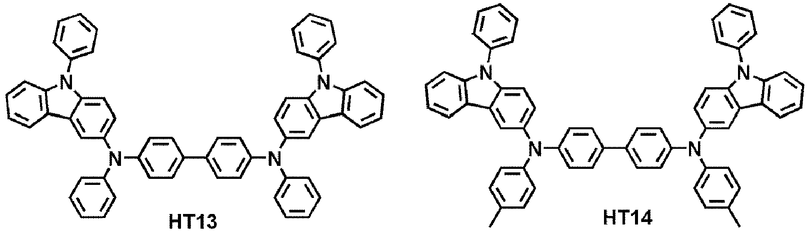

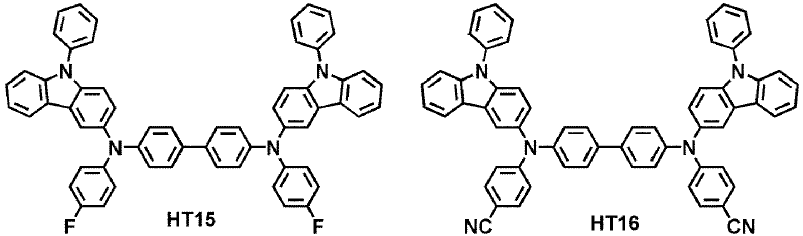

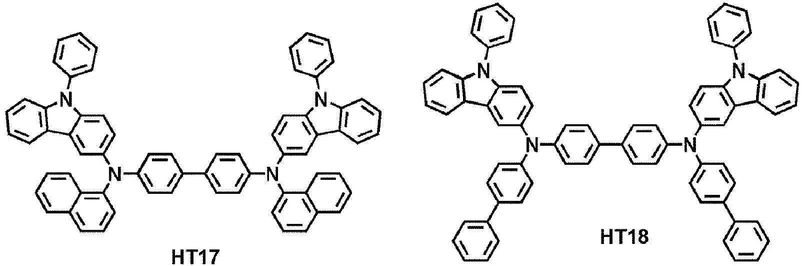

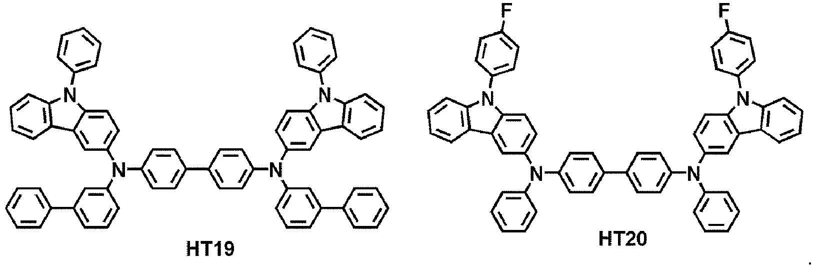

A thickness of the hole transport region 120 may be about 100 Å to about 10,000 Å, for example, about 100 Å to about 1,000 Å. When the hole transport region 120 includes a hole injection layer, a hole transport layer, an electron blocking layer, or a combination thereof, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. When the thicknesses of the hole transport region 120, the hole injection layer, and the hole transport layer are within these ranges as described above, satisfactory hole transporting characteristics may be obtained without a substantial increase in driving voltage.

In addition to the above-described materials, the hole transport region 120 may further include a charge-generation material to improve conductivity. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or any combination thereof. For example, the p-dopant may be: a quinone derivative such as tetracyanoquinonedimethane (TCNQ), 2,3,5,6-tetrafluoro-tetracyano-1,4-benzoquinonedimethane (F4-TCNQ), or F6-TCNNQ; metal oxide, such as tungsten oxide and molybdenum oxide; a cyano group-containing compound, such as Compound HT-D1; or any combination thereof.

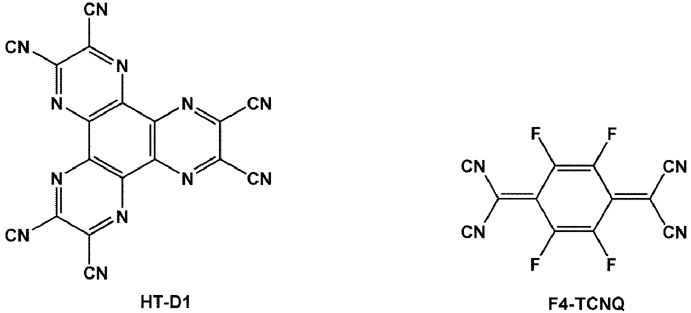

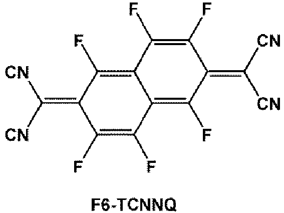

The hole transport region 120 may further include a buffer layer.

The buffer layer may compensate for an optical resonance distance according to a wavelength of light emitted from the emission layer, and thus, efficiency may be increased.

Meanwhile, when the hole transport region 120 includes an electron blocking layer, the material for the electron blocking layer may include a material that may be used in the hole transport region 120 as described above, a host material, or any combination thereof. For example, when a hole transport region includes an electron blocking layer, mCP or Compound HTH1 may be used as a material for the electron blocking layer.

The emission layer 150 may be formed on the hole transport region 120 by using, for example, a vacuum deposition method, a spin coating method, a cast ingmethod, an LB method, and/or an ink-jet printing method. When the emission layer 150 is formed by vacuum deposition or spin coating, the deposition or coating conditions may be similar to those applied in forming the hole injection layer although the deposition or coating conditions may vary depending on a material that is used to form the emission layer.

The emission layer 150 is the same as described in the present specification.

A thickness of the emission layer 150 may be about 100 Å to about 1,000 Å, for example, about 200 Å to about 600 Å. When the thickness of the emission layer 150 is within the range as described above, excellent light-emission characteristics may be obtained without a substantial increase in driving voltage.

When the light-emitting device is a full-color light-emitting device, the emission layer 150 may be patterned into a red emission layer, a green emission layer, and/or a blue emission layer.

Next, the electron transport region 170 may be arranged on the emission layer 150.

The electron transport region 170 may include a hole blocking layer, an electron transport layer, an electron injection layer, or any combination thereof.

For example, the electron transport region 170 may have a hole blocking layer/electron transport layer/electron injection layer structure, a hole blocking layer/electron transport layer structure, or an electron transport layer/electron injection layer structure. The electron transport layer may have a single-layered structure or a multilayer structure including two or more different materials.

The conditions for the forming the hole blocking layer, the electron transport layer, and the electron injection layer in the electron transport region 170 are the same as the conditions for the forming the hole injection layer.

When the electron transport region 170 includes a hole blocking layer, the hole blocking layer may include, for example, BCP, Bphen, BAlq, or any combination thereof:

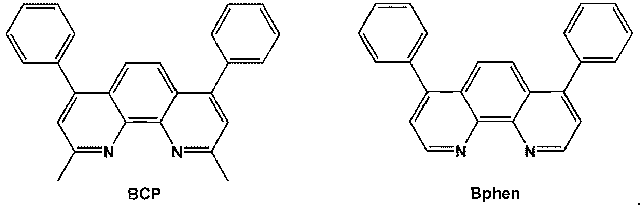

In an embodiment, the hole blocking layer may include any host material, a material for an electron transport layer, a material for an electron injection layer, or a combination thereof, which will be described later.

A thickness of the hole blocking layer may be about 20 Å to about 1,000 Å, for example, about 30 Å to about 600 Å. When the thickness of the hole blocking layer is within the range as described above, excellent hole blocking characteristics may be obtained without a substantial increase in driving voltage.

The electron transport layer may include BCP, Bphen, TPBi, Alq₃, BAlq, TAZ, NTAZ, or any combination thereof:

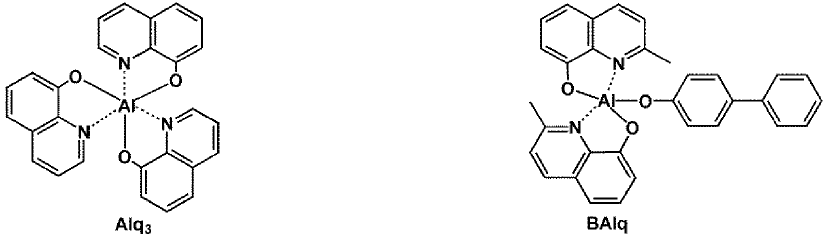

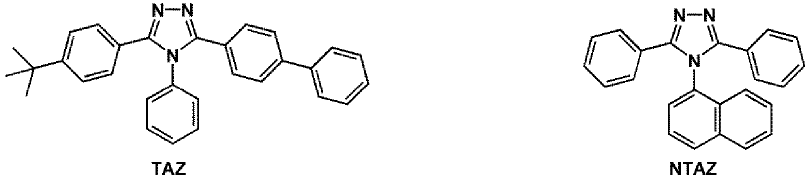

In an embodiment, the electron transport layer may include one of Compounds ET1 to ET25 or any combination thereof:

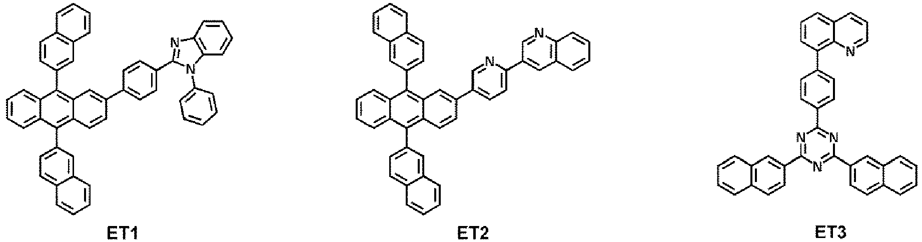

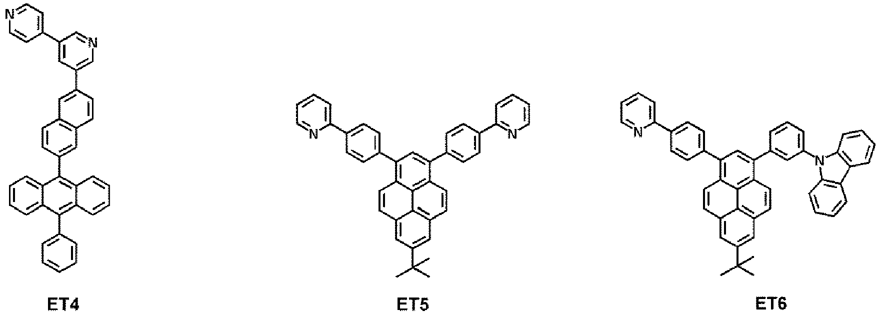

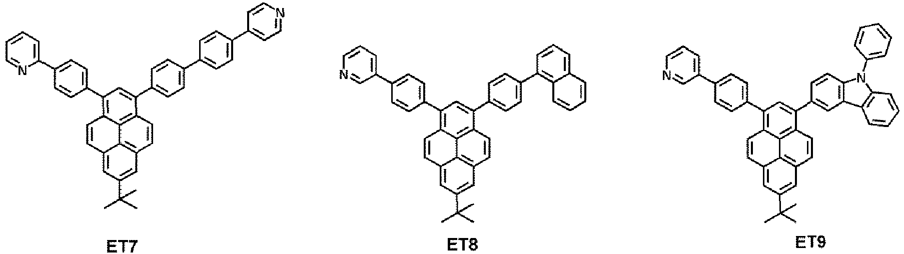

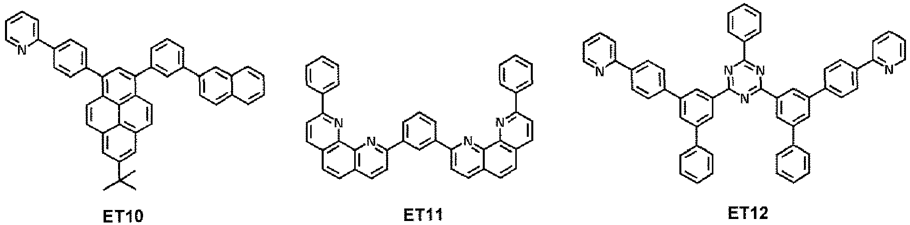

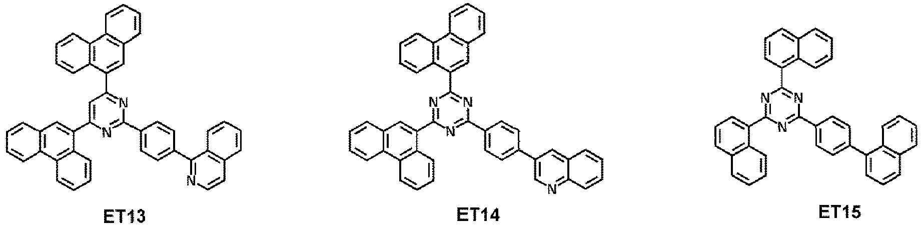

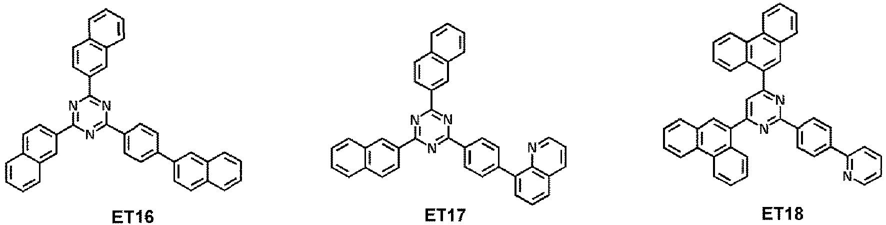

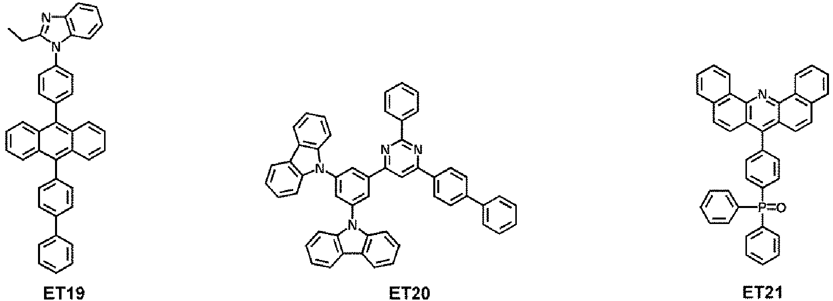

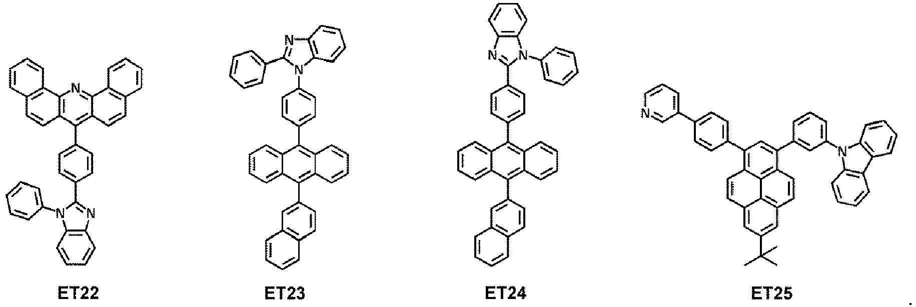

A thickness of the electron transport layer may be in a range of about 100 Å to about 1,000 Å, for example, about 150 Å to about 500 Å. When the thickness of the electron transport layer is within the range as described above, satisfactory electron transport characteristics may be obtained without a substantial increase in driving voltage.

Also, the electron transport layer may further include, in addition to the materials described above, a metal-containing material.

The metal-containing material may include a Li complex. The Li complex may include, for example, Compound ET-D1 or ET-D2.

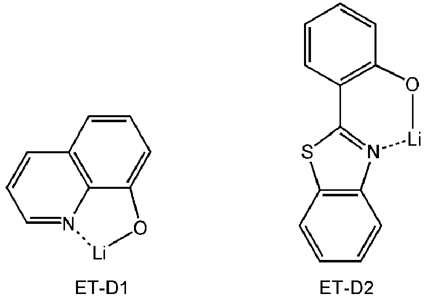

In addition, the electron transport region 170 may include an electron injection layer that facilitates injection of electrons from the second electrode 190.

The electron injection layer may include LiF, NaCl, CsF, Li₂O, BaO, Yb, Compound ET-D1, Compound ET-D2, or any combination thereof.

A thickness of the electron injection layer may be about 1 Å to about 100 Å, for example, about 3 Å to about 90 Å. When the thickness of the electron injection layer is within the range described above, satisfactory electron injection characteristics may be obtained without a substantial increase in driving voltage.

The second electrode 190 may be arranged on the electron transport region 170. The second electrode 190 may be a cathode. A material for forming the second electrode 190 may be metal, an alloy, an electrically conductive compound, or any combination thereof, which have a relatively low work function. For example, lithium (Li), magnesium (Mg), aluminum (Al), silver (Ag), aluminum-lithium (Al-Li), calcium (Ca), magnesium-indium (Mg-In), magnesium-silver (Mg-Ag), or the like may be used as the material for forming the second electrode 190. In an embodiment, to manufacture a top-emission type light-emitting device, a transparent or semi-transparent electrode formed using ITO or IZO may be used as the second electrode 190, and various modifications may be made.

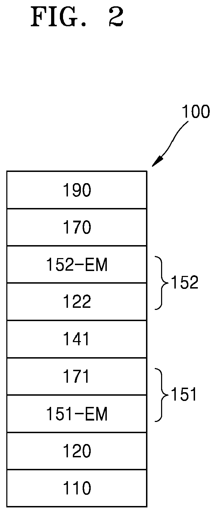

FIG. 2 is a schematic view of a light-emitting device 100 according to an embodiment. The light-emitting device 100 of FIG. 2 may include a first electrode 110, a second electrode 190 facing the first electrode 110, and a first light-emitting unit 151 and a second light-emitting unit 152 which are stacked between the first electrode 110 and the second electrode 190. A charge generation layer 141 is arranged between the first light-emitting unit 151 and the second light-emitting unit 152. The charge generation layer 141 may include an n-type charge generation layer, a p-type charge generation layer, or a combination thereof. The charge generation layer 141 is a layer that generates charge and supplies the charge to neighboring light-emitting units, and any known material may be used therefor.

The first light-emitting unit 151 may include an emission layer 1 151-EM, and the second light-emitting unit 152 may include an emission layer 2 152-EM.

In an embodiment, the emission layer 1 151-EM may include the emission layer as described in the present specification.

In an embodiment, the emission layer 2 152-EM may include the emission layer as described in the present specification.

A hole transport region 120 is arranged between the first light-emitting unit 151 and the first electrode 110, and the second light-emitting unit 152 includes a second hole transport region 122 arranged on the side of the first electrode 110.

An electron transport region 170 may be arranged between the second light-emitting unit 152 and the second electrode 190, and the first light-emitting unit 151 may include a first electron transport region 171 arranged between the charge generation layer 141 and the emission layer 1 151-EM.

The first electrode 110 and the second electrode 190 illustrated in FIG. 2 are the same as described in connection with the first electrode 110 and the second electrode 190 illustrated in FIG. 1, respectively.

The hole transport region 120 and the second hole transport region 122 illustrated in FIG. 2 are each the same as described in connection with the hole transport region 120 illustrated in FIG. 1.

The electron transport region 170 and the first electron transport region 171 illustrated in FIG. 2 are each the same as described in connection with the electron transport region 170 illustrated in FIG. 1.

Hereinbefore, an example of a tandem light-emitting device has been described with reference to FIG. 2. However, the tandem light-emitting device may have various other forms. For example, the tandem light-emitting device may include three or more light-emitting units.

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or any combination thereof. For example, Formula 9-33 is a branched C₆ alkyl group, for example, a tert-butyl group that is substituted with two methyl groups.

The term "C₁-C₆₀ alkoxy group" used herein refers to a monovalent group represented by -OA₁₀₁ (wherein A₁₀₁ is the C₁-C₆₀ alkyl group), and examples thereof are a methoxy group, an ethoxy group, a propoxy group, a butoxy group, or a pentoxy group.

The term "C₁-C₆₀ alkylthio group" as used herein refers to a monovalent group represented by -SA₁₀₁ (wherein A₁₀₁ is the C₁-C₆₀ alkyl group).

The term "C₂-C₆₀ alkenyl group" as used herein has a structure including at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein has a structure including at least one carbon-carbon triple bond in the middle or at the terminus of the C₂-C₆₀ alkyl group, and examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the C₃-C₁₀ cycloalkylene group is a divalent group having the same structure as the C₃-C₁₀ cycloalkyl group.

Examples of the C₃-C₁₀ cycloalkyl group are a cyclopropyl group, a cyclobutyl group, a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monovalent saturated cyclic group that includes at least one hetero atom selected from N, O, P, Si, S, Se, Ge, and B as a ring-forming atom and 1 to 10 carbon atoms, and the term "C₁-C₁₀ heterocycloalkylene group" as used herein refers to a divalent group having the same structure as the C₁-C₁₀ heterocycloalkyl group.

Examples of the C₁-C₁₀ heterocycloalkyl group may include a silolanyl group, a silinanyl group, a tetrahydrofuranyl group, a tetrahydro-2H-pyranyl group, and a tetrahydrothiophenyl group.

The term "C₃-C₁₀ cycloalkenyl group" as used herein refers to a monovalent monocyclic group that has 3 to 10 carbon atoms, at least one carbon-carbon double bond in the ring thereof, and no aromaticity, and examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, Ge, and B as a ring-forming atom, 1 to 10 carbon atoms, and at least one double bond in its ring. Examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the two or more rings may be fused to each other.

The "C₇-C₆₀ alkylaryl group" as used herein refers to a C₆-C₆₀ aryl group that is substituted with at least one C₁-C₆₀ alkyl group.

The term "C₁-C₆₀ heteroaryl group" as used herein refers to a monovalent group having a cyclic aromatic system having at least one hetero atom selected from N, O, P, Si, S, Se, Ge, and B as a ring-forming atom and 1 to 60 carbon atoms, and the term "C₁-C₆₀ heteroarylene group" as used herein refers to a divalent group having a cyclic aromatic system having at least one hetero atom selected from N, O, P, Si, S, Se, Ge, and B as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the two or more rings may be fused to each other.

The "C₂-C₆₀ alkylheteroaryl group" as used herein refers to a C₁-C₆₀ heteroaryl group that is substituted with at least one C₁-C₆₀ alkyl group.

The term "C₆-C₆₀ aryloxy group" as used herein indicates -OA₁₀₂ (wherein A₁₀₂ indicates the C₆-C₆₀ aryl group), the C₆-C₆₀ arylthio group indicates -SA₁₀₃ (wherein A₁₀₃ indicates the C₆-C₆₀ aryl group), and the C₁-C₆₀ alkylthio group indicates -SA₁₀₄ (wherein A₁₀₄ indicates the C₁-C₆₀ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its molecular structure when considered as a whole. Examples of the monovalent non-aromatic condensed polycyclic group include a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group having two or more rings condensed to each other, at least one hetero atom selected from N, O, P, Si, S, Se, Ge, and B, other than carbon atoms (for example, having 1 to 60 carbon atoms), as a ring-forming atom, and no aromaticity in its molecular structure when considered as a whole. The monovalent non-aromatic condensed heteropolycyclic group includes a carbazolyl group. The term "divalent non-aromatic condensed heteropolycyclic group" as used herein refers to a divalent group having the same structure as a monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Examples of the "C₅-C₃₀ carbocyclic group (that is unsubstituted or substituted with at least one R₁₀ₐ)" used herein are an adamantane group, a norbornene group, a bicyclo[1.1.1]pentane group, a bicyclo[2.1.1]hexane group, a bicyclo[2.2.1]heptane group (norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group, (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The C₁-C₃₀ heterocyclic group may be a monocyclic group or a polycyclic group. The "C₁-C₃₀ heterocyclic group (unsubstituted or substituted with at least one R₁₀ₐ)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one R₁₀ₐ).

Examples of the "C₅-C₃₀ carbocyclic group" and "C₁-C₃₀ heterocyclic group" as used herein are i) a first ring, ii) a second ring, iii) a condensed ring in which two or more first rings are condensed with each other, iv) a condensed ring in which two or more second rings are condensed with each other, or v) a condensed ring in which at least one first ring is condensed with at least one second ring,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group", and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (that is, a fluorinated methyl group)" includes -CF₃, -CF₂H, and -CFH₂. The "fluorinated C₁-C₆₀ alkyl group (or, a fluorinated C₁-C₂₀ alkyl group, or the like)", "fluorinated C₃-C₁₀ cycloalkyl group", "fluorinated C₁-C₁₀ heterocycloalkyl group", or "fluorinated phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen included therein is not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group", and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include -CD₃, -CD₂H, and -CDH₂, and examples of the "deuterated C₃-C₁₀ cycloalkyl group" are, for example, Formula 10-501 and the like. The "deuterated C₁-C₆₀ alkyl group (or, the deuterated C₁-C₂₀ alkyl group or the like)", "deuterated C₃-C₁₀ cycloalkyl group", "deuterated C₁-C₁₀ heterocycloalkyl group", or "deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein is substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein is not substituted with deuterium.

The term "(C₁-C₂₀ alkyl) 'X' group" as used herein refers to an 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group that is substituted with at least one C₁-C₂₀ alkyl group, and the term "(C₁-C₂₀ alkyl)phenyl group" as used herein refers to a phenyl group that is substituted with at least one C₁-C₂₀ alkyl group. Examples of a (C₁ alkyl)phenyl group include a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon atom selected from ring-forming carbon atoms is substituted with nitrogen.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkylaryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group may be:
deuterium, -F, -Cl, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), - P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), -P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or any combination thereof.
Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, or a monovalent non-aromatic condensed heteropolycyclic group, each unsubstituted or substituted with deuterium, a C₁-C₆₀ alkyl group, a C₆-C₆₀ aryl group, or any combination thereof.

For example, Q₁ to Q₉, Q₁₁ to Q₁₉, Q₂₁ to Q₂₉, and Q₃₁ to Q₃₉ described herein may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

Hereinafter, a light-emitting device according to an embodiment is described in detail with reference to Examples. However, the disclosure is not limited to the following Examples.

### Examples

### Evaluation Example 1

DFT calculation using a Gaussian 16 program was performed by optimizing a molecular structure of each of Compounds S-1, S-2, S-A, S-B, and S-C by using B3LYP/LanL2DZ function with respect to a metal included in each of Compounds S-1, S-2, S-A, S-B, and S-C and using B3LYP/6-31G(D,P) function with respect to an organic ligand included in each of Compounds S-1, S-2, S-A, S-B, and S-C, to calculate a permanent dipole moment, singlet energy, and triplet energy of each of Compounds S-1, S-2, S-A, S-B, and S-C. Results are shown in Table 1. Also, DFT calculation using a Gaussian 16 program was performed by optimizing a molecular structure of each of Compounds HTH1, ETH1, HTH2, ETH2, and TBADN by using B3LYP/6-31G(D,P) function, to calculate each of permanent dipole moment, singlet energy, and/or triplet energy of each of Compounds HTH1, ETH1, HTH2, ETH2, and TBADN. Results are shown in Table 1.

**Table 1**

| Compound | Permanent dipole moment (debye) | Singlet (S₁) energy (eV) | Triplet (T₁) energy (eV) |
|---|---|---|---|
| S-1 (Compound 4 of Group 1-2) | 1.56 | 2.4706 | 2.339 |
| S-2 (Compound 24 of Group 1-2) | 1.76 | 2.4425 | 2.311 |
| S-A | 12.5899 | 2.8612 | 2.553 |
| S-B | 6.332 | 2.8198 | 2.643 |
| S-C | 7.7357 | 2.8673 | 2.487 |
| FE1 (Compound 2 of Group 3) | 1.792 | 2.6374 | 2.2337 |
| HTH1 | 0.753 | 3.522 | 2.887 |
| ETH1 | 2.0813 | 3.011 | 2.741 |
| HTH2 | 0.6285 | 3.539 | 3.009 |
| ETH2 | 2.3079 | 2.767 | 2.703 |
| TBADN | 0.523 | - | - |

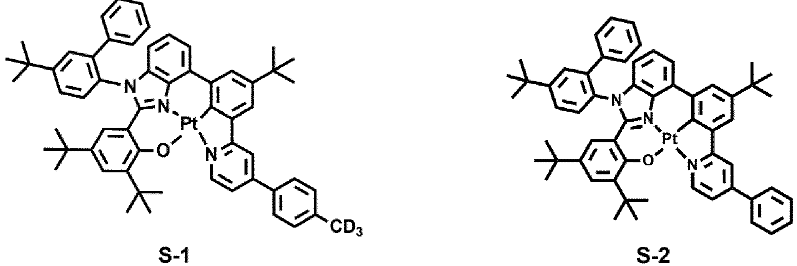

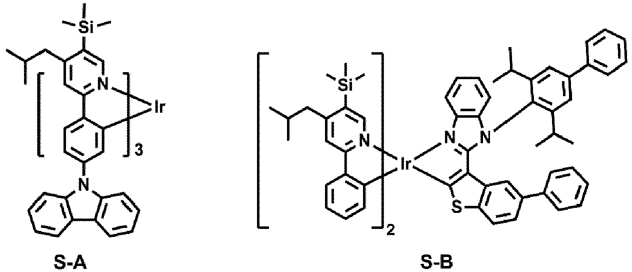

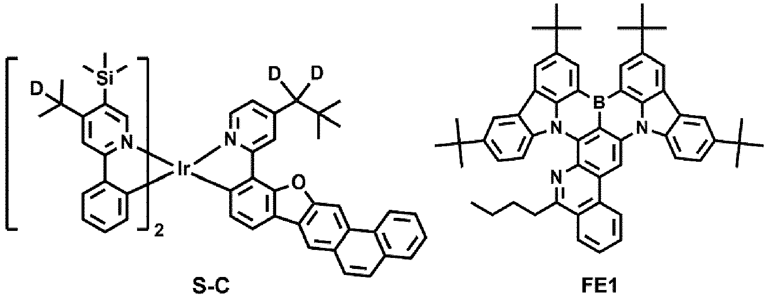

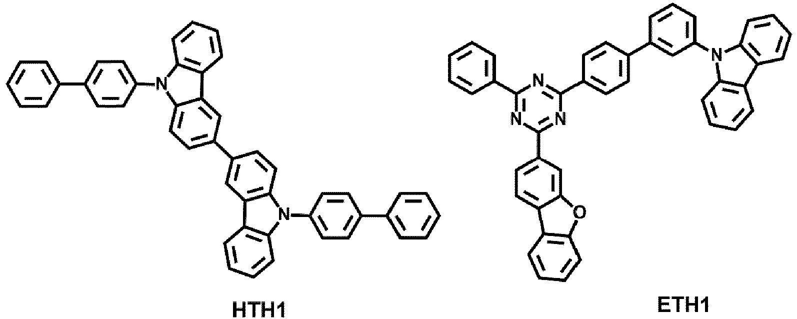

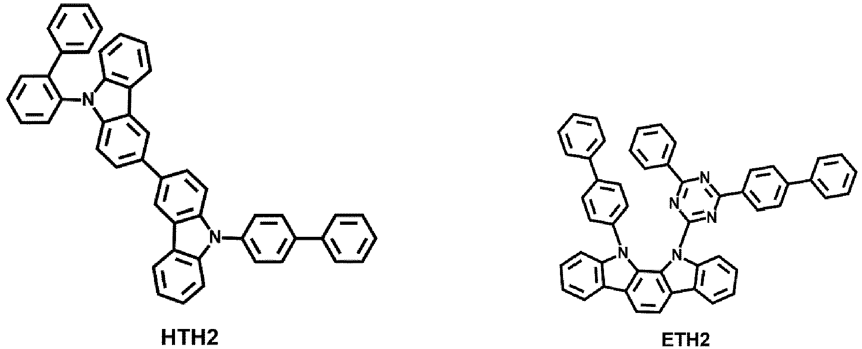

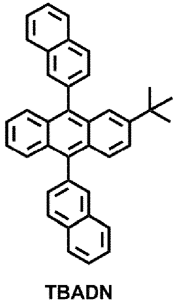

### Evaluation Example 2

Compounds shown in Table 2 were vacuum-codeposited on a quartz substrate at a vacuum degree of 10⁻⁷ torr in a weight ratio shown in Table 2 to prepare Films S-1, S-2, S-A, S-B, S-C, and FE1, each having a thickness of 40 nm.

Next, a photoluminescence spectrum of each of Films S-1, S-2, S-A, S-B, S-C, and FE1 was measured by using a Quantaurus-QY Absolute PL quantum yield spectrometer of Hamamatsu Inc. (equipped with a xenon light source, a monochromator, a photonic multichannel analyzer, and an integrating sphere, and using PLQY measurement software (Hamamatsu Photonics, Ltd., Shizuoka, Japan)). During the measurement, an excitation wavelength was scanned from 320 nm to 380 nm at 10 nm intervals, and a spectrum measured at the excitation wavelength of 320 nm was taken. From the photoluminescence spectrum of each of Films S-1, S-2, S-A, S-B, S-C, and FE1, a full width at half maximum and maximum emission peak wavelength of each of Compounds S-1, S-2, S-A, S-B, S-C, and FE1 were determined and results are shown in Table 2.

**Table 2**

| Film No. | Film composition (weight ratio) | FWHM (nm) | Maximum emission peak wavelength (nm) |
|---|---|---|---|
| S-1 | HTH1 : ETH1 : S-1 (71:24:5) | 61.2 | 522 |
| S-2 | HTH1:ETH1:S-2 (71:24:5) | 63.9 | 527 |
| S-A | HTH1:ETH1:S-A (71:24:5) | 53.8 | 512 |
| S-B | HTH1:ETH1:S-B (71:24:5) | 63 | 522 |
| S-C | HTH1:ETH1:S-C (71:24:5) | 32.9 | 526 |
| FE1 | TBADN:FE1 (97:3) | 32.4 | 529 |

From Table 2, emission characteristics of each of Compounds S-1, S-2, S-A, S-B, S-C, and FE1 could be confirmed.

### Evaluation Example 3

Compounds shown in Table 3 were vacuum-codeposited on a quartz substrate at a vacuum degree of 10⁻⁷ torr in a weight ratio shown in Table 3 to prepare Films S-1_FE1, S-2_FE1, S-A_FE1, S-B_FE1, and S-C_FE1, each having a thickness of 40 nm.

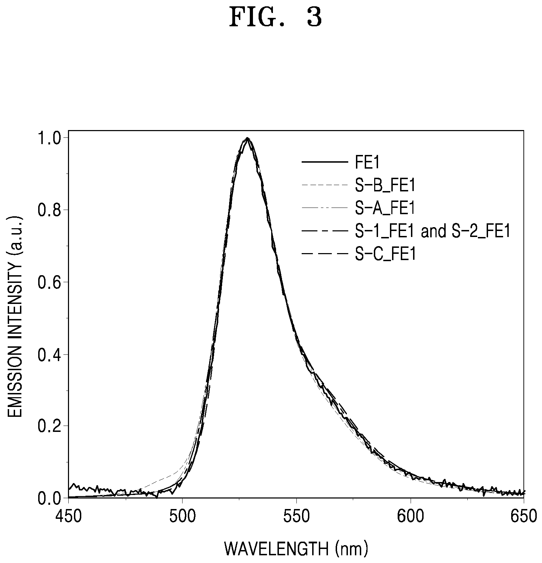

Next, a photoluminescence spectrum of each of Films S-1_FE1, S-2_FE1, S-A_FE1, S-B_FE1, and S-C_FE1 was evaluated by using the same method as that used in Evaluation Example 2, and from the photoluminescence spectrum of each of Films S-1_FE1, S-2_FE1, S-A_FE1, S-B_FE1, and S-C_FE1, a full width at half maximum and maximum emission peak wavelength of each of a combination of S-1 and FE1, a combination of S-2 and FE1, a combination of S-A and FE1, a combination of S-B and FE1, and a combination of S-C and FE1 were determined. Results are shown in Table 3. The photoluminescence spectrum of each of Films S-1_FE1, S-2_FE1, S-A_FE1, S-B_FE1, and S-C_FE1 are as shown in FIG. 3. For comparison, the photoluminescence spectrum of Film FE1 prepared in Evaluation Example 2 is also shown in FIG. 3.

Afterwards, PL spectrum of each of Films S-1_FE1, S-2_FE1, S-A_FE1, S-B_FE1, and S-C_FE1 was evaluated at room temperature by using a TRPL measurement system, FluoTime 300, of PicoQuant and a pumping source, PLS340, of PicoQuant (excitation wavelength = 340 nm, spectral width = 20 nm), and then a wavelength of a main peak of the spectrum was determined. PLS340 repeated the measurement of the number of photons emitted from each Film at the wavelength of the main peak by a photon pulse (pulse width = 500 picoseconds) applied to each Film according to the time, based on time-correlated single photon counting (TCSPC), to obtain a sufficiently fittable TRPL curve. T_{decay}(Ex), that is, decay time, of each of Films S-1_FE1, S-2_FE1, S-A_FE1, S-B_FE1, and S-C_FE1 was obtained by fitting two or more exponential decay functions to the results obtained and the results are shown in Table 3. A function for fitting of the data is shown in Equation 100, and from the T_{decay} values obtained from each exponential decay function used for fitting, the largest T_{decay} was obtained as T_{decay}(Ex). In this regard, the same measurement was performed during the same measurement time as that for obtaining TRPL curve in the dark state (in which pumping signals entering a certain film are blocked) to obtain a baseline or a background signal curve for use as a baseline for fitting. $f \left(t\right) = {\sum }_{i = 1}^{n} {A}_{i} exp \left(-t/{T}_{decay , i}\right)$ Equation 100

**Table 3**

| Film No. | Film composition (weight ratio) | FWHM (nm) | Maximum emission peak wavelength (nm) | Decay time (ns) |
|---|---|---|---|---|
| S-1_FE1 | HTH1:ETH1:S-1:FE1 (70.5:23.5:5:1) | 33.4 | 529 | 168 |
| S-2_FE1 | HTH1:ETH1:S-2:FE1 (70.5:23.5:5:1) | 33.3 | 529 | 169 |
| S-A_FE1 | HTH1:ETH1:S-A:FE1 (70.5:23.5:5:1) | 33.2 | 529 | 250 |
| S-B_FE1 | HTH1:ETH1:S-B:FE1 (70.5:23.5:5:1) | 32.5 | 529 | 129 |
| S-C_FE1 | HTH1:ETH1:S-C:FE1 (70.5:23.5:5:1) | 32 | 529 | 378 |

From Table 3 and FIG. 3,
1) it could be confirmed that in Films S-1_FE1, S-2_FE1, S-A_FE1, and S-C_FE1, the Compound FE1 is a relatively strong emitter of light, and each of Compounds S-1, S-2, S-A, and S-C are relatively poor emitters (photoluminescence spectra of Films S-1_FE1, S-2_FE1, S-A_FE1, and S-C_FE1 in FIG. 3 are substantially identical to each other, and thus, are not clearly distinguished),
2) it could be confirmed that Film S-1_FE1 and Film S-2_FE1 had smaller decay times than those of Film S-A_FE1 and Film S-C_FE1, respectively, and thus, a rate of energy transfer from Compound S-1 to FE1, and a rate of energy transfer from Compound S-2 to FE1, were greater than a rate of energy transfer from Compound S-A to FE1 and a rate of energy transfer from Compound S-C to FE1, respectively, and
3) it could be confirmed that although Film S-B_FE1 had smaller decay time than those of Films S-1_FE1 and S-2_FE1, complete energy transfer from Compound S-B to FE1 was not achieved, and thus, some luminescence also occurred in Compound S-B (see the photoluminescence spectrum of Film S-B_FE1 in FIG. 3).

### Manufacture of OLED 1

As an anode, a glass substrate with ITO deposited thereon to a thickness of 1,500 Å was cut to a size of 50 mm x 50 mm x 0.5 mm, sonicated with isopropyl alcohol and pure water each for 5 minutes, and then cleaned by irradiation of ultraviolet rays and exposure of ozone thereto for 30 minutes. Then, the resultant glass substrate was loaded onto a vacuum deposition apparatus.

HT3 and F6-TCNNQ were co-deposited on the anode in a weight ratio of 98:2 to form a hole injection layer (HIL) having a thickness of 10 nm, HT3 was deposited on the hole injection layer to form a hole transport layer (HTL) having a thickness of 150 nm, and HTH1 was vacuum-deposited on the hole transport layer to form an electron blocking layer (EBL) having a thickness of 5 nm.

Next, hosts (HTH1 and ETH1), a sensitizer (S-1), and a fluorescent emitter (FE1) were co-deposited on the electron blocking layer in a weight ratio of 89:10:1 to form an emission layer having a thickness of 40 nm. In this regard, a weight ratio of HTH1 to ETH1 was adjusted to 75:25, and PDM(H) was calculated as "(0.753 debye x 0.75) + (2.0813 debye x 0.25) = 0.56475 debye + 0.520325 debye = 1.085075 debye".

Next, ET3 was vacuum-deposited on the emission layer to form a hole blocking layer (HBL) having a thickness of 5 nm, ET3 and ET-D1 were co-deposited on the hole blocking layer in a volume ratio of 50:50 to form an electron transport layer (ETL) having a thickness of 31 nm, and Al was deposited on the electron transport layer to form a cathode having a thickness of 100 nm, thereby completing the manufacture of a light-emitting device.

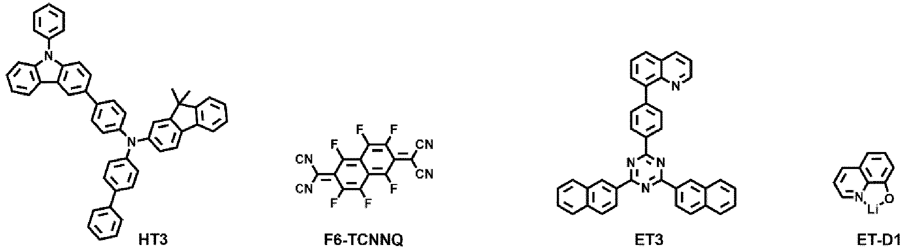

### Manufacture of OLED A, OLED B, and OLED C

OLED A, OLED B, and OLED C were manufactured in the same manner as used to manufacture OLED 1, except that, a compound shown in Table 4 (S-A, S-B, or S-C) was used instead of Compound S-1, respectively, as the sensitizer in the emission layer.

### Manufacture of OLED D

OLED D was manufactured in the same manner as used to manufacture OLED 1, except that, in forming the emission layer, a host (TBADN) and a fluorescent emitter (FE1) were co-deposited on the electron blocking layer in a weight ratio of 97:3 to form an emission layer having a thickness of 40 nm.

Compositions of the emission layers of OLEDs 1 and A to D are the same as described in Table 4.

**Table 4**

| Device No. | Host | | Sensitizer | | \|PDM(S) - PDM(H)\| | Fluorescent emitter |
|---|---|---|---|---|---|---|
| | Composition | PDM(H) (debye) | Compound | PDM(S) (debye) | | |
| OLED 1 | HTH1:ETH1 (89 wt%) | 1.085075 | S-1 (10 wt%) | 1.56 | 0.474925 | FE1 (1 wt%) |
| OLED A | HTH1:ETH1 (89 wt%) | 1.085075 | S-A (10 wt%) | 12.5899 | 11.504825 | FE1 (1 wt%) |
| OLED B | HTH1:ETH1 (89 wt%) | 1.085075 | S-B (10 wt%) | 6.332 | 5.246925 | FE1 (1 wt%) |
| OLED C | HTH1:ETH1 (89 wt%) | 1.085075 | S-C (10 wt%) | 7.7357 | 6.650625 | FE1 (1 wt%) |
| OLED D | TBADN (97 wt%) | 0.523 | - | - | - | FE1 (3 wt%) |

### Evaluation Example 4

External quantum efficiency (%), driving voltage (V), and roll-off ratio (%) of OLEDs 1 and A to D were evaluated, and the results are shown in Table 5. A current-voltmeter (Keithley 2400) and a luminance meter (Topcon SR3) were used as evaluation devices, and the roll-off ratio was calculated according to the following Equation 20: 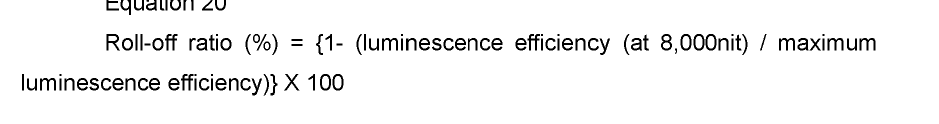 Roll-off ratio (%) = {1- (luminescence efficiency (at 8,000nit)/maximum luminescence efficiency)} × 100 Equation 20

**Table 5**

| | External quantum efficiency (EQE) (%) | Driving voltage (V) | Roll-off ratio (%) |
|---|---|---|---|
| OLED 1 | 18.4 | 4.29 | 18 |
| OLED A | 15.1 | 4.02 | 29 |
| OLED B | 17.0 | 4.36 | 27 |
| OLED C | 15.6 | 4.88 | 33 |
| OLED D | 5.78 | 6.11 | 9 |

From Table 5, it could be confirmed that
1) the external quantum efficiency of OLED 1 was greater than the external quantum efficiency of OLED D by a factor of 3, and thus, OLED 1 had far superior external quantum efficiency characteristics to those of OLED D, and
2) OLED 1 had better characteristics in terms of the external quantum efficiency, and the roll-off ratio than those of OLEDs A to C, and OLED 1 had better characteristics in terms of the driving voltage than those of OLEDs B and C.

### Manufacture of OLED 2

OLED 2 was manufactured in the same manner as used to manufacture OLED 1, except that, in forming the emission layer, hosts (HTH2 and ETH2), a sensitizer (S-2), and a fluorescent emitter (FE1) were co-deposited on the electron blocking layer in a weight ratio of 89.4:10:0.6 to form an emission layer having a thickness of 40 nm. In this regard, a weight ratio of HTH2 to ETH2 was adjusted to 65:35, and PDM(H) was calculated as "(0.6285 debye x 0.65) + (2.3079 debye x 0.35) = 0.408525 debye + 0.807765 debye = 1.21629 debye".

### Manufacture of OLED 3

OLED 3 was manufactured in the same manner as used to manufacture OLED 2, except that, in forming the emission layer, a weight ratio of the host, the sensitizer, and the fluorescent emitter was changed to 89:10:1.

**Table 6**

| Device No. | Host | | Sensitizer | | \|PDM(S) - PDM(H)\| | Fluorescent emitter |
|---|---|---|---|---|---|---|
| | Composition | PDM(H) (debye) | Compound | PDM(S) (debye) | | |
| OLED 2 | HTH2:ETH2 (89.4 wt%) | 1.21629 | S-2 (10 wt%) | 1.76 | 0.54371 | FE1 (0.6 wt%) |
| OLED 3 | HTH2:ETH2 (89 wt%) | 1.21629 | S-2 (10 wt%) | 1.76 | 0.54371 | FE1 (1 wt%) |

### Evaluation Example 5

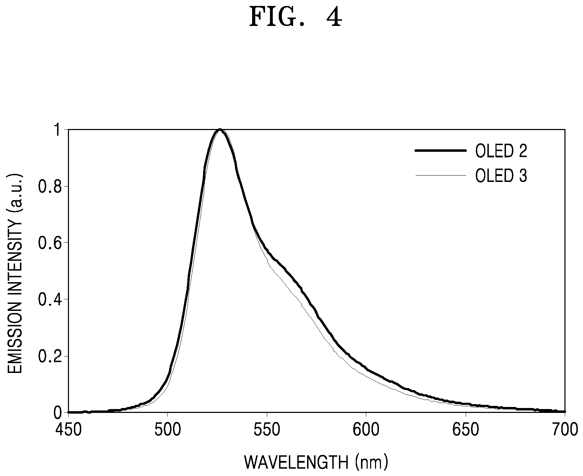

The External quantum efficiency (%), driving voltage (V), and roll-off ratio (%) of each of OLEDs 2 and 3 were evaluated by using the same method as that used in Evaluation Example 4, and results are shown in Table 7. EL spectra of OLEDs 2 and 3 are as shown in FIG. 4.

**Table 7**

| | External quantum efficiency (EQE) (%) | Driving voltage (V) | Roll-off ratio (%) |
|---|---|---|---|
| OLED 2 | 21.0 | 3.6 | 17 |
| OLED 3 | 19.3 | 3.63 | 22 |

From Table 7 and FIG. 4, it could be confirmed that OLEDs 2 and 3 had excellent characteristics in terms of external quantum efficiency, driving voltage, and roll-off ratio.

The light emitting device may have improved light emitting efficiency, lifespan, and roll-off ratio characteristics, and a high-quality electronic apparatus may be manufactured by using the light emitting device.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A light-emitting device comprising:
a first electrode (110);
a second electrode (190); and
an interlayer arranged between the first electrode (110) and the second electrode (190), wherein the interlayer comprises an emission layer (150),
the emission layer comprises m1 hosts, a sensitizer, and a fluorescent emitter,
where m1 is an integer of 1 or more, and when m1 is 2 or more, the two or more hosts are each different from the other,
the m1 hosts, the sensitizer, and the fluorescent emitter are each different from the other, **characterized in that**
Expression 1 is satisfied: $0 debye \leq \left|PDM\left(S\right)-PDM\left(H\right)\right| \leq 3 debye$ Expression 1
wherein, in Expression 1,
PDM(S) is a permanent dipole moment of the sensitizer and has a unit of debye,
PDM(H) is ${\sum }_{x = 1}^{m 1} PDM \left(Hx\right) ⋅ W \left(Hx\right)$ which is an average value of permanent dipole moments of the m1 hosts included in the emission layer, and has a unit of debye, wherein i) x is a variable of 1 to m1, ii) PDM(Hx) is a permanent dipole moment of an x^{th} host in the emission layer and has a unit of debye, and iii) W(Hx) is a weight fraction of the x^{th} host relative to a total weight of the host in the emission layer, and is calculated as (a weight of the x^{th} host in the emission layer / a total weight of the host in the emission layer), and
each of PDM(S) and PDM(H) is calculated based on density functional theory (DFT) according to the method of Evaluation Example 1.

2. The light-emitting device of claim 1, wherein PDM(S) is 0.1 debye to 3.0 debye; and/or
wherein PDM(H) is 0.01 debye to 4.00 debye.

3. The light-emitting device of claims 1 or 2, wherein Expression 2 is further satisfied: $0 eV \leq \left|{S}_{1}\left(S\right)-{T}_{1}\left(S\right)\right| \leq 0.4 eV$ Expression 2 wherein, in Expression 2,
S₁(S) is singlet energy of the sensitizer and has a unit of eV,
T₁(S) is triplet energy of the sensitizer and has a unit of eV, and
each of S₁(S) and T₁(S) is calculated based on DFT.

4. The light-emitting device of claim 3, wherein S₁(S) is 2.25 eV to 2.65 eV; and/or
wherein T₁(S) is 2.2 eV to 2.6 eV.

5. The light-emitting device of any of claims 1-4, wherein Expression 3 is further satisfied: $0 eV \leq \left|{S}_{1}\left(FE\right)-{T}_{1}\left(FE\right)\right| \leq 1.5 eV$ Expression 3 wherein, in Expression 3,
S₁(FE) is singlet energy of the fluorescent emitter and has a unit of eV,
T₁(FE) is triplet energy of the fluorescent emitter and has a unit of eV, and
each of S₁(FE) and T₁(FE) is calculated based on DFT.

6. The light-emitting device of any of claims 1-5, wherein T₁(FE) is 1.0 eV to 2.5 eV,
T₁(FE) is triplet energy of the fluorescent emitter and has a unit of eV, and
T₁(FE) is calculated based on DFT.

7. The light-emitting device of any of claims 1-6, wherein FWHM(FE) is 5 nanometers to 50 nanometers,
FWHM(FE) is a full width at half maximum at the maximum emission peak wavelength of a photoluminescence spectrum of the fluorescent emitter and has a unit of nm, and
the photoluminescence spectrum is evaluated relative to a film including the fluorescent emitter.

8. The light-emitting device of any of claims 1-7, wherein Amax(FE) is 500 nm to 550 nm,
Amax(FE) is a maximum emission peak wavelength of a photoluminescence spectrum of the fluorescent emitter and has a unit of nm, and
the photoluminescence spectrum is evaluated with respect to a film including the fluorescent emitter.

9. The light-emitting device of any of claims 1-8, wherein the m1 hosts independently comprise a hole-transporting compound, an electron-transporting compound, a bipolar compound, or any combination thereof.

10. The light-emitting device of any of claims 1-9, wherein the sensitizer comprises a platinum-containing organometallic compound,
the platinum-containing organometallic compound comprises platinum and a tetradentate ligand bonded to the platinum, and
at least one of chemical bonds between the platinum and the tetradentate ligand is a platinum-carbon chemical bond.

11. The light-emitting device of claim 10, wherein one of the chemical bonds between the platinum and the tetradentate ligand is a platinum-oxygen chemical bond; and/or
wherein the tetradentate ligand comprises one benzimidazole group.

12. The light-emitting device of any of claims 1-11, wherein the fluorescent emitter does not comprise a transition metal.

13. The light-emitting device of any of claims 1-12, wherein the fluorescent emitter is a thermally activated delayed fluorescence emitter comprising at least one 6-membered ring comprising at least one nitrogen (N) and at least one boron (B); or
wherein the fluorescent emitter is a prompt fluorescence emitter comprising at least one 5-membered ring or 6-membered ring comprising at least one boron (B).

14. The light-emitting device of any of claims 1-13, wherein the interlayer comprises:
m light-emitting units (151, 152) comprising at least one emission layer; and
m-1 charge generation layers (141) arranged between two adjacent light-emitting units among the m light-emitting units,
m is an integer of 2 or more, and
at least one light-emitting unit among the m light-emitting units comprises the emission layer as defined in claim 1;
preferably wherein the at least one light-emitting unit among the m light-emitting units emits blue light.

15. An electronic apparatus comprising the light-emitting device of any of claims 1-14.

## Patentansprüche

1. Lichtemittierende Vorrichtung, umfassend:
eine erste Elektrode (110);
eine zweite Elektrode (190); und
eine Zwischenschicht, die zwischen der ersten Elektrode (110) und der zweiten Elektrode (190) angeordnet ist, wobei die Zwischenschicht eine Emissionsschicht (150) umfasst,
die Emissionsschicht m1 Hosts, einen Sensibilisator und einen fluoreszierenden Emitter umfasst,
wobei m1 eine ganze Zahl von 1 oder mehr ist und wenn m1 2 oder mehr ist, sich die zwei oder mehr Hosts voneinander unterscheiden,
wobei sich die m1 Hosts, der Sensibilisator und der fluoreszierende Emitter jeweils voneinander unterscheiden, **dadurch gekennzeichnet, dass**
Ausdruck 1 erfüllt ist: $0 Debye \leq \left|PDM\left(S\right)-PDM\left(H\right)\right| \leq 3 Debye$ Ausdruck 1
wobei in Ausdruck 1
PDM(S) ein permanentes Dipolmoment des Sensibilisators ist und eine Einheit von Debye aufweist,
PDM(H) ${\sum }_{x = 1}^{m 1} PDM \left(Hx\right) ⋅ W \left(Hx\right)$ ist, was ein Durchschnittswert von permanenten Dipolmomenten der m1 Hosts ist, die in der Emissionsschicht enthalten sind, und eine Einheit von Debye aufweist, wobei i) x eine Variable von 1 zu m1 ist, ii) PDM(Hx) ein permanentes Dipolmoment eines x. Hosts in der Emissionsschicht ist und eine Einheit von Debye aufweist, und iii) W(Hx) ein Gewichtsanteil des x. Hosts relativ zu einem Gesamtgewicht des Hosts in der Emissionsschicht ist und als (ein Gewicht des x. Hosts in der Emissionsschicht / ein Gesamtgewicht des Hosts in der Emissionsschicht) berechnet wird, und
jedes von PDM(S) und PDM(H) basierend auf der Dichtefunktionaltheorie (DFT) gemäß dem Verfahren von Bewertungsbeispiel 1 berechnet wird.

2. Lichtemittierende Vorrichtung nach Anspruch 1, wobei PDM(S) 0,1 Debye bis 3,0 Debye ist; und/oder
wobei PDM(H) 0,01 Debye bis 4,00 Debye ist.

3. Lichtemittierende Vorrichtung nach Anspruch 1 oder 2, wobei Ausdruck 2 ferner erfüllt ist: $0 eV \leq \left|{S}_{1}\left(S\right)-{T}_{1}\left(S\right)\right| \leq 0 , 4 eV$ Ausdruck 2 wobei in Ausdruck 2
S₁(S) Singulett-Energie des Sensibilisators ist und eine Einheit von eV aufweist,
T₁(S) Triplett-Energie des Sensibilisators ist und eine Einheit von eV aufweist und jedes von S₁(S) und T₁(S) basierend auf DFT berechnet wird.

4. Lichtemittierende Vorrichtung nach Anspruch 3, wobei S₁(S) 2,25 eV bis 2,65 eV ist; und/oder
wobei T₁(S) 2,2 eV bis 2,6 eV ist.

5. Lichtemittierende Vorrichtung nach einem der Ansprüche 1-4, wobei Ausdruck 3 ferner erfüllt ist: $0 eV \leq \left|{S}_{1}\left(FE\right)-{T}_{1}\left(FE\right)\right| \leq 1 , 5 eV$ Ausdruck 3 wobei in Ausdruck 3
S₁(FE) Singulett-Energie des fluoreszierenden Emitters ist und eine Einheit von eV aufweist,
T₁(FE) Triplett-Energie des fluoreszierenden Emitters ist und eine Einheit von eV aufweist und
jedes von S₁(FE) und T₁(FE) basierend auf DFT berechnet wird.

6. Lichtemittierende Vorrichtung nach einem der Ansprüche 1-5, wobei T₁(FE) 1,0 eV bis 2,5 eV ist,
T₁(FE) Triplett-Energie des fluoreszierenden Emitters ist und eine Einheit von eV aufweist und
T₁(FE) basierend auf DFT berechnet wird.

7. Lichtemittierende Vorrichtung nach einem der Ansprüche 1-6, wobei FWHM(FE) 5 Nanometer bis 50 Nanometer ist,
FWHM(FE) eine volle Breite bei halbem Maximum bei der maximalen Emissionsspitzenwellenlänge eines Photolumineszenzspektrums des fluoreszierenden Emitters ist und eine Einheit von nm aufweist und
das Photolumineszenzspektrum relativ zu einem Film bewertet wird, der den fluoreszierenden Emitter beinhaltet.

8. Lichtemittierende Vorrichtung nach einem der Ansprüche 1-7, wobei λmax(FE) 500 nm bis 550 nm ist,
λmax(FE) eine maximale Emissionsspitzenwellenlänge eines Photolumineszenzspektrums des fluoreszierenden Emitters ist und eine Einheit von nm aufweist und
das Photolumineszenzspektrum in Bezug auf einen Film bewertet wird, der den fluoreszierenden Emitter beinhaltet.

9. Lichtemittierende Vorrichtung nach einem der Ansprüche 1-8, wobei die m1 Hosts unabhängig eine Loch-transportierende Verbindung, eine Elektronen-transportierende Verbindung, eine bipolare Verbindung oder eine beliebige Kombination davon umfassen.

10. Lichtemittierende Vorrichtung nach einem der Ansprüche 1-9, wobei der Sensibilisator eine platinhaltige organometallische Verbindung umfasst,
die platinhaltige organometallische Verbindung Platin und einen vierzähnigen Liganden, der an das Platin gebunden ist, umfasst und
zumindest eine von chemischen Bindungen zwischen dem Platin und dem vierzähnigen Liganden eine chemische Platin-Kohlenstoff-Bindung ist.

11. Lichtemittierende Vorrichtung nach Anspruch 10, wobei eine der chemischen Bindungen zwischen dem Platin und dem vierzähnigen Liganden eine chemische Platin-Sauerstoff-Bindung ist; und/oder
wobei der vierzähnige Ligand eine Benzimidazolgruppe umfasst.

12. Lichtemittierende Vorrichtung nach einem der Ansprüche 1-11, wobei der fluoreszierende Emitter kein Übergangsmetall umfasst.

13. Lichtemittierende Vorrichtung nach einem der Ansprüche 1-12, wobei der fluoreszierende Emitter ein thermisch aktivierter verzögerter Fluoreszenzemitter ist, der zumindest einen 6-gliedrigen Ring umfasst, der zumindest einen Stickstoff (N) und zumindest ein Bor (B) umfasst; oder
wobei der fluoreszierende Emitter ein prompter Fluoreszenzemitter ist, der zumindest einen 5-gliedrigen Ring oder 6-gliedrigen Ring umfasst, der zumindest ein Bor (B) umfasst.

14. Lichtemittierende Vorrichtung nach einem der Ansprüche 1-13, wobei die Zwischenschicht Folgendes umfasst:
m lichtemittierende Einheiten (151, 152), die zumindest eine Emissionsschicht umfassen; und
m-1 Ladungserzeugungsschichten (141), die zwischen zwei benachbarten lichtemittierenden Einheiten unter den m lichtemittierenden Einheiten angeordnet sind,
wobei m eine ganze Zahl von 2 oder mehr ist und
zumindest eine lichtemittierende Einheit unter den m lichtemittierenden Einheiten die Emissionsschicht nach Anspruch 1 umfasst;
wobei bevorzugt die zumindest eine lichtemittierende Einheit unter den m lichtemittierenden Einheiten blaues Licht emittiert.

15. Elektronische Einrichtung, umfassend die lichtemittierende Vorrichtung nach einem der Ansprüche 1-14.

## Revendications

1. Dispositif électroluminescent comprenant :
une première électrode (110) ;
une seconde électrode (190) ; et
une couche intermédiaire disposée entre la première électrode (110) et la seconde électrode (190), dans lequel la couche intermédiaire comprend une couche d'émission (150),
la couche d'émission comprend m1 hôtes, un sensibilisateur et un émetteur fluorescent,
où m1 est un entier égal ou supérieur à 1, et lorsque m1 est égal ou supérieur à 2, les deux hôtes ou plus sont chacun différents les uns des autres,
les m1 hôtes, le sensibilisateur et l'émetteur fluorescent sont chacun différents les uns des autres, **caractérisé en ce que**
l'Expression 1 est satisfaite : $0 debye \leq \left|PDM\left(S\right)-PDM\left(H\right)\right| \leq 3 debye$ Expression 1
dans laquelle, dans l'Expression 1,
PDM(S) est un moment dipolaire permanent du sensibilisateur et a une unité en debye,
PDM(H) est ${\sum }_{x = 1}^{m 1} PDM \left(Hx\right) ⋅ W \left(Hx\right)$ qui est une valeur moyenne des moments dipolaires permanents des m1 hôtes compris dans la couche d'émission, et a une unité en debye, dans laquelle i) x est une variable de 1 à m1, ii) PDM(Hx) est un moment dipolaire permanent d'un x^{ième} hôte dans la couche d'émission et a une unité en debye, et iii) W(Hx) est une fraction pondérale du x^{ième} hôte par rapport à un poids total de l'hôte dans la couche d'émission, et est calculée comme (un poids du x^{ième} hôte dans la couche d'émission / un poids total de l'hôte dans la couche d'émission), et
chacun de PDM(S) et de PDM(H) est calculé sur la base de la théorie fonctionnelle de la densité (DFT) selon le procédé de l'Exemple d'Évaluation 1.

2. Dispositif électroluminescent selon la revendication 1, dans lequel PDM(S) est de 0,1 debye à 3,0 debye ; et/ou
dans lequel PDM(H) est de 0,01 debye à 4,00 debye.

3. Dispositif électroluminescent selon les revendications 1 ou 2, dans lequel l'Expression 2 est en outre satisfaite : $0 eV \leq \left|{S}_{1}\left(S\right)-{T}_{1}\left(S\right)\right| \leq 0 , 4 eV$ Expression 2 dans lequel, dans l'Expression 2,
S₁(S) est l'énergie singulet du sensibilisateur et a une unité en eV,
T₁(S) est l'énergie triplet du sensibilisateur et a une unité en eV, et
chacun de S₁(S) et T₁(S) est calculé sur la base de la DFT.

4. Dispositif électroluminescent selon la revendication 3, dans lequel S₁(S) est de 2,25 eV à 2,65 eV ; et/ou
dans lequel T₁(S) est de 2,2 eV à 2,6 eV.

5. Dispositif électroluminescent selon l'une quelconque des revendications 1 à 4, dans lequel l'Expression 3 est en outre satisfaite : $0 eV \leq \left|{S}_{1}\left(FE\right)-{T}_{1}\left(FE\right)\right| \leq 1 , 5 eV$ Expression 3 dans lequel, dans l'Expression 3,
S₁(FE) est l'énergie singulet de l'émetteur fluorescent et a une unité en eV,
T₁(FE) est l'énergie triplet de l'émetteur fluorescent et a une unité en eV, et
chacun de S₁(FE) et T₁(FE) est calculé sur la base de la DFT.

6. Dispositif électroluminescent selon l'une quelconque des revendications 1 à 5, dans lequel T₁(FE) est de 1,0 eV à 2,5 eV,
T₁(FE) est l'énergie triplet de l'émetteur fluorescent et a une unité en eV, et
T₁(FE) est calculé sur la base de la DFT.

7. Dispositif électroluminescent selon l'une quelconque des revendications 1 à 6, dans lequel FWHM(FE) est de 5 nanomètres à 50 nanomètres,
FWHM(FE) est une largeur totale à mi-hauteur maximum à la longueur d'onde maximale de pic d'émission d'un spectre de photoluminescence de l'émetteur fluorescent et a une unité en nm, et
le spectre de photoluminescence est évalué par rapport à un film comprenant l'émetteur fluorescent.

8. Dispositif électroluminescent selon l'une quelconque des revendications 1 à 7, dans lequel λmax(FE) est de 500 nm à 550 nm,
λmax(FE) est une longueur d'onde maximale de pic d'émission d'un spectre de photoluminescence de l'émetteur fluorescent et a une unité en nm, et
le spectre de photoluminescence est évalué par rapport à un film comprenant l'émetteur fluorescent.

9. Dispositif électroluminescent selon l'une quelconque des revendications 1 à 8, dans lequel les m1 hôtes comprennent indépendamment un composé de transport de trous, un composé de transport d'électrons, un composé bipolaire, ou toute combinaison de ceux-ci.

10. Dispositif électroluminescent selon l'une quelconque des revendications 1 à 9, dans lequel le sensibilisateur comprend un composé organométallique contenant du platine,
le composé organométallique contenant du platine comprend du platine et un ligand tétradenté lié au platine, et
au moins l'une des liaisons chimiques entre le platine et le ligand tétradenté est une liaison chimique platine-carbone.

11. Dispositif électroluminescent selon la revendication 10, dans lequel l'une des liaisons chimiques entre le platine et le ligand tétradenté est une liaison chimique platine-oxygène ; et/ou
dans lequel le ligand tétradenté comprend un groupe benzimidazole.

12. Dispositif électroluminescent selon l'une quelconque des revendications 1 à 11, dans lequel l'émetteur fluorescent ne comprend pas de métal de transition.

13. Dispositif électroluminescent selon l'une quelconque des revendications 1 à 12, dans lequel l'émetteur fluorescent est un émetteur à fluorescence retardée activée thermiquement comprenant au moins un cycle à 6 éléments comprenant au moins un azote (N) et au moins un bore (B) ; ou
dans lequel l'émetteur fluorescent est un émetteur à fluorescence rapide comprenant au moins un cycle à 5 éléments ou un cycle à 6 éléments comprenant au moins un bore (B).

14. Dispositif électroluminescent selon l'une quelconque des revendications 1 à 13, dans lequel la couche intermédiaire comprend :
m unités électroluminescentes (151, 152) comprenant au moins une couche d'émission ; et
m-1 couches de génération de charge (141) agencées entre deux unités électroluminescentes adjacentes parmi les m unités électroluminescentes,
m est un nombre entier de 2 ou plus, et
au moins une unité électroluminescente parmi les m unités électroluminescentes comprend la couche d'émission telle que définie dans la revendication 1 ;
de préférence dans lequel l'au moins une unité électroluminescente parmi les m unités électroluminescentes émet une lumière bleue.

15. Appareil électronique, comprenant le dispositif électroluminescent selon l'une quelconque des revendications 1 à 14.
